# EUROPEAN PATENT APPLICATION

(11) **EP 4 671 921 A1**
(43) Date of publication of application: **31.12.2025**
(21) Application number: 25173383.8
(22) Date of filing: 29.04.2025
(51) Int. Cl.: G06F 1/20, H05K 7/20

(54) **METHODS AND APPARATUS FOR LOCALIZED TEMPERATURE CONTROL AND LEAKAGE PROTECTION IN A SERVER HOUSING**

(30) Priority: 27.06.2024 US 202418757049
(71) Applicant: Intel Corporation, Santa Clara, CA 95054 (US)
(72) Inventor: WONDIMU, Berhanu Kebede, Beaverton, OR, 97003 (US); WINKEL, Casey, Hillsboro, OR, 97124 (US); AHUJA, Sandeep, Portland, OR, 97229 (US); MACDONALD, Mark Angus, Beaverton, OR, 97006 (US); INKLEY, Benson Dale, Hillsboro, OR, 97123 (US); LUCKEROTH, Mark Joseph, Portland, OR, 97229 (US); CROP, Jason, Fort Collins, CO, 80528 (US); DAMARAJU, Srinivasa Rao, Fremont, CA, 94538 (US); CARTE, Casey Jamesen, Portland, OR, 97225 (US); VISHWANATHAN, Laxmi, Portland, OR, 97229 (US); KAM, Timothy Yee-Kwong, Portland, OR, 97229 (US); ELENITOBA-JOHNSON, Olaotan Frank, Tigard, OR, 97224 (US); DESAI, Romir, Fremont, CA, 94539 (US); MISTOFSKY, Kevin, Hillsboro, OR, 97124 (US); REN, Zhikui, Portland, OR, 97229 (US)
(74) Representative: Maiwald GmbH

(57) **Abstract**

Methods and apparatus for localized temperature control and leakage protection in a server housing are disclosed. An example system includes interface circuitry, machine readable instructions, and at least one programmable circuit of a server disposable inside a portion of a server housing. The at least one programmable circuit are to at least one of instantiate or execute the machine readable instructions to identify a temperature of the server, determine a target temperature for a workload for the server, and control an actuator based on the temperature and the target temperature, the actuator to control a local flow rate of a coolant in the portion of the server housing.

## Description

### BACKGROUND

The use of liquids to cool electronic components is being explored for its benefits over more traditional air cooling systems, as there is an increasing need to address thermal management risks resulting from increased thermal design power in high performance systems (e.g., CPU and/or GPU servers in data centers, cloud computing, edge computing, and the like). More particularly, relative to air, liquid has inherent advantages of higher specific heat (when no boiling is involved) and higher latent heat of vaporization (when boiling is involved).

### BRIEF DESCRIPTION OF THE DRAWINGS

FIG. 1 illustrates one or more example environments in which teachings of this disclosure may be implemented.
FIG. 2 illustrates at least one example of a data center for executing workloads with disaggregated resources.
FIG. 3 illustrates at least one example of a pod that may be included in the data center of FIG. 2.
FIG. 4 is a perspective view of at least one example of a rack that may be included in the pod of FIG. 3.
FIG. 5 is a side elevation view of the rack of FIG. 4.
FIG. 6 is a perspective view of the rack of FIG. 4 having a sled mounted therein.
FIG. 7 is a is a block diagram of at least one example of a top side of the sled of FIG. 6.
FIG. 8 is a block diagram of at least one example of a bottom side of the sled of FIG. 7.
FIG. 9 is a block diagram of at least one example of a compute sled usable in the data center of FIG. 2.
FIG. 10 is a top perspective view of at least one example of the compute sled of FIG. 9.
FIG. 11 is a block diagram of at least one example of an accelerator sled usable in the data center of FIG. 2.
FIG. 12 is a top perspective view of at least one example of the accelerator sled of FIG. 11.
FIG. 13 is a block diagram of at least one example of a storage sled usable in the data center of FIG. 2.
FIG. 14 is a top perspective view of at least one example of the storage sled of FIG. 13.
FIG. 15 is a block diagram of at least one example of a memory sled usable in the data center of FIG. 2.
FIG. 16 is a block diagram of a system that may be established within the data center of FIG. 2 to execute workloads with managed nodes of disaggregated resources.
FIG. 17 illustrate an example environment in which example local temperature control circuitry operates to control a temperature of a server in a portion of a server housing and in which example cooling distribution unit (CDU) circuitry operates to protect electronics in the server housing from damage when a coolant leak occurs.
FIG. 18 is a block diagram of an example implementation of the local temperature control circuitry and the CDU circuitry of FIG. 17.
FIG. 19 is a simplified schematic representation of example coolant flow control for local temperature management by the local temperature control circuitry of FIGS. 17-18.
FIG. 20A is another simplified schematic representation of example coolant flow control for local temperature management in which an actuator that controls the coolant flow is associated with a pump.
FIG. 20B is another simplified schematic representation of example coolant flow control for local temperature management in which an actuator that controls the coolant flow is associated with a valve.
FIG. 21 illustrates another example environment in which an example local temperature control circuitry operates to control a temperature of a server in a portion of a server housing and in which example CDU circuitry operates to protect electronics in the server housing from damage when a coolant leak occurs.
FIG. 22 illustrates another example environment in which an example local temperature control circuitry operates to control a temperature of a server in a portion of a server housing.
FIG. 23 illustrates an example rack of the environment of FIGS. 17 and/or 21.
FIG. 24 is a flowchart representative of example machine readable instructions and/or example operations that may be executed, instantiated, and/or performed by example programmable circuitry to implement the local temperature control circuitry of FIGS. 17 and/or 18.
FIG. 25 is another flowchart representative of example machine readable instructions and/or example operations that may be executed, instantiated, and/or performed by example programmable circuitry to implement the local temperature control circuitry of FIGS. 17 and/or 18.
FIG. 26 is a flowchart representative of example machine readable instructions and/or example operations that may be executed, instantiated, and/or performed by example programmable circuitry to implement the CDU circuitry of FIGS. 17 and/or 18.
FIG. 27 is a block diagram of an example processing platform including programmable circuitry structured to execute, instantiate, and/or perform the example machine readable instructions and/or perform the example operations of FIGS. 24, 25, and/or 26 to implement the local temperature control circuitry of FIGS. 17 and/or 18.
FIG. 28 is a block diagram of an example processing platform including programmable circuitry structured to execute, instantiate, and/or perform the example machine readable instructions and/or perform the example operations of FIGS. 24, 25, and/or 26 to implement the CDU circuitry of FIGS. 17 and/or 18.
FIG. 29 is a block diagram of an example implementation of the programmable circuitry of FIGS. 27 and/or 28.
FIG. 30 is a block diagram of another example implementation of the programmable circuitry of FIGS. 27 and/or 28.

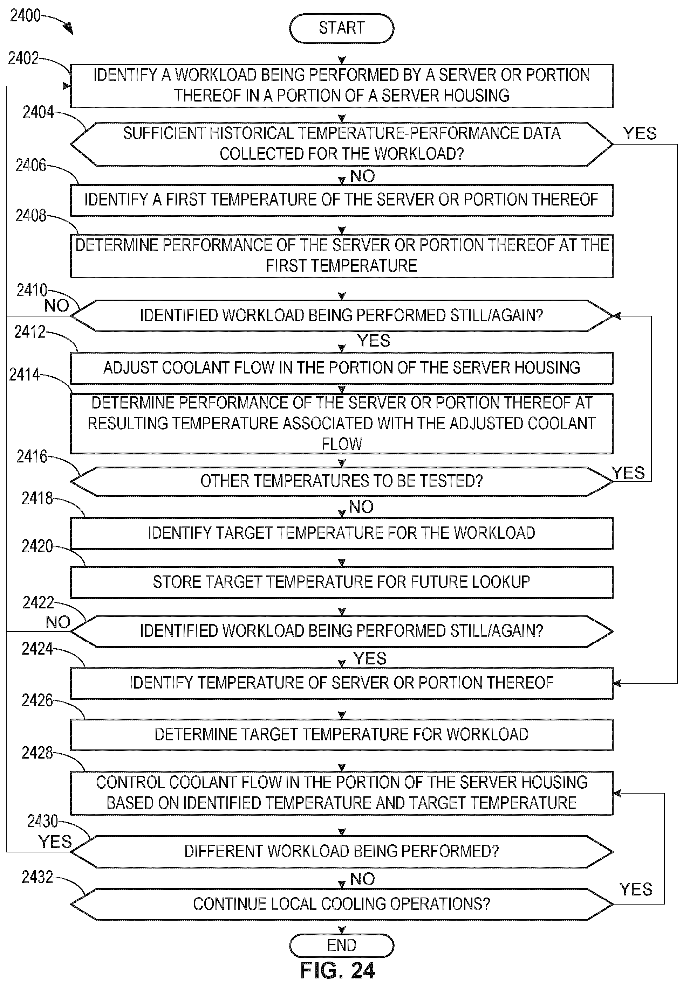

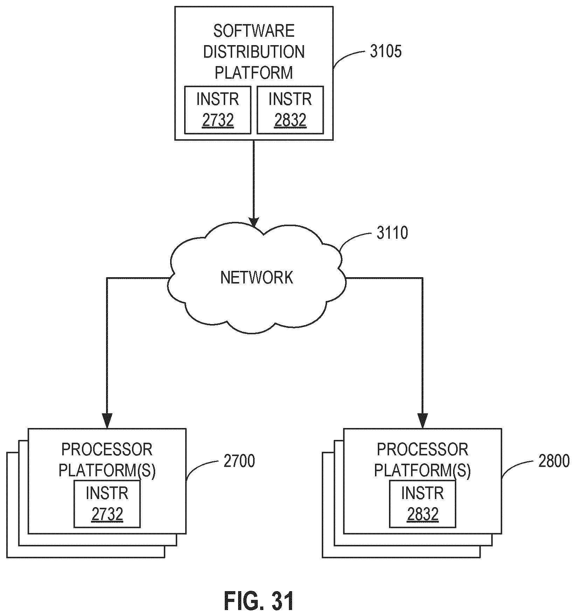

FIG. 31 is a block diagram of an example software/firmware/instructions distribution platform (e.g., one or more servers) to distribute software, instructions, and/or firmware (e.g., corresponding to the example machine readable instructions of FIGS. 24, 25, and/or 26) to client devices associated with end users and/or consumers (e.g., for license, sale, and/or use), retailers (e.g., for sale, re-sale, license, and/or sub-license), and/or original equipment manufacturers (OEMs) (e.g., for inclusion in products to be distributed to, for example, retailers and/or to other end users such as direct buy customers).

In general, the same reference numbers will be used throughout the drawing(s) and accompanying written description to refer to the same or like parts. The figures are not necessarily to scale. Instead, the thickness of the layers or portions may be enlarged in the drawings. Although the figures show layers and portions with clean lines and boundaries, some or all of these lines and/or boundaries may be idealized. In reality, the boundaries and/or lines may be unobservable, blended, and/or irregular.

### DETAILED DESCRIPTION

As noted above, the use of liquids to cool electronic components is being explored for its benefits over more traditional air cooling systems, as there are increasing needs to address thermal management risks resulting from increased thermal design power in high performance systems (e.g., CPU and/or GPU servers in data centers, accelerators, artificial intelligence computing, machine learning computing, cloud computing, edge computing, and the like). More particularly, relative to air, liquid has inherent advantages of higher specific heat (when no boiling is involved) and higher latent heat of vaporization (when boiling is involved). In some instances, liquid can be used to indirectly cool electronic components by cooling a cold plate that is thermally coupled to the electronic component(s). An alternative approach is to directly immerse electronic components in the cooling liquid. In direct immersion cooling, the liquid can be in direct contact with the electronic components to directly draw away heat from the electronic components. To enable the cooling liquid to be in direct contact with electronic components, the cooling liquid is electrically insulative (e.g., a dielectric liquid).

A liquid cooling system can involve at least one of single-phase cooling or two-phase cooling. As used herein, single-phase cooling (e.g., single-phase immersion cooling) means the cooling fluid (sometimes also referred to herein as cooling liquid or coolant) used to cool electronic components draws heat away from heat sources (e.g., electronic components) without changing phase (e.g., without boiling and becoming vapor). Such cooling fluids are referred to herein as single-phase cooling fluids, liquids, or coolants. By contrast, as used herein, two-phase cooling (e.g., two-phase immersion cooling) means the cooling fluid (in this case, a cooling liquid) vaporizes or boils from the heat generated by the electronic components to be cooled, thereby changing from the liquid phase to the vapor phase. The gaseous vapor may subsequently be condensed back into a liquid (e.g., via a condenser) to again be used in the cooling process. Such cooling fluids are referred to herein as two-phase cooling fluids, liquids, or coolants. Notably, gases (e.g., air) can also be used to cool components and, therefore, may also be referred to as a cooling fluid and/or a coolant. However, indirect cooling and immersion cooling typically involves at least one cooling liquid (which may or may not change to the vapor phase when in use). Example systems, apparatus, and associated methods to improve cooling systems and/or associated cooling processes are disclosed herein.

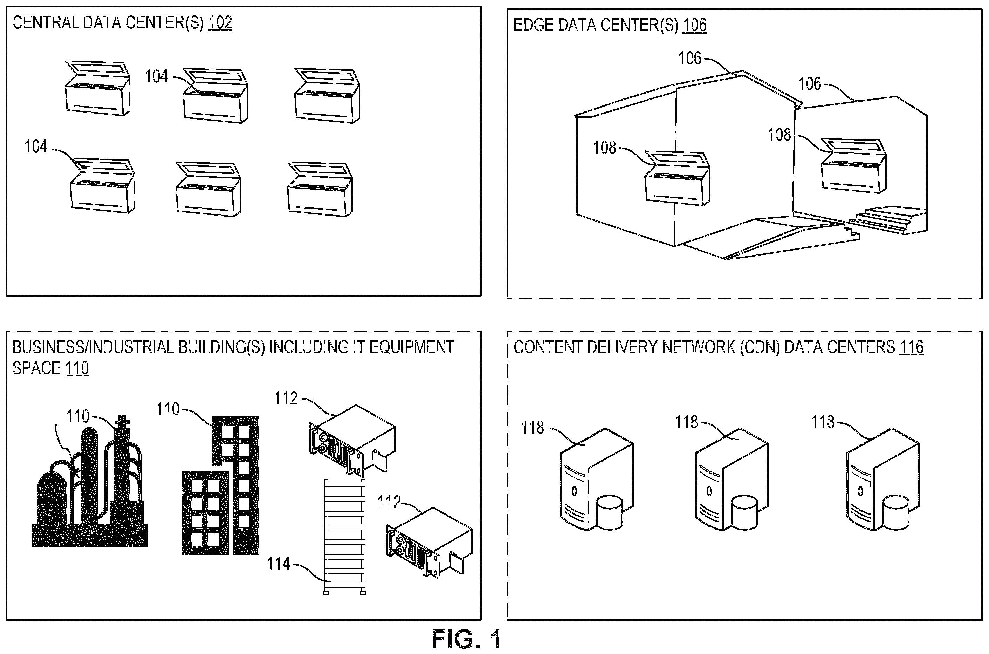

FIG. 1 illustrates one or more example environments in which teachings of this disclosure may be implemented. The example environment(s) of FIG. 1 can include one or more central data centers 102. The central data center(s) 102 can store a large number of servers used by, for instance, one or more organizations for data processing, storage, etc. As illustrated in FIG. 1, the central data center(s) 102 include a plurality of immersion tank(s) 104 to facilitate cooling of the servers and/or other electronic components stored at the central data center(s) 102. The immersion tank(s) 104 can provide for single-phase cooling or two-phase cooling.

The example environments of FIG. 1 can be part of an edge computing system. For instance, the example environments of FIG. 1 can include edge data centers or micro-data centers 106. The edge data center(s) 106 can include, for example, data centers located at a base of a cell tower. In some examples, the edge data center(s) 106 are located at or near a top of a cell tower and/or other utility pole. The edge data center(s) 106 include respective housings that store server(s), where the server(s) can be in communication with, for instance, the server(s) stored at the central data center(s) 102, client devices, and/or other computing devices in the edge network. Example housings of the edge data center(s) 106 may include materials that form one or more exterior surfaces that partially or fully protect contents therein, in which protection may include weather protection, hazardous environment protection (e.g., EMI, vibration, extreme temperatures), and/or enable submergibility. Example housings may include power circuitry to provide power for stationary and/or portable implementations, such as AC power inputs, DC power inputs, AC/DC or DC/AC converter(s), power regulators, transformers, charging circuitry, batteries, wired inputs and/or wireless power inputs. As illustrated in FIG. 1, the edge data center(s) 106 can include immersion tank(s) 108 to store server(s) and/or other electronic component(s) located at the edge data center(s) 106.

The example environment(s) of FIG. 1 can include buildings 110 for purposes of business and/or industry that store information technology (IT) equipment in, for example, one or more rooms of the building(s) 110. For example, as represented in FIG. 1, server(s) 112 can be stored with server rack(s) 114 that support the server(s) 112 (e.g., in an opening of slot of the rack 114). In some examples, the server(s) 112 located at the buildings 110 include on-premise server(s) of an edge computing network, where the on-premise server(s) are in communication with remote server(s) (e.g., the server(s) at the edge data center(s) 106) and/or other computing device(s) within an edge network.

The example environment(s) of FIG. 1 include content delivery network (CDN) data center(s) 116. The CDN data center(s) 116 of this example include server(s) 118 that cache content such as images, webpages, videos, etc. accessed via user devices. The server(s) 118 of the CDN data centers 116 can be disposed in immersion cooling tank(s) such as the immersion tanks 104, 108 shown in connection with the data centers 102, 106.

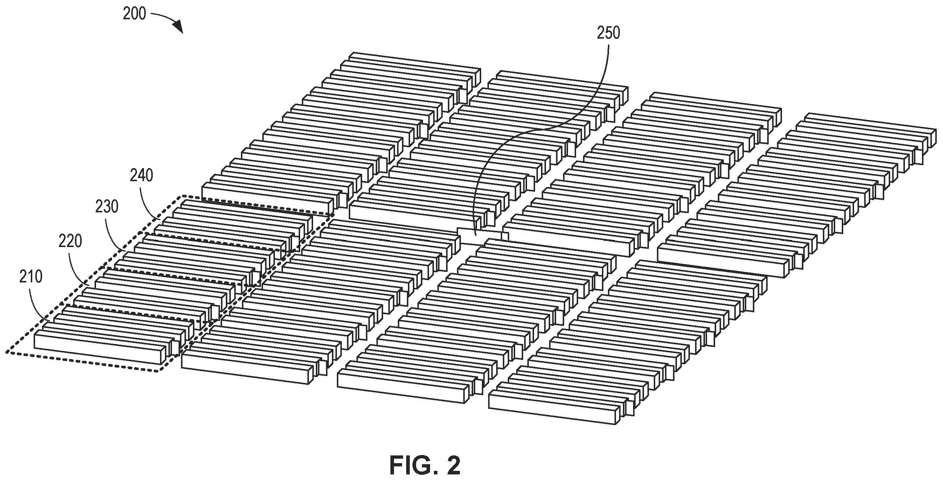

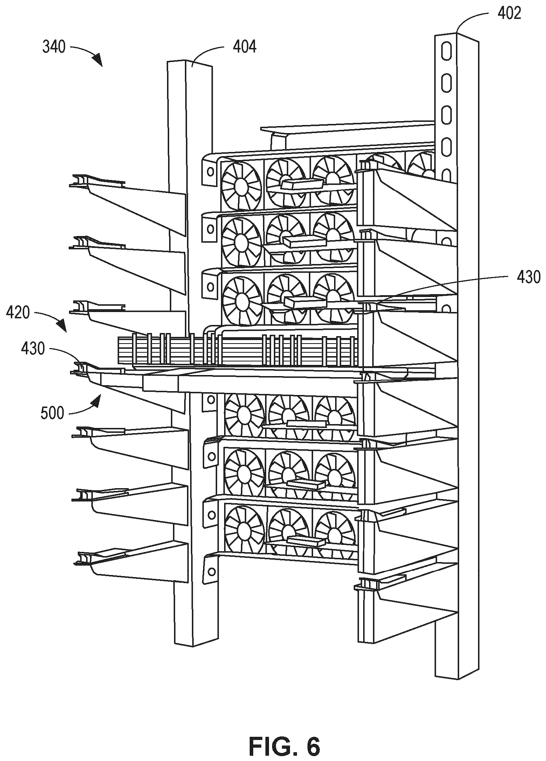

In some instances, the example data centers 102, 106, 116 and/or building(s) 110 of FIG. 1 include servers and/or other electronic components that are cooled independent of immersion tanks (e.g., the immersion tanks 104, 108) and/or an associated immersion cooling system. That is, in some examples, some or all of the servers and/or other electronic components in the data centers 102, 106, 116 and/or building(s) 110 can be cooled by air and/or liquid coolants without immersing the servers and/or other electronic components therein. Thus, in some examples, the immersion tanks 104, 108 of FIG. 1 may be omitted. Further, the example data centers 102, 106, 116 and/or building(s) 110 of FIG. 1 can correspond to, be implemented by, and/or be adaptations of the example data center 200 described in further detail below in connection with FIGS. 2-16.

Although a certain number of cooling tank(s) and other component(s) are shown in the figures, any number of such components may be present. Also, the example cooling data centers and/or other structures or environments disclosed herein are not limited to arrangements of the size that are depicted in FIG. 1. For instance, the structures containing example cooling systems and/or components thereof disclosed herein can be of a size that includes an opening to accommodate service personnel, such as the example data center(s) 106 of FIG. 1, but can also be smaller (e.g., a "doghouse" enclosure). For instance, the structures containing example cooling systems and/or components thereof disclosed herein can be sized such that access (e.g., the only access) to an interior of the structure is a port for service personnel to reach into the structure. In some examples, the structures containing example cooling systems and/or components thereof disclosed herein can be sized such that only a tool can reach into the enclosure because the structure may be supported by, for a utility pole or radio tower, or a larger structure.

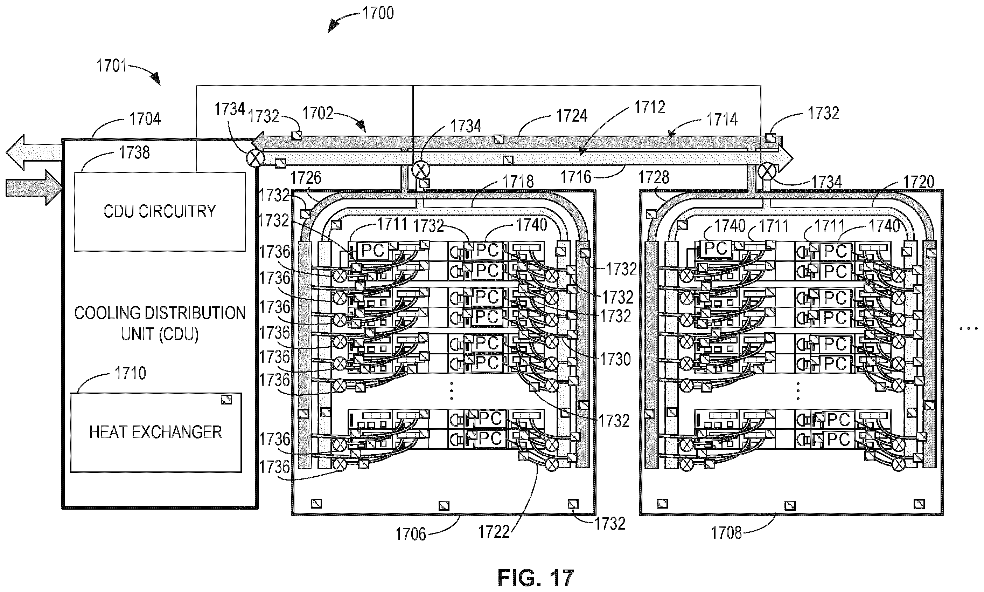

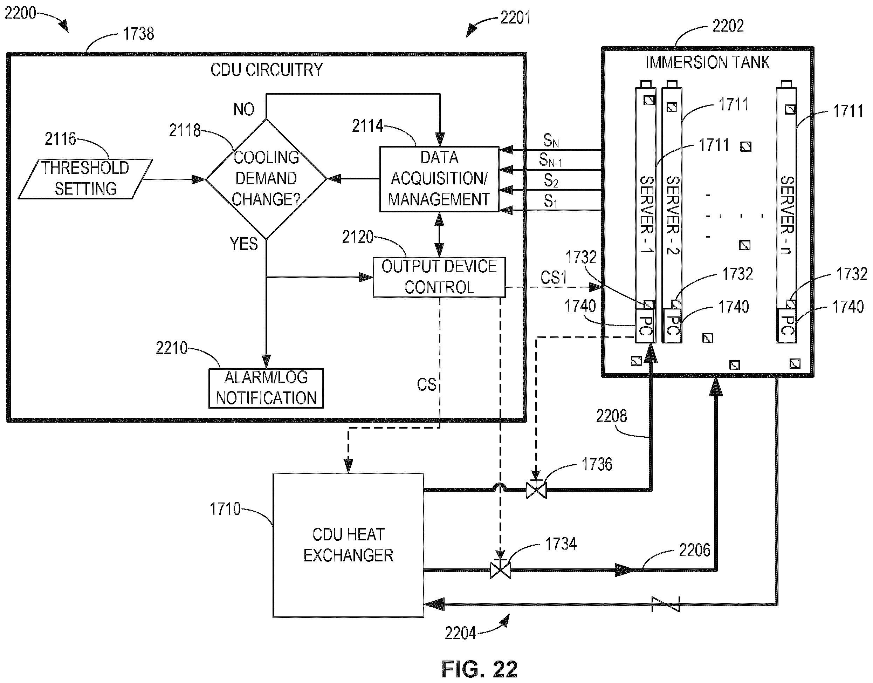

In addition to or as an alternative to the immersion tanks 104, 108, any of the example environments of FIG. 1 can utilize one or more liquid cooling systems having a cold plate to control the temperature of the electronic devices/components in the example environments. Example liquid cooling systems that can utilize cold plates are disclosed in FIGS. 17, 20A, 20B, 21, and 23. An example liquid cooling system that utilizes immersion tanks, such as the immersion tanks 104, 108, is disclosed in FIG. 22.

FIG. 2 illustrates an example data center 200 in which disaggregated resources may cooperatively execute one or more workloads (e.g., applications on behalf of customers). The illustrated data center 200 includes multiple platforms 210, 220, 230, 240 (referred to herein as pods), each of which includes one or more rows of racks. Although the data center 200 is shown with multiple pods, in some examples, the data center 200 may be implemented as a single pod. As described in more detail herein, a rack may house multiple sleds. A sled may be primarily equipped with a particular type of resource (e.g., memory devices, data storage devices, accelerator devices, general purpose programmable circuitry), i.e., resources that can be logically coupled to form a composed node. Some such nodes may act as, for example, a server. In the illustrative example, the sleds in the pods 210, 220, 230, 240 are connected to multiple pod switches (e.g., switches that route data communications to and from sleds within the pod). The pod switches, in turn, connect with spine switches 250 that switch communications among pods (e.g., the pods 210, 220, 230, 240) in the data center 200. In some examples, the sleds may be connected with a fabric using Intel Omni-Path^{™} technology. In other examples, the sleds may be connected with other fabrics, such as InfiniBand or Ethernet. As described in more detail herein, resources within the sleds in the data center 200 may be allocated to a group (referred to herein as a "managed node") containing resources from one or more sleds to be collectively utilized in the execution of a workload. The workload can execute as if the resources belonging to the managed node were located on the same sled. The resources in a managed node may belong to sleds belonging to different racks, and even to different pods 210, 220, 230, 240. As such, some resources of a single sled may be allocated to one managed node while other resources of the same sled are allocated to a different managed node (e.g., first programmable circuitry assigned to one managed node and second programmable circuitry of the same sled assigned to a different managed node).

A data center including disaggregated resources, such as the data center 200, can be used in a wide variety of contexts, such as enterprise, government, cloud service provider, and communications service provider (e.g., Telco's), as well in a wide variety of sizes, from cloud service provider mega-data centers that consume over 200,000 sq. ft. to single- or multi-rack installations for use in base stations.

In some examples, the disaggregation of resources is accomplished by using individual sleds that include predominantly a single type of resource (e.g., compute sleds including primarily compute resources, memory sleds including primarily memory resources). The disaggregation of resources in this manner, and the selective allocation and deallocation of the disaggregated resources to form a managed node assigned to execute a workload, improves the operation and resource usage of the data center 200 relative to typical data centers. Such typical data centers include hyperconverged servers containing compute, memory, storage and perhaps additional resources in a single chassis. For example, because a given sled will contain mostly resources of a same particular type, resources of that type can be upgraded independently of other resources. Additionally, because different resource types (programmable circuitry, storage, accelerators, etc.) typically have different refresh rates, greater resource utilization and reduced total cost of ownership may be achieved. For example, a data center operator can upgrade the programmable circuitry throughout a facility by only swapping out the compute sleds. In such a case, accelerator and storage resources may not be contemporaneously upgraded and, rather, may be allowed to continue operating until those resources are scheduled for their own refresh. Resource utilization may also increase. For example, if managed nodes are composed based on requirements of the workloads that will be running on them, resources within a node are more likely to be fully utilized. Such utilization may allow for more managed nodes to run in a data center with a given set of resources, or for a data center expected to run a given set of workloads, to be built using fewer resources.

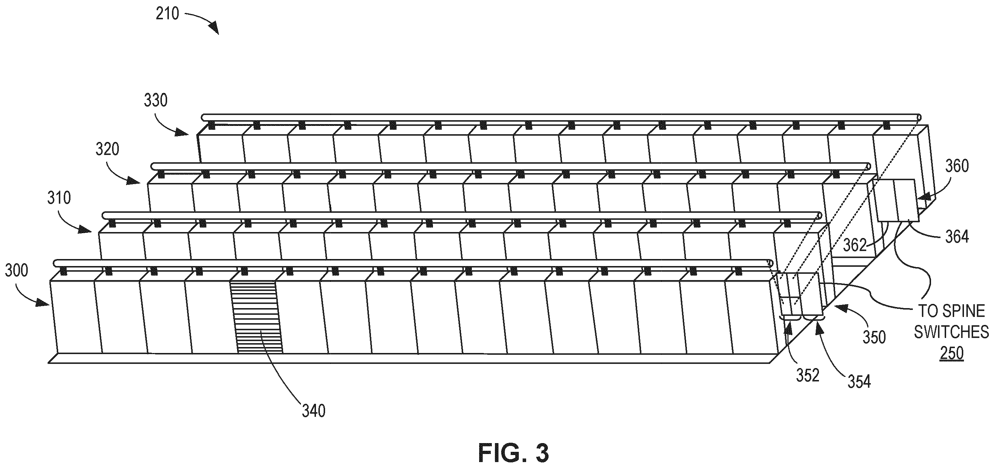

Referring now to FIG. 3, the pod 210, in the illustrative example, includes a set of rows 300, 310, 320, 330 of racks 340. Example liquid cooling systems that utilizes racks, such as the racks 340, are discussed further in connection with FIGS. 17, 18, 19, 20A, 20B, 21, and/or 23. Individual ones of the racks 340 may house multiple sleds (e.g., sixteen sleds) and provide power and data connections to the housed sleds, as described in more detail herein. In the illustrative example, the racks are connected to multiple pod switches 350, 360. The pod switch 350 includes a set of ports 352 to which the sleds of the racks of the pod 210 are connected and another set of ports 354 that connect the pod 210 to the spine switches 250 to provide connectivity to other pods in the data center 200. Similarly, the pod switch 360 includes a set of ports 362 to which the sleds of the racks of the pod 210 are connected and a set of ports 364 that connect the pod 210 to the spine switches 250. As such, the use of the pair of switches 350, 360 provides an amount of redundancy to the pod 210. For example, if either of the switches 350, 360 fails, the sleds in the pod 210 may still maintain data communication with the remainder of the data center 200 (e.g., sleds of other pods) through the other switch 350, 360. Furthermore, in the illustrative example, the switches 250, 350, 360 may be implemented as dual-mode optical switches, capable of routing both Ethernet protocol communications carrying Internet Protocol (IP) packets and communications according to a second, high-performance link-layer protocol (e.g., PCI Express) via optical signaling media of an optical fabric.

It should be appreciated that any one of the other pods 220, 230, 240 (as well as any additional pods of the data center 200) may be similarly structured as, and have components similar to, the pod 210 shown in and disclosed in regard to FIG. 3 (e.g., a given pod may have rows of racks housing multiple sleds as described above). Additionally, while two pod switches 350, 360 are shown, it should be understood that in other examples, a different number of pod switches may be present, providing even more failover capacity. In other examples, pods may be arranged differently than the rows-of-racks configuration shown in FIGS. 2 and 3. For example, a pod may include multiple sets of racks arranged radially, i.e., the racks are equidistant from a center switch.

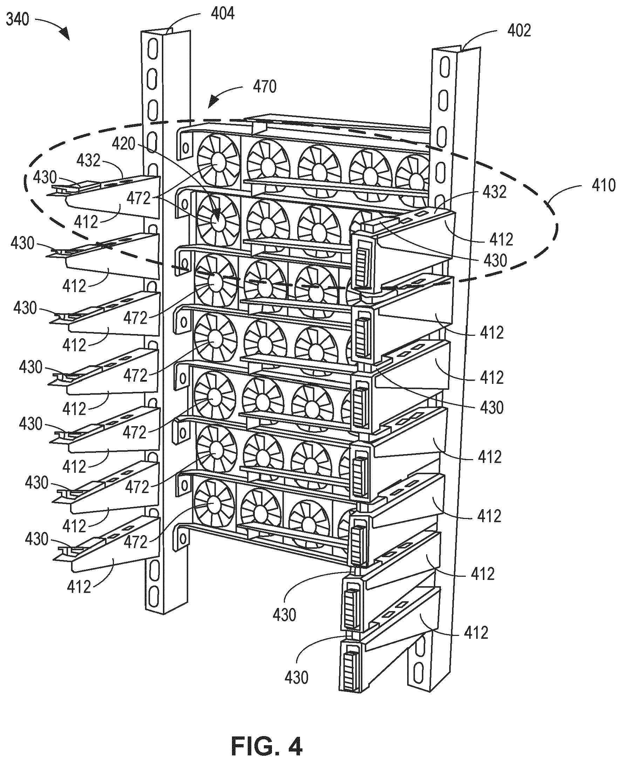

FIGS. 4-6 illustrate an example rack 340 of the data center 200. As shown in the illustrated example, the rack 340 includes two elongated support posts 402, 404, which are arranged vertically. For example, the elongated support posts 402, 404 may extend upwardly from a floor of the data center 200 when deployed. The rack 340 also includes one or more horizontal pairs 410 of elongated support arms 412 (identified in FIG. 4 via a dashed ellipse) configured to support a sled of the data center 200 as discussed below. One elongated support arm 412 of the pair of elongated support arms 412 extends outwardly from the elongated support post 402 and the other elongated support arm 412 extends outwardly from the elongated support post 404.

In the illustrative examples, at least some of the sleds of the data center 200 are chassis-less sleds. That is, such sleds have a chassis-less circuit board substrate on which physical resources (e.g., programmable circuitry, memory, accelerators, storage, etc.) are mounted as discussed in more detail below. As such, the rack 340 is configured to receive the chassis-less sleds. For example, a given pair 410 of the elongated support arms 412 defines a sled slot 420 of the rack 340, which is configured to receive a corresponding chassis-less sled. To do so, the elongated support arms 412 include corresponding circuit board guides 430 configured to receive the chassis-less circuit board substrate of the sled. The circuit board guides 430 are secured to, or otherwise mounted to, a top side 432 of the corresponding elongated support arms 412. For example, in the illustrative example, the circuit board guides 430 are mounted at a distal end of the corresponding elongated support arm 412 relative to the corresponding elongated support post 402, 404. For clarity of FIGS. 4-6, not every circuit board guide 430 may be referenced in each figure. In some examples, at least some of the sleds include a chassis and the racks 340 are suitably adapted to receive the chassis.

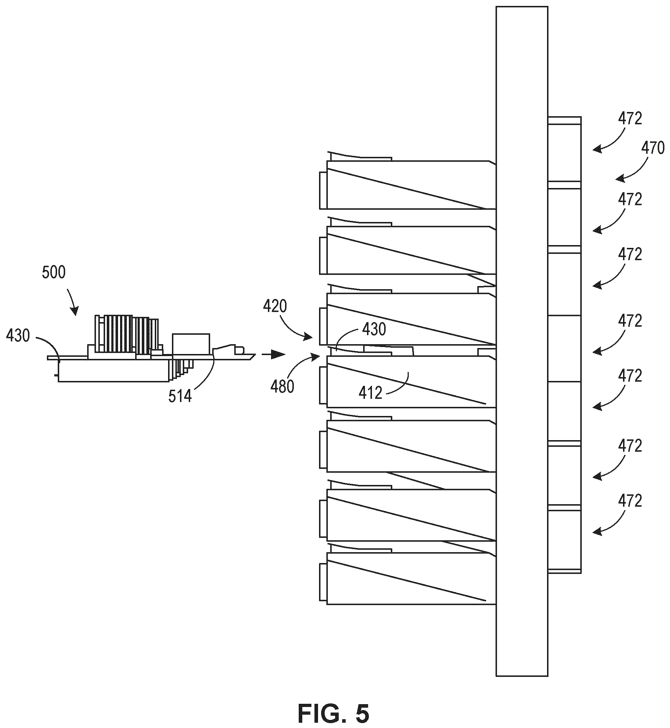

The circuit board guides 430 include an inner wall that defines a circuit board slot 480 configured to receive the chassis-less circuit board substrate of a sled 500 when the sled 500 is received in the corresponding sled slot 420 of the rack 340. To do so, as shown in FIG. 5, a user (or robot) aligns the chassis-less circuit board substrate of an illustrative chassis-less sled 500 to a sled slot 420. The user, or robot, may then slide the chassis-less circuit board substrate forward into the sled slot 420 such that each side edge 514 of the chassis-less circuit board substrate is received in a corresponding circuit board slot 480 of the circuit board guides 430 of the pair 410 of elongated support arms 412 that define the corresponding sled slot 420 as shown in FIG. 5. By having robotically accessible and robotically manipulable sleds including disaggregated resources, the different types of resource can be upgraded independently of one other and at their own optimized refresh rate. Furthermore, the sleds are configured to blindly mate with power and data communication cables in the rack 340, enhancing their ability to be quickly removed, upgraded, reinstalled, and/or replaced. As such, in some examples, the data center 200 may operate (e.g., execute workloads, undergo maintenance and/or upgrades, etc.) without human involvement on the data center floor. In other examples, a human may facilitate one or more maintenance or upgrade operations in the data center 200.

It should be appreciated that the circuit board guides 430 are dual sided. That is, a circuit board guide 430 includes an inner wall that defines a circuit board slot 480 on each side of the circuit board guide 430. In this way, the circuit board guide 430 can support a chassis-less circuit board substrate on either side. As such, a single additional elongated support post may be added to the rack 340 to turn the rack 340 into a two-rack solution that can hold twice as many sled slots 420 as shown in Fig. 4. The illustrative rack 340 includes seven pairs 410 of elongated support arms 412 that define seven corresponding sled slots 420. The sled slots 420 are configured to receive and support a corresponding sled 500 as discussed above. In other examples, the rack 340 may include additional or fewer pairs 410 of elongated support arms 412 (i.e., additional or fewer sled slots 420). It should be appreciated that because the sled 500 is chassis-less, the sled 500 may have an overall height that is different than typical servers. As such, in some examples, the height of a given sled slot 420 may be shorter than the height of a typical server (e.g., shorter than a single rank unit, referred to as "1U"). That is, the vertical distance between pairs 410 of elongated support arms 412 may be less than a standard rack unit "1U." Additionally, due to the relative decrease in height of the sled slots 420, the overall height of the rack 340 in some examples may be shorter than the height of traditional rack enclosures. For example, in some examples, the elongated support posts 402, 404 may have a length of six feet or less. Again, in other examples, the rack 340 may have different dimensions. For example, in some examples, the vertical distance between pairs 410 of elongated support arms 412 may be greater than a standard rack unit "1U". In such examples, the increased vertical distance between the sleds allows for larger heatsinks to be attached to the physical resources and for larger fans to be used (e.g., in the fan array 470 described below) for cooling the sleds, which in turn can allow the physical resources to operate at increased power levels. Further, it should be appreciated that the rack 340 does not include any walls, enclosures, or the like. Rather, the rack 340 is an enclosure-less rack that is opened to the local environment. In some cases, an end plate may be attached to one of the elongated support posts 402, 404 in those situations in which the rack 340 forms an end-of-row rack in the data center 200.

In some examples, various interconnects may be routed upwardly or downwardly through the elongated support posts 402, 404. To facilitate such routing, the elongated support posts 402, 404 include an inner wall that defines an inner chamber in which interconnects may be located. The interconnects routed through the elongated support posts 402, 404 may be implemented as any type of interconnects including, but not limited to, data or communication interconnects to provide communication connections to the sled slots 420, power interconnects to provide power to the sled slots 420, and/or other types of interconnects.

The rack 340, in the illustrative example, includes a support platform on which a corresponding optical data connector (not shown) is mounted. Such optical data connectors are associated with corresponding sled slots 420 and are configured to mate with optical data connectors of corresponding sleds 500 when the sleds 500 are received in the corresponding sled slots 420. In some examples, optical connections between components (e.g., sleds, racks, and switches) in the data center 200 are made with a blind mate optical connection. For example, a door on a given cable may prevent dust from contaminating the fiber inside the cable. In the process of connecting to a blind mate optical connector mechanism, the door is pushed open when the end of the cable approaches or enters the connector mechanism. Subsequently, the optical fiber inside the cable may enter a gel within the connector mechanism and the optical fiber of one cable comes into contact with the optical fiber of another cable within the gel inside the connector mechanism.

The illustrative rack 340 also includes a fan array 470 coupled to the cross-support arms of the rack 340. The fan array 470 includes one or more rows of cooling fans 472, which are aligned in a horizontal line between the elongated support posts 402, 404. In the illustrative example, the fan array 470 includes a row of cooling fans 472 for the different sled slots 420 of the rack 340. As discussed above, the sleds 500 do not include any on-board cooling system in the illustrative example and, as such, the fan array 470 provides cooling for such sleds 500 received in the rack 340. In other examples, some or all of the sleds 500 can include on-board cooling systems. Further, in some examples, the sleds 500 and/or the racks 340 may include and/or incorporate a liquid and/or immersion cooling system to facilitate cooling of electronic component(s) on the sleds 500. The rack 340, in the illustrative example, also includes different power supplies associated with different ones of the sled slots 420. A given power supply is secured to one of the elongated support arms 412 of the pair 410 of elongated support arms 412 that define the corresponding sled slot 420. For example, the rack 340 may include a power supply coupled or secured to individual ones of the elongated support arms 412 extending from the elongated support post 402. A given power supply includes a power connector configured to mate with a power connector of a sled 500 when the sled 500 is received in the corresponding sled slot 420. In the illustrative example, the sled 500 does not include any on-board power supply and, as such, the power supplies provided in the rack 340 supply power to corresponding sleds 500 when mounted to the rack 340. A given power supply is configured to satisfy the power requirements for its associated sled, which can differ from sled to sled. Additionally, the power supplies provided in the rack 340 can operate independent of each other. That is, within a single rack, a first power supply providing power to a compute sled can provide power levels that are different than power levels supplied by a second power supply providing power to an accelerator sled. The power supplies may be controllable at the sled level or rack level, and may be controlled locally by components on the associated sled or remotely, such as by another sled or an orchestrator.

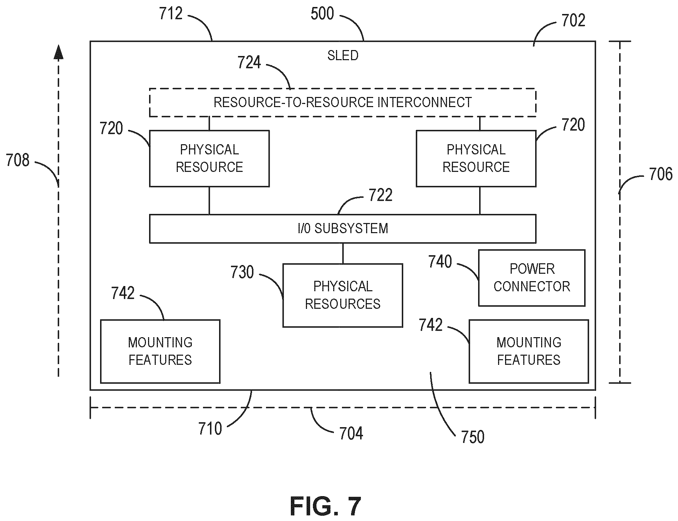

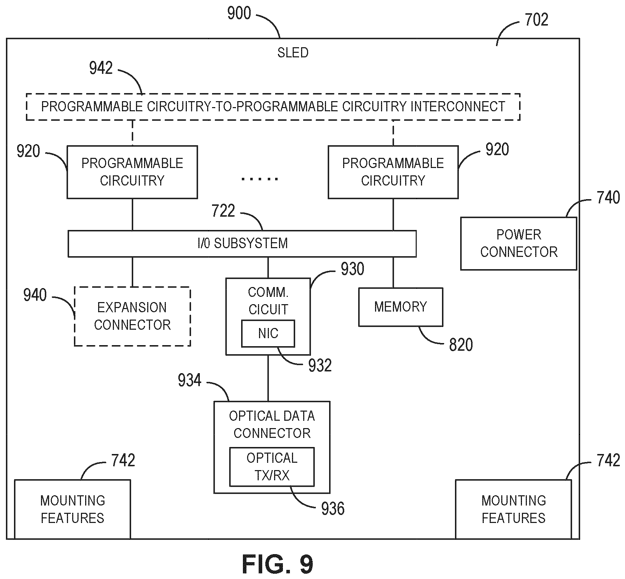

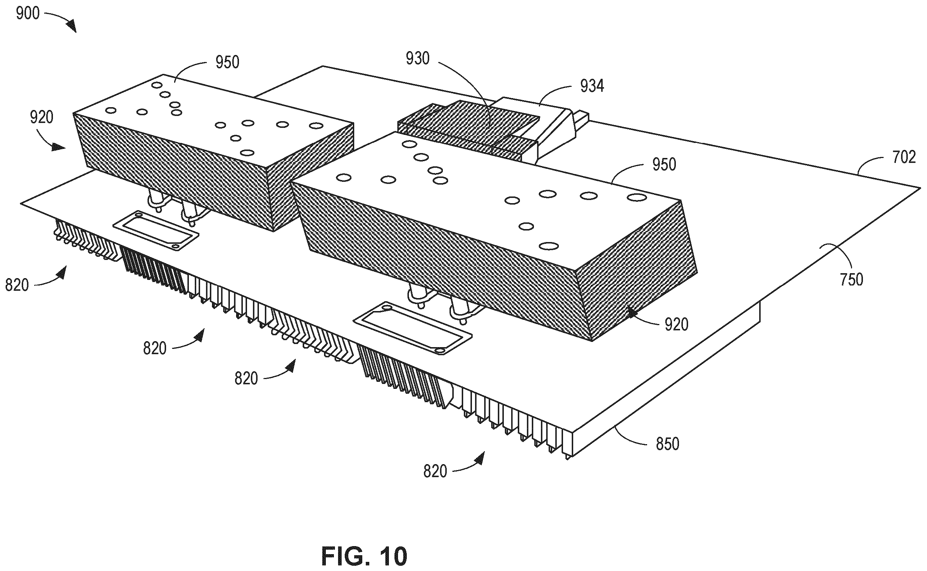

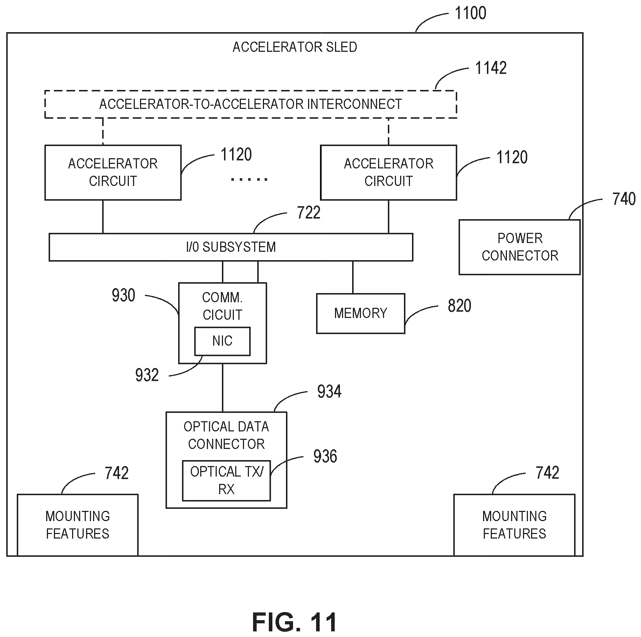

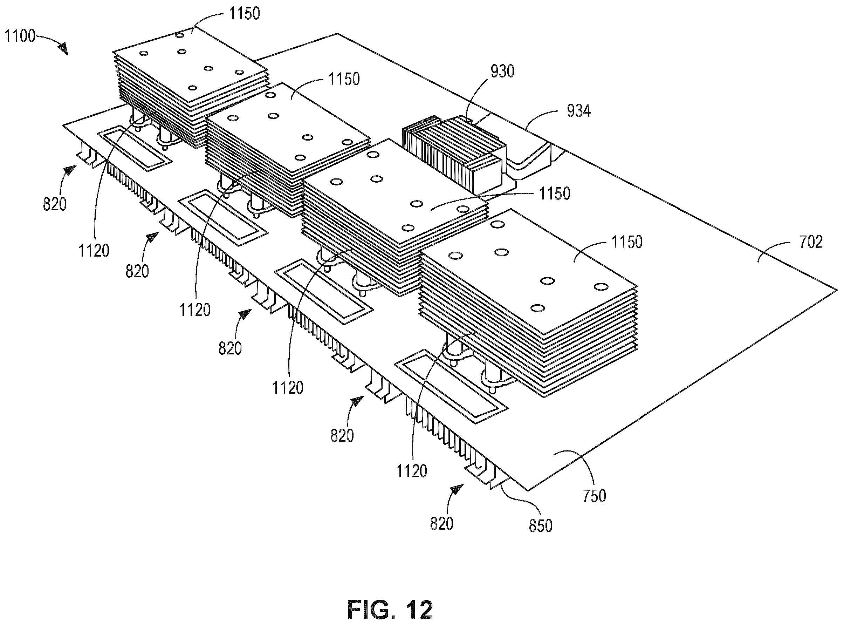

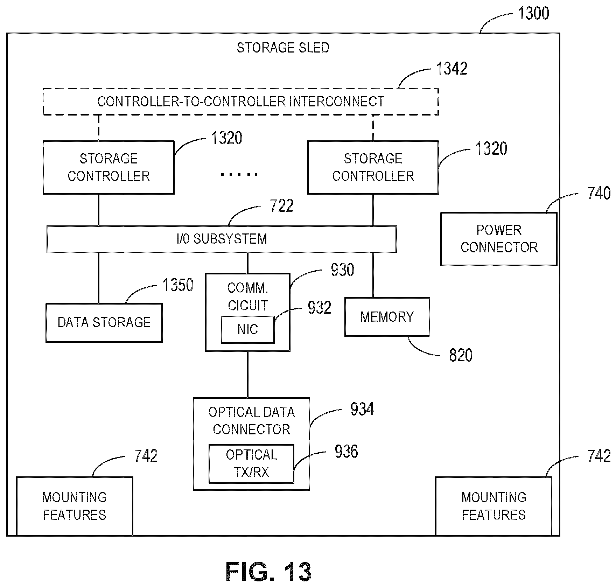

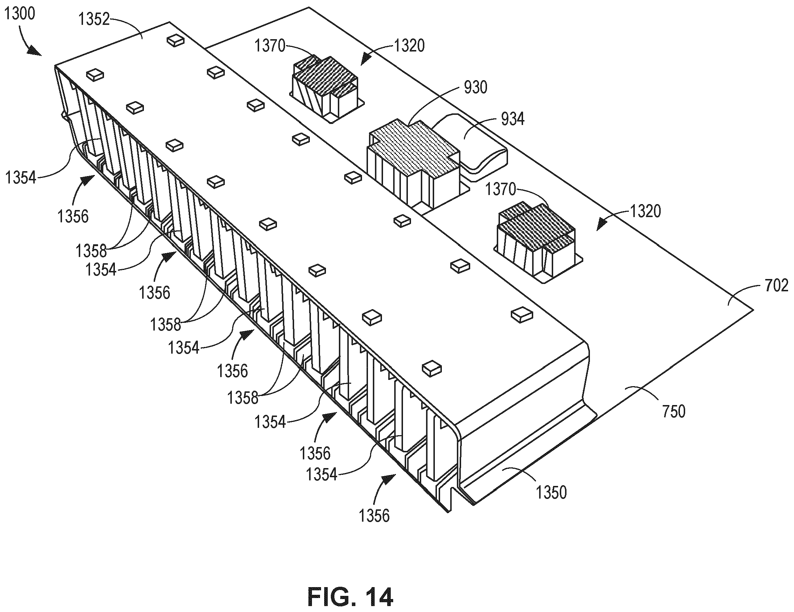

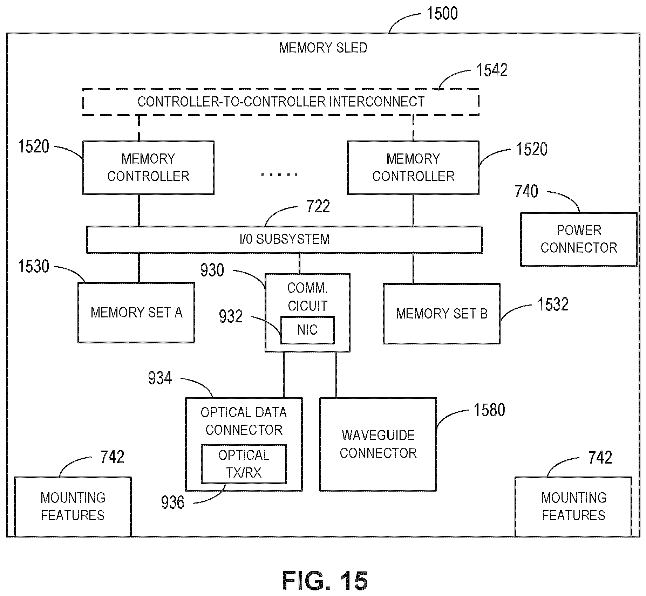

Referring now to FIG. 7, the sled 500, in the illustrative example, is configured to be mounted in a corresponding rack 340 of the data center 200 as discussed above. In some examples, a given sled 500 may be optimized or otherwise configured for performing particular tasks, such as compute tasks, acceleration tasks, data storage tasks, etc. For example, the sled 500 may be implemented as a compute sled 900 as discussed below in regard to FIGS. 9 and 10, an accelerator sled 1100 as discussed below in regard to FIGS. 11 and 12, a storage sled 1300 as discussed below in regard to FIGS. 13 and 14, or as a sled optimized or otherwise configured to perform other specialized tasks, such as a memory sled 1500, discussed below in regard to FIG. 15.

As discussed above, the illustrative sled 500 includes a chassis-less circuit board substrate 702, which supports various physical resources (e.g., electrical components) mounted thereon. It should be appreciated that the circuit board substrate 702 is "chassis-less" in that the sled 500 does not include a housing or enclosure. Rather, the chassis-less circuit board substrate 702 is open to the local environment. The chassis-less circuit board substrate 702 may be formed from any material capable of supporting the various electrical components mounted thereon. For example, in an illustrative example, the chassis-less circuit board substrate 702 is formed from an FR-4 glass-reinforced epoxy laminate material. Other materials may be used to form the chassis-less circuit board substrate 702 in other examples.

As discussed in more detail below, the chassis-less circuit board substrate 702 includes multiple features that improve the thermal cooling characteristics of the various electrical components mounted on the chassis-less circuit board substrate 702. As discussed, the chassis-less circuit board substrate 702 does not include a housing or enclosure, which may improve the airflow over the electrical components of the sled 500 by reducing those structures that may inhibit air flow. For example, because the chassis-less circuit board substrate 702 is not positioned in an individual housing or enclosure, there is no vertically-arranged backplane (e.g., a back plate of the chassis) attached to the chassis-less circuit board substrate 702, which could inhibit air flow across the electrical components. Additionally, the chassis-less circuit board substrate 702 has a geometric shape configured to reduce the length of the airflow path across the electrical components mounted to the chassis-less circuit board substrate 702. For example, the illustrative chassis-less circuit board substrate 702 has a width 704 that is greater than a depth 706 of the chassis-less circuit board substrate 702. In one particular example, the chassis-less circuit board substrate 702 has a width of about 21 inches and a depth of about 9 inches, compared to a typical server that has a width of about 17 inches and a depth of about 39 inches. As such, an airflow path 708 that extends from a front edge 710 of the chassis-less circuit board substrate 702 toward a rear edge 712 has a shorter distance relative to typical servers, which may improve the thermal cooling characteristics of the sled 500. Furthermore, although not illustrated in FIG. 7, the various physical resources mounted to the chassis-less circuit board substrate 702 in this example are mounted in corresponding locations such that no two substantively heat-producing electrical components shadow each other as discussed in more detail below. That is, no two electrical components, which produce appreciable heat during operation (i.e., greater than a nominal heat sufficient enough to adversely impact the cooling of another electrical component), are mounted to the chassis-less circuit board substrate 702 linearly in-line with each other along the direction of the airflow path 708 (i.e., along a direction extending from the front edge 710 toward the rear edge 712 of the chassis-less circuit board substrate 702). The placement and/or structure of the features may be suitable adapted when the electrical component(s) are being cooled via liquid (e.g., one phase or two phase cooling).

As discussed above, the illustrative sled 500 includes one or more physical resources 720 mounted to a top side 750 of the chassis-less circuit board substrate 702. Although two physical resources 720 are shown in FIG. 7, it should be appreciated that the sled 500 may include one, two, or more physical resources 720 in other examples. The physical resources 720 may be implemented as any type of programmable circuitry, controller, or other compute circuit capable of performing various tasks such as compute functions and/or controlling the functions of the sled 500 depending on, for example, the type or intended functionality of the sled 500. For example, as discussed in more detail below, the physical resources 720 may be implemented as high-performance processor circuitry in examples in which the sled 500 is implemented as a compute sled, as accelerator co-processor circuitry or circuits in examples in which the sled 500 is implemented as an accelerator sled, storage controllers in examples in which the sled 500 is implemented as a storage sled, or a set of memory devices in examples in which the sled 500 is implemented as a memory sled.

The sled 500 also includes one or more additional physical resources 730 mounted to the top side 750 of the chassis-less circuit board substrate 702. In the illustrative example, the additional physical resources include a network interface controller (NIC) as discussed in more detail below. Depending on the type and functionality of the sled 500, the physical resources 730 may include additional or other electrical components, circuits, and/or devices in other examples.

The physical resources 720 are communicatively coupled to the physical resources 730 via an input/output (I/O) subsystem 722. The I/O subsystem 722 may be implemented as circuitry and/or components to facilitate input/output operations with the physical resources 720, the physical resources 730, and/or other components of the sled 500. For example, the I/O subsystem 722 may be implemented as, or otherwise include, memory controller hubs, input/output control hubs, integrated sensor hubs, firmware devices, communication links (e.g., point-to-point links, bus links, wires, cables, waveguides, light guides, printed circuit board traces, etc.), and/or other components and subsystems to facilitate the input/output operations. In the illustrative example, the I/O subsystem 722 is implemented as, or otherwise includes, a double data rate 4 (DDR4) data bus or a DDR5 data bus.

In some examples, the sled 500 may also include a resource-to-resource interconnect 724. The resource-to-resource interconnect 724 may be implemented as any type of communication interconnect capable of facilitating resource-to-resource communications. In the illustrative example, the resource-to-resource interconnect 724 is implemented as a high-speed point-to-point interconnect (e.g., faster than the I/O subsystem 722). For example, the resource-to-resource interconnect 724 may be implemented as a QuickPath Interconnect (QPI), an UltraPath Interconnect (UPI), or other high-speed point-to-point interconnect dedicated to resource-to-resource communications.

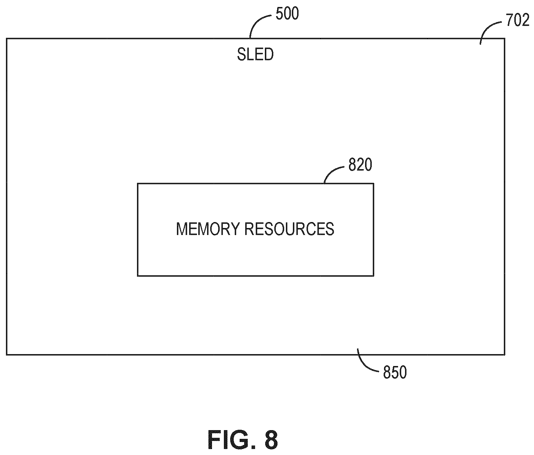

The sled 500 also includes a power connector 740 configured to mate with a corresponding power connector of the rack 340 when the sled 500 is mounted in the corresponding rack 340. The sled 500 receives power from a power supply of the rack 340 via the power connector 740 to supply power to the various electrical components of the sled 500. That is, the sled 500 does not include any local power supply (i.e., an on-board power supply) to provide power to the electrical components of the sled 500. The exclusion of a local or on-board power supply facilitates the reduction in the overall footprint of the chassis-less circuit board substrate 702, which may increase the thermal cooling characteristics of the various electrical components mounted on the chassis-less circuit board substrate 702 as discussed above. In some examples, voltage regulators are placed on a bottom side 850 (see FIG. 8) of the chassis-less circuit board substrate 702 directly opposite of programmable circuitry 920 (see FIG. 9), and power is routed from the voltage regulators to the programmable circuitry 920 by vias extending through the circuit board substrate 702. Such a configuration provides an increased thermal budget, additional current and/or voltage, and better voltage control relative to typical printed circuit boards in which processor power is delivered from a voltage regulator, in part, by printed circuit traces.

In some examples, the sled 500 may also include mounting features 742 configured to mate with a mounting arm, or other structure, of a robot to facilitate the placement of the sled 500 in a rack 340 by the robot. The mounting features 742 may be implemented as any type of physical structures that allow the robot to grasp the sled 500 without damaging the chassis-less circuit board substrate 702 or the electrical components mounted thereto. For example, in some examples, the mounting features 742 may be implemented as non-conductive pads attached to the chassis-less circuit board substrate 702. In other examples, the mounting features may be implemented as brackets, braces, or other similar structures attached to the chassis-less circuit board substrate 702. The particular number, shape, size, and/or make-up of the mounting feature 742 may depend on the design of the robot configured to manage the sled 500.

Referring now to FIG. 8, in addition to the physical resources 730 mounted on the top side 750 of the chassis-less circuit board substrate 702, the sled 500 also includes one or more memory devices 820 mounted to a bottom side 850 of the chassis-less circuit board substrate 702. That is, the chassis-less circuit board substrate 702 is implemented as a double-sided circuit board. The physical resources 720 are communicatively coupled to the memory devices 820 via the I/O subsystem 722. For example, the physical resources 720 and the memory devices 820 may be communicatively coupled by one or more vias extending through the chassis-less circuit board substrate 702. Different ones of the physical resources 720 may be communicatively coupled to different sets of one or more memory devices 820 in some examples. Alternatively, in other examples, different ones of the physical resources 720 may be communicatively coupled to the same ones of the memory devices 820.

The memory devices 820 may be implemented as any type of memory device capable of storing data for the physical resources 720 during operation of the sled 500, such as any type of volatile (e.g., dynamic random access memory (DRAM), etc.) or non-volatile memory. Volatile memory may be a storage medium that requires power to maintain the state of data stored by the medium. Non-limiting examples of volatile memory may include various types of random access memory (RAM), such as dynamic random access memory (DRAM) or static random access memory (SRAM). One particular type of DRAM that may be used in a memory module is synchronous dynamic random access memory (SDRAM). In particular examples, DRAM of a memory component may comply with a standard promulgated by JEDEC, such as JESD79F for DDR SDRAM, JESD79-2F for DDR2 SDRAM, JESD79-3F for DDR3 SDRAM, JESD79-4A for DDR4 SDRAM, JESD209 for Low Power DDR (LPDDR), JESD209-2 for LPDDR2, JESD209-3 for LPDDR3, and JESD209-4 for LPDDR4. Such standards (and similar standards) may be referred to as DDR-based standards and communication interfaces of the storage devices that implement such standards may be referred to as DDR-based interfaces.

In one example, the memory device is a block addressable memory device, such as those based on NAND or NOR technologies. A memory device may also include next-generation nonvolatile devices, such as Intel 3D XPoint^{™} memory or other byte addressable write-in-place nonvolatile memory devices. In one example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a DW (Domain Wall) and SOT (Spin Orbit Transfer) based device, a thyristor based memory device, or a combination of any of the above, or other memory. The memory device may refer to the die itself and/or to a packaged memory product. In some examples, the memory device may include a transistor-less stackable cross point architecture in which memory cells sit at the intersection of word lines and bit lines and are individually addressable and in which bit storage is based on a change in bulk resistance.

Referring now to FIG. 9, in some examples, the sled 500 may be implemented as a compute sled 900. The compute sled 900 is optimized, or otherwise configured, to perform compute tasks. As discussed above, the compute sled 900 may rely on other sleds, such as acceleration sleds and/or storage sleds, to perform such compute tasks. The compute sled 900 includes various physical resources (e.g., electrical components) similar to the physical resources of the sled 500, which have been identified in FIG. 9 using the same reference numbers. The description of such components provided above in regard to FIGS. 7 and 8 applies to the corresponding components of the compute sled 900 and is not repeated herein for clarity of the description of the compute sled 900.

In the illustrative compute sled 900, the physical resources 720 include programmable circuitry 920. Although only two blocks of programmable circuitry 920 are shown in FIG. 9, it should be appreciated that the compute sled 900 may include additional programmable circuits 920 in other examples. Illustratively, the programmable circuitry 920 corresponds to high-performance processor circuitry 920 and may be configured to operate at a relatively high power rating. Although the high-performance programmable circuitry 920 generates additional heat operating at power ratings greater than typical processor circuitry (which operate at around 155-230 W), the enhanced thermal cooling characteristics of the chassis-less circuit board substrate 702 discussed above facilitate the higher power operation. For example, in the illustrative example, the programmable circuitry 920 is configured to operate at a power rating of at least 250 W. In some examples, the programmable circuitry 920 may be configured to operate at a power rating of at least 350 W.

In some examples, the compute sled 900 may also include a programmable circuitry-to-programmable circuitry interconnect 942. Similar to the resource-to-resource interconnect 724 of the sled 500 discussed above, the programmable circuitry -to-programmable circuitry interconnect 942 may be implemented as any type of communication interconnect capable of facilitating programmable circuitry-to-programmable circuitry interconnect 942 communications. In the illustrative example, the programmable circuitry-to-programmable circuitry interconnect 942 is implemented as a high-speed point-to-point interconnect (e.g., faster than the I/O subsystem 722). For example, the programmable circuitry-to-programmable circuitry interconnect 942 may be implemented as a QuickPath Interconnect (QPI), an UltraPath Interconnect (UPI), or other high-speed point-to-point interconnect dedicated to programmable circuitry-to-programmable circuitry communications.

The compute sled 900 also includes a communication circuit 930. The illustrative communication circuit 930 includes a network interface controller (NIC) 932, which may also be referred to as a host fabric interface (HFI). The NIC 932 may be implemented as, or otherwise include, any type of integrated circuit, discrete circuits, controller chips, chipsets, add-in-boards, daughtercards, network interface cards, or other devices that may be used by the compute sled 900 to connect with another compute device (e.g., with other sleds 500). In some examples, the NIC 932 may be implemented as part of a system-on-a-chip (SoC) that includes one or more processor circuits, or included on a multichip package that also contains one or more processor circuits. In some examples, the NIC 932 may include a local processor circuit (not shown) and/or a local memory (not shown) that are both local to the NIC 932. In such examples, the local processor circuit of the NIC 932 may be capable of performing one or more of the functions of the programmable circuitry 920. Additionally or alternatively, in such examples, the local memory of the NIC 932 may be integrated into one or more components of the compute sled at the board level, socket level, chip level, and/or other levels.

The communication circuit 930 is communicatively coupled to an optical data connector 934. The optical data connector 934 is configured to mate with a corresponding optical data connector of the rack 340 when the compute sled 900 is mounted in the rack 340. Illustratively, the optical data connector 934 includes a plurality of optical fibers which lead from a mating surface of the optical data connector 934 to an optical transceiver 936. The optical transceiver 936 is configured to convert incoming optical signals from the rack-side optical data connector to electrical signals and to convert electrical signals to outgoing optical signals to the rack-side optical data connector. Although shown as forming part of the optical data connector 934 in the illustrative example, the optical transceiver 936 may form a portion of the communication circuit 930 in other examples.

In some examples, the compute sled 900 may also include an expansion connector 940. In such examples, the expansion connector 940 is configured to mate with a corresponding connector of an expansion chassis-less circuit board substrate to provide additional physical resources to the compute sled 900. The additional physical resources may be used, for example, by the programmable circuitry 920 during operation of the compute sled 900. The expansion chassis-less circuit board substrate may be substantially similar to the chassis-less circuit board substrate 702 discussed above and may include various electrical components mounted thereto. The particular electrical components mounted to the expansion chassis-less circuit board substrate may depend on the intended functionality of the expansion chassis-less circuit board substrate. For example, the expansion chassis-less circuit board substrate may provide additional compute resources, memory resources, and/or storage resources. As such, the additional physical resources of the expansion chassis-less circuit board substrate may include, but is not limited to, processor circuitry, memory devices, storage devices, and/or accelerator circuits including, for example, field programmable gate arrays (FPGA), application-specific integrated circuits (ASICs), security co-processor circuits, graphics processing units (GPUs), machine learning circuits, or other specialized processor circuits, controllers, devices, and/or circuits.

Referring now to FIG. 10, an illustrative example of the compute sled 900 is shown. As shown, the programmable circuitry 920, communication circuit 930, and optical data connector 934 are mounted to the top side 750 of the chassis-less circuit board substrate 702. Any suitable attachment or mounting technology may be used to mount the physical resources of the compute sled 900 to the chassis-less circuit board substrate 702. For example, the various physical resources may be mounted in corresponding sockets (e.g., a processor circuit socket), holders, or brackets. In some cases, some of the electrical components may be directly mounted to the chassis-less circuit board substrate 702 via soldering or similar techniques.

As discussed above, the separate programmable circuitry 920 and the communication circuit 930 are mounted to the top side 750 of the chassis-less circuit board substrate 702 such that no two heat-producing, electrical components shadow each other. In the illustrative example, the programmable circuitry 920 and the communication circuit 930 are mounted in corresponding locations on the top side 750 of the chassis-less circuit board substrate 702 such that no two of those physical resources are linearly in-line with others along the direction of the airflow path 708. It should be appreciated that, although the optical data connector 934 is in-line with the communication circuit 930, the optical data connector 934 produces no or nominal heat during operation.

The memory devices 820 of the compute sled 900 are mounted to the bottom side 850 of the of the chassis-less circuit board substrate 702 as discussed above in regard to the sled 500. Although mounted to the bottom side 850, the memory devices 820 are communicatively coupled to the programmable circuitry 920 located on the top side 750 via the I/O subsystem 722. Because the chassis-less circuit board substrate 702 is implemented as a double-sided circuit board, the memory devices 820 and the programmable circuitry 920 may be communicatively coupled by one or more vias, connectors, or other mechanisms extending through the chassis-less circuit board substrate 702. Different programmable circuitry 920 (e.g., different processor circuitry) may be communicatively coupled to a different set of one or more memory devices 820 in some examples. Alternatively, in other examples, different programmable circuitry 920 (e.g., different processor circuitry) may be communicatively coupled to the same ones of the memory devices 820. In some examples, the memory devices 820 may be mounted to one or more memory mezzanines on the bottom side of the chassis-less circuit board substrate 702 and may interconnect with a corresponding programmable circuitry 920 through a ball-grid array.

Different programmable circuitry 920 (e.g., different processor circuitry) include and/or is associated with corresponding heatsinks 950 secured thereto. Due to the mounting of the memory devices 820 to the bottom side 850 of the chassis-less circuit board substrate 702 (as well as the vertical spacing of the sleds 500 in the corresponding rack 340), the top side 750 of the chassis-less circuit board substrate 702 includes additional "free" area or space that facilitates the use of heatsinks 950 having a larger size relative to traditional heatsinks used in typical servers. Additionally, due to the improved thermal cooling characteristics of the chassis-less circuit board substrate 702, none of the programmable circuitry heatsinks 950 include cooling fans attached thereto. That is, the heatsinks 950 may be fan-less heatsinks. In some examples, the heatsinks 950 mounted atop the programmable circuitry 920 may overlap with the heatsink attached to the communication circuit 930 in the direction of the airflow path 708 due to their increased size, as illustratively suggested by FIG. 10.

Referring now to FIG. 11, in some examples, the sled 500 may be implemented as an accelerator sled 1100. The accelerator sled 1100 is configured to perform specialized compute tasks, such as machine learning, encryption, hashing, or other computational-intensive task. In some examples, for example, a compute sled 900 may offload tasks to the accelerator sled 1100 during operation. The accelerator sled 1100 includes various components similar to components of the sled 500 and/or the compute sled 900, which have been identified in FIG. 11 using the same reference numbers. The description of such components provided above in regard to FIGS. 7, 8, and 9 apply to the corresponding components of the accelerator sled 1100 and is not repeated herein for clarity of the description of the accelerator sled 1100.

In the illustrative accelerator sled 1100, the physical resources 720 include accelerator circuits 1120. Although only two accelerator circuits 1120 are shown in FIG. 11, it should be appreciated that the accelerator sled 1100 may include additional accelerator circuits 1120 in other examples. For example, as shown in FIG. 12, the accelerator sled 1100 may include four accelerator circuits 1120. The accelerator circuits 1120 may be implemented as any type of processor circuitry, co-processor circuitry, compute circuit, or other device capable of performing compute or processing operations. For example, the accelerator circuits 1120 may be implemented as, for example, field programmable gate arrays (FPGA), application-specific integrated circuits (ASICs), security co-processor circuitry, graphics processing units (GPUs), neuromorphic processor units, quantum computers, machine learning circuits, or other specialized processor circuitry, controllers, devices, and/or circuits.

In some examples, the accelerator sled 1100 may also include an accelerator-to-accelerator interconnect 1142. Similar to the resource-to-resource interconnect 724 of the sled 500 discussed above, the accelerator-to-accelerator interconnect 1142 may be implemented as any type of communication interconnect capable of facilitating accelerator-to-accelerator communications. In the illustrative example, the accelerator-to-accelerator interconnect 1142 is implemented as a high-speed point-to-point interconnect (e.g., faster than the I/O subsystem 722). For example, the accelerator-to-accelerator interconnect 1142 may be implemented as a QuickPath Interconnect (QPI), an UltraPath Interconnect (UPI), or other high-speed point-to-point interconnect dedicated to programmable circuitry-to-programmable circuitry communications. In some examples, the accelerator circuits 1120 may be daisy-chained with a primary accelerator circuit 1120 connected to the NIC 932 and memory 820 through the I/O subsystem 722 and a secondary accelerator circuit 1120 connected to the NIC 932 and memory 820 through a primary accelerator circuit 1120.

Referring now to FIG. 12, an illustrative example of the accelerator sled 1100 is shown. As discussed above, the accelerator circuits 1120, the communication circuit 930, and the optical data connector 934 are mounted to the top side 750 of the chassis-less circuit board substrate 702. Again, the individual accelerator circuits 1120 and communication circuit 930 are mounted to the top side 750 of the chassis-less circuit board substrate 702 such that no two heat-producing, electrical components shadow each other as discussed above. The memory devices 820 of the accelerator sled 1100 are mounted to the bottom side 850 of the of the chassis-less circuit board substrate 702 as discussed above in regard to the sled 500. Although mounted to the bottom side 850, the memory devices 820 are communicatively coupled to the accelerator circuits 1120 located on the top side 750 via the I/O subsystem 722 (e.g., through vias). Further, the accelerator circuits 1120 may include and/or be associated with a heatsink 1150 that is larger than a traditional heatsink used in a server. As discussed above with reference to the heatsinks 950 of FIG. 9, the heatsinks 1150 may be larger than traditional heatsinks because of the "free" area provided by the memory resources 820 being located on the bottom side 850 of the chassis-less circuit board substrate 702 rather than on the top side 750.

Referring now to FIG. 13, in some examples, the sled 500 may be implemented as a storage sled 1300. The storage sled 1300 is configured to store data in a data storage 1350 local to the storage sled 1300. For example, during operation, a compute sled 900 or an accelerator sled 1100 may store and retrieve data from the data storage 1350 of the storage sled 1300. The storage sled 1300 includes various components similar to components of the sled 500 and/or the compute sled 900, which have been identified in FIG. 13 using the same reference numbers. The description of such components provided above in regard to FIGS. 7, 8, and 9 apply to the corresponding components of the storage sled 1300 and is not repeated herein for clarity of the description of the storage sled 1300.

In the illustrative storage sled 1300, the physical resources 720 includes storage controllers 1320. Although only two storage controllers 1320 are shown in FIG. 13, it should be appreciated that the storage sled 1300 may include additional storage controllers 1320 in other examples. The storage controllers 1320 may be implemented as any type of programmable circuitry, controller, or control circuit capable of controlling the storage and retrieval of data into the data storage 1350 based on requests received via the communication circuit 930. In the illustrative example, the storage controllers 1320 are implemented as relatively low-power programmable circuitry or controllers. For example, in some examples, the storage controllers 1320 may be configured to operate at a power rating of about 75 watts.

In some examples, the storage sled 1300 may also include a controller-to-controller interconnect 1342. Similar to the resource-to-resource interconnect 724 of the sled 500 discussed above, the controller-to-controller interconnect 1342 may be implemented as any type of communication interconnect capable of facilitating controller-to-controller communications. In the illustrative example, the controller-to-controller interconnect 1342 is implemented as a high-speed point-to-point interconnect (e.g., faster than the I/O subsystem 722). For example, the controller-to-controller interconnect 1342 may be implemented as a QuickPath Interconnect (QPI), an UltraPath Interconnect (UPI), or other high-speed point-to-point interconnect dedicated to programmable circuitry-to-programmable circuitry communications.

Referring now to FIG. 14, an illustrative example of the storage sled 1300 is shown. In the illustrative example, the data storage 1350 is implemented as, or otherwise includes, a storage cage 1352 configured to house one or more solid state drives (SSDs) 1354. To do so, the storage cage 1352 includes a number of mounting slots 1356, which are configured to receive corresponding solid state drives 1354. The mounting slots 1356 include a number of drive guides 1358 that cooperate to define an access opening of the corresponding mounting slot 1356. The storage cage 1352 is secured to the chassis-less circuit board substrate 702 such that the access openings face away from (i.e., toward the front of) the chassis-less circuit board substrate 702. As such, solid state drives 1354 are accessible while the storage sled 1300 is mounted in a corresponding rack 340. For example, a solid state drive 1354 may be swapped out of a rack 340 (e.g., via a robot) while the storage sled 1300 remains mounted in the corresponding rack 340.

The storage cage 1352 illustratively includes sixteen mounting slots 1356 and is capable of mounting and storing sixteen solid state drives 1354. The storage cage 1352 may be configured to store additional or fewer solid state drives 1354 in other examples. Additionally, in the illustrative example, the solid state drives are mounted vertically in the storage cage 1352, but may be mounted in the storage cage 1352 in a different orientation in other examples. A given solid state drive 1354 may be implemented as any type of data storage device capable of storing long term data. To do so, the solid state drives 1354 may include volatile and non-volatile memory devices discussed above.

As shown in FIG. 14, the storage controllers 1320, the communication circuit 930, and the optical data connector 934 are illustratively mounted to the top side 750 of the chassis-less circuit board substrate 702. Again, as discussed above, any suitable attachment or mounting technology may be used to mount the electrical components of the storage sled 1300 to the chassis-less circuit board substrate 702 including, for example, sockets (e.g., a processor circuit socket), holders, brackets, soldered connections, and/or other mounting or securing techniques.

As discussed above, the individual storage controllers 1320 and the communication circuit 930 are mounted to the top side 750 of the chassis-less circuit board substrate 702 such that no two heat-producing, electrical components shadow each other. For example, the storage controllers 1320 and the communication circuit 930 are mounted in corresponding locations on the top side 750 of the chassis-less circuit board substrate 702 such that no two of those electrical components are linearly in-line with each other along the direction of the airflow path 708.

The memory devices 820 (not shown in FIG. 14) of the storage sled 1300 are mounted to the bottom side 850 (not shown in FIG. 14) of the chassis-less circuit board substrate 702 as discussed above in regard to the sled 500. Although mounted to the bottom side 850, the memory devices 820 are communicatively coupled to the storage controllers 1320 located on the top side 750 via the I/O subsystem 722. Again, because the chassis-less circuit board substrate 702 is implemented as a double-sided circuit board, the memory devices 820 and the storage controllers 1320 may be communicatively coupled by one or more vias, connectors, or other mechanisms extending through the chassis-less circuit board substrate 702. The storage controllers 1320 include and/or are associated with a heatsink 1370 secured thereto. As discussed above, due to the improved thermal cooling characteristics of the chassis-less circuit board substrate 702 of the storage sled 1300, none of the heatsinks 1370 include cooling fans attached thereto. That is, the heatsinks 1370 may be fan-less heatsinks.

Referring now to FIG. 15, in some examples, the sled 500 may be implemented as a memory sled 1500. The storage sled 1500 is optimized, or otherwise configured, to provide other sleds 500 (e.g., compute sleds 900, accelerator sleds 1100, etc.) with access to a pool of memory (e.g., in two or more sets 1530, 1532 of memory devices 820) local to the memory sled 1300. For example, during operation, a compute sled 900 or an accelerator sled 1100 may remotely write to and/or read from one or more of the memory sets 1530, 1532 of the memory sled 1300 using a logical address space that maps to physical addresses in the memory sets 1530, 1532. The memory sled 1500 includes various components similar to components of the sled 500 and/or the compute sled 900, which have been identified in FIG. 15 using the same reference numbers. The description of such components provided above in regard to FIGS. 7, 8, and 9 apply to the corresponding components of the memory sled 1500 and is not repeated herein for clarity of the description of the memory sled 1500.

In the illustrative memory sled 1500, the physical resources 720 include memory controllers 1520. Although only two memory controllers 1520 are shown in FIG. 15, it should be appreciated that the memory sled 1500 may include additional memory controllers 1520 in other examples. The memory controllers 1520 may be implemented as any type of programmable circuitry, controller, or control circuit capable of controlling the writing and reading of data into the memory sets 1530, 1532 based on requests received via the communication circuit 930. In the illustrative example, the memory controllers 1520 are connected to corresponding memory sets 1530, 1532 to write to and read from memory devices 820 (not shown) within the corresponding memory set 1530, 1532 and enforce any permissions (e.g., read, write, etc.) associated with sled 500 that has sent a request to the memory sled 1500 to perform a memory access operation (e.g., read or write).

In some examples, the memory sled 1500 may also include a controller-to-controller interconnect 1542. Similar to the resource-to-resource interconnect 724 of the sled 500 discussed above, the controller-to-controller interconnect 1542 may be implemented as any type of communication interconnect capable of facilitating controller-to-controller communications. In the illustrative example, the controller-to-controller interconnect 1542 is implemented as a high-speed point-to-point interconnect (e.g., faster than the I/O subsystem 722). For example, the controller-to-controller interconnect 1542 may be implemented as a QuickPath Interconnect (QPI), an UltraPath Interconnect (UPI), or other high-speed point-to-point interconnect dedicated to programmable circuitry-to-programmable circuitry communications. As such, in some examples, a memory controller 1520 may access, through the controller-to-controller interconnect 1542, memory that is within the memory set 1532 associated with another memory controller 1520. In some examples, a scalable memory controller is made of multiple smaller memory controllers, referred to herein as "chiplets", on a memory sled (e.g., the memory sled 1500). The chiplets may be interconnected (e.g., using EMIB (Embedded Multi-Die Interconnect Bridge) technology). The combined chiplet memory controller may scale up to a relatively large number of memory controllers and I/O ports, (e.g., up to 16 memory channels). In some examples, the memory controllers 1520 may implement a memory interleave (e.g., one memory address is mapped to the memory set 1530, the next memory address is mapped to the memory set 1532, and the third address is mapped to the memory set 1530, etc.). The interleaving may be managed within the memory controllers 1520, or from CPU sockets (e.g., of the compute sled 900) across network links to the memory sets 1530, 1532, and may improve the latency associated with performing memory access operations as compared to accessing contiguous memory addresses from the same memory device.

Further, in some examples, the memory sled 1500 may be connected to one or more other sleds 500 (e.g., in the same rack 340 or an adjacent rack 340) through a waveguide, using the waveguide connector 1580. In the illustrative example, the waveguides are 74 millimeter waveguides that provide 16 Rx (i.e., receive) lanes and 16 Tx (i.e., transmit) lanes. Different ones of the lanes, in the illustrative example, are either 16 GHz or 32 GHz. In other examples, the frequencies may be different. Using a waveguide may provide high throughput access to the memory pool (e.g., the memory sets 1530, 1532) to another sled (e.g., a sled 500 in the same rack 340 or an adjacent rack 340 as the memory sled 1500) without adding to the load on the optical data connector 934.

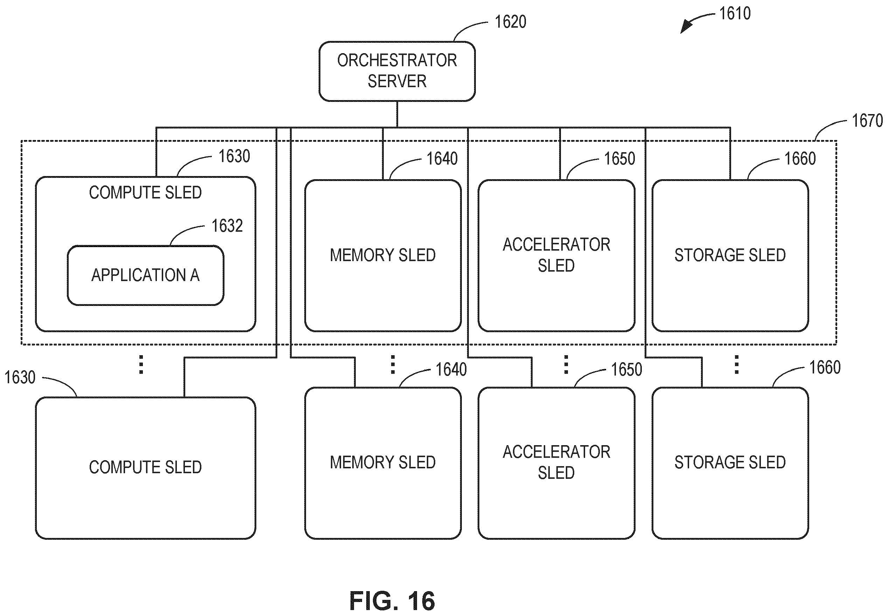

Referring now to FIG. 16, a system for executing one or more workloads (e.g., applications) may be implemented in accordance with the data center 200. In the illustrative example, the system 1610 includes an orchestrator server 1620, which may be implemented as a managed node including a compute device (e.g., programmable circuitry 920 on a compute sled 900) executing management software (e.g., a cloud operating environment, such as OpenStack) that is communicatively coupled to multiple sleds 500 including a large number of compute sleds 1630 (e.g., similar to the compute sled 900), memory sleds 1640 (e.g., similar to the memory sled 1500), accelerator sleds 1650 (e.g., similar to the memory sled 1500), and storage sleds 1660 (e.g., similar to the storage sled 1300). One or more of the sleds 1630, 1640, 1650, 1660 may be grouped into a managed node 1670, such as by the orchestrator server 1620, to collectively perform a workload (e.g., an application 1632 executed in a virtual machine or in a container). The managed node 1670 may be implemented as an assembly of physical resources 720, such as programmable circuitry 920, memory resources 820, accelerator circuits 1120, or data storage 1350, from the same or different sleds 500. Further, the managed node may be established, defined, or "spun up" by the orchestrator server 1620 at the time a workload is to be assigned to the managed node or at any other time, and may exist regardless of whether any workloads are presently assigned to the managed node. In the illustrative example, the orchestrator server 1620 may selectively allocate and/or deallocate physical resources 720 from the sleds 500 and/or add or remove one or more sleds 500 from the managed node 1670 as a function of quality of service (QoS) targets (e.g., a target throughput, a target latency, a target number of instructions per second, etc.) associated with a service level agreement for the workload (e.g., the application 1632). In doing so, the orchestrator server 1620 may receive telemetry data indicative of performance conditions (e.g., throughput, latency, instructions per second, etc.) in different ones of the sleds 500 of the managed node 1670 and compare the telemetry data to the quality of service targets to determine whether the quality of service targets are being satisfied. The orchestrator server 1620 may additionally determine whether one or more physical resources may be deallocated from the managed node 1670 while still satisfying the QoS targets, thereby freeing up those physical resources for use in another managed node (e.g., to execute a different workload). Alternatively, if the QoS targets are not presently satisfied, the orchestrator server 1620 may determine to dynamically allocate additional physical resources to assist in the execution of the workload (e.g., the application 1632) while the workload is executing. Similarly, the orchestrator server 1620 may determine to dynamically deallocate physical resources from a managed node if the orchestrator server 1620 determines that deallocating the physical resource would result in QoS targets still being met.

Additionally, in some examples, the orchestrator server 1620 may identify trends in the resource utilization of the workload (e.g., the application 1632), such as by identifying phases of execution (e.g., time periods in which different operations, having different resource utilizations characteristics, are performed) of the workload (e.g., the application 1632) and pre-emptively identifying available resources in the data center 200 and allocating them to the managed node 1670 (e.g., within a predefined time period of the associated phase beginning). In some examples, the orchestrator server 1620 may model performance based on various latencies and a distribution scheme to place workloads among compute sleds and other resources (e.g., accelerator sleds, memory sleds, storage sleds) in the data center 200. For example, the orchestrator server 1620 may utilize a model that accounts for the performance of resources on the sleds 500 (e.g., FPGA performance, memory access latency, etc.) and the performance (e.g., congestion, latency, bandwidth) of the path through the network to the resource (e.g., FPGA). As such, the orchestrator server 1620 may determine which resource(s) should be used with which workloads based on the total latency associated with different potential resource(s) available in the data center 200 (e.g., the latency associated with the performance of the resource itself in addition to the latency associated with the path through the network between the compute sled executing the workload and the sled 500 on which the resource is located).

In some examples, the orchestrator server 1620 may generate a map of heat generation in the data center 200 using telemetry data (e.g., temperatures, fan speeds, etc.) reported from the sleds 500 and allocate resources to managed nodes as a function of the map of heat generation and predicted heat generation associated with different workloads, to maintain a target temperature and heat distribution in the data center 200. Additionally or alternatively, in some examples, the orchestrator server 1620 may organize received telemetry data into a hierarchical model that is indicative of a relationship between the managed nodes (e.g., a spatial relationship such as the physical locations of the resources of the managed nodes within the data center 200 and/or a functional relationship, such as groupings of the managed nodes by the customers the managed nodes provide services for, the types of functions typically performed by the managed nodes, managed nodes that typically share or exchange workloads among each other, etc.). Based on differences in the physical locations and resources in the managed nodes, a given workload may exhibit different resource utilizations (e.g., cause a different internal temperature, use a different percentage of programmable circuitry or memory capacity) across the resources of different managed nodes. The orchestrator server 1620 may determine the differences based on the telemetry data stored in the hierarchical model and factor the differences into a prediction of future resource utilization of a workload if the workload is reassigned from one managed node to another managed node, to accurately balance resource utilization in the data center 200. In some examples, the orchestrator server 1620 may identify patterns in resource utilization phases of the workloads and use the patterns to predict future resource utilization of the workloads.

To reduce the computational load on the orchestrator server 1620 and the data transfer load on the network, in some examples, the orchestrator server 1620 may send self-test information to the sleds 500 to enable a given sled 500 to locally (e.g., on the sled 500) determine whether telemetry data generated by the sled 500 satisfies one or more conditions (e.g., an available capacity that satisfies a predefined threshold, a temperature that satisfies a predefined threshold, etc.). The given sled 500 may then report back a simplified result (e.g., yes or no) to the orchestrator server 1620, which the orchestrator server 1620 may utilize in determining the allocation of resources to managed nodes.

FIG. 17 illustrates an example environment 1700 (e.g., one or more of the central data centers 102, one or more of the edge data centers 106, one or more of the buildings 110, one or more of the CDN data centers 116 of FIG. 1) including a liquid cooling system 1701 in which examples disclosed herein can be implemented. The liquid cooling system 1701 includes a coolant flowline 1702 to convey coolant between a cooling distribution unit (CDU) 1704 and server housings 1706, 1708 (e.g., a first server housing 1706 and a second server housing 1708). As used herein, a "flowline" can refer to one or more paths (e.g., a flow path(s), flow direction(s), etc.) of the coolant and/or a structure (e.g., pipe, conduit, casing, duct, etc.) used to enclose (e.g., direct, guide, convey, carry, etc.) the coolant. The CDU 1704 includes a heat exchanger 1710 that absorbs heat from the coolant carried by the coolant flowline 1702.

The CDU 1704 can be associated with a row of server housings that includes the server housings 1706, 1708. For example, the environment 1700 can include multiple rows of the server housings 1706 (e.g., rows-of-racks configuration shown in FIGS. 2 and 3) with ones of the CDU 1704 positioned at the end of each row to facilitate cooling circuitry (e.g., servers) in the server housings 1706 in the row associated therewith. In the illustrated example of FIG. 17, the server housings 1706, 1708 are server racks (e.g., the rack 340). In some examples, the server housings 1706, 1708 are immersion tanks. While a certain number of instances of server housings 1706, 1708 are shown in FIG. 17, it should be understood that the environment 1700 may include any number of instances of the server housings 1706, 1708 (i.e., additional or fewer server housings 1706, 1708).

In the illustrated example of FIG. 17, the server housings 1706, 1708 can include sleds that hold one or more servers 1711 (e.g., CPU servers, GPU servers, xPU servers). While a certain number of instances of the servers 1711 are shown in the server housings 1706, 1708 in FIG. 17, it should be understood that the environment 1700 may include any number of instances of the servers 1711 in the server housings 1706, 1708 (i.e., additional or fewer servers 1711 in the server housings 1706, 1708). The coolant in the coolant flowline 1702 cools the servers 1711 to increase an efficiency of the servers 1711, such as by obtaining a certain power dissipation and/or performance-per-watt. In the illustrated example of FIG. 17, the coolant is a conductive liquid that can cause damage upon contact with powered electronic components of the servers 1711. In this example, the coolant indirectly cools the servers 1711 by cooling a cold plate that is thermally coupled to the servers 1711. In some examples, the coolant is a dielectric liquid in which the servers 1711 are immersed for cooling, as discussed further in association with FIG. 22. For visual clarity in FIG. 17, not every instance of the servers 1711 is labeled.

In the illustrated example of FIG. 17, the coolant flowline 1702 includes a cold portion 1712 and a hot portion 1714. The cold portion 1712 carries the coolant to the server housings 1706 after the coolant is cooled via the heat exchanger 1710 in the CDU 1704. The hot portion 1714 carries the coolant to the CDU 1704 after the coolant absorbs heat from the servers 1711 in the server housings 1706, 1708.

The cold portion 1712 of the flowline 1702 includes a CDU output conduit 1716, housing conduits 1718, 1720 (e.g., a first housing conduit 1718, a second housing conduit 1720) that carry the coolant from the CDU output conduit 1716 to the respective server housings 1706, 1708, and first server conduits 1722 that carry the coolant from the housing conduits 1718, 1720 to and/or across the cold plates that are thermally coupled to the respective servers 1711. Specifically, the second housing conduit 1720 is connected to the CDU output conduit 1716 downstream of the first housing conduit 1718. The housing conduits 1718, 1720 are positioned on opposite ends of the sleds that hold the servers 1711 in the respective server housings 1706, 1708 (e.g., on opposite sides of the rack). That is, the first housing conduit 1718 of the flowline 1702 extends across a first side of the first server housing 1706 (e.g., on a first side of the sleds in the first server housing 1706) and across a second side of the first server housing 1706 opposite the first side (e.g., on a second side of the sleds opposite the first side). Further, the server conduits 1722 extend from the housing conduits 1718, 1720 to and/or across the cold plates that are thermally coupled to the servers 1711 in the first server housing 1706. Specifically, respective ones of the server conduits 1722 are associated with respective ones of the cold plates, which are associated with respective ones of the servers 1711 in the server housings 1706, 1708. Thus, the respective ones of the server conduits 1722 deliver coolant to a respective portion of the server housings 1706 that is thermally coupled to one of the servers 1711.

Similarly, the hot portion 1714 of the flowline includes a CDU input conduit 1724, housing conduits 1726, 1728 (e.g., a third housing conduit 1726, a fourth housing conduit 1728) that carry the coolant from the server housings 1706, 1708 to the CDU input conduit 1724, and second server conduits 1730 that carry the coolant from the cold plates thermally coupled to the servers 1711 in the server housings 1706, 1708 to the housing conduits 1726, 1728. Specifically, after the coolant flows through one of the first server conduits 1722 and cools the cold plate and, in turn, one of the servers 1711, the second server conduits 1730 carry the coolant from the cold plates and/or the first server conduits 1722 to the housing conduits 1726, 1728, which direct the coolant to the CDU input conduit 1724. Further, the CDU input conduit 1726 carries the coolant to the heat exchanger 1710 of the CDU 1704 to cool the coolant and enable the cooled coolant to be redistributed to the server housings 1706, 1708 to again absorb heat from the servers 1711.

In the illustrated example of FIG. 17, the liquid cooling system 1701 includes sensors 1732 (e.g., temperature sensors, pressure sensors, flow rate sensors, leak sensors, etc.) (signified by boxes with cross-hatching in FIG. 17) that are positioned in, and/or operatively coupled to, the server housings 1706, 1708, the flowline 1702, and/or the CDU heat exchanger 1710 to detect parameters (e.g., a temperature, a pressure, a flow rate, coolant leakage, etc.) associated with the coolant and/or the servers 1711 in the server housings 1706, 1708. For example, the sensors 1732 can be positioned in, and/or operatively coupled to the CDU 1704, the respective servers 1711, the CDU output conduit 1716, the respective housing conduits 1718, 1720, 1726, 1728, the respective first server conduits 1722, the CDU input conduit 1724, the respective second server conduits 1730, and/or the server housings 1706, 1708. While a certain number of instances of the sensors 1732 is shown in FIG. 17, it should be understood that the environment 1700 may include any number of instances of the sensors 1732 (i.e., additional or fewer sensors 1732). Similarly, while the sensors 1732 are shown in certain positions in FIG. 17, it should be understood that the sensors 1732 may be placed in alternative positions based on, for instance, areas of thermal interest and/or areas in which coolant leakage can cause damage to electronics in the environment 1700.

In the illustrated example of FIG. 17, the liquid cooling system 1701 includes first actuators 1734 (e.g., remote actuators, rack-level actuators) and second actuators 1736 (e.g., local actuators, server-level actuators) to control a flow of the coolant in the coolant flowline 1702. For example, the actuators 1734, 1736 can be associated with (e.g., a part of or operatively coupled to) pumps and/or valves that control a flow rate of the coolant. In the illustrated example of FIG. 17, the first actuators 1734 control a flow of the coolant from the CDU output conduit 1716 to the housing conduits 1718, 1720. The second actuators 1736 control a flow of the coolant from the housing conduits 1718, 1720 to the first server conduits 1722 and, thus, to the cold plates thermally coupled to the servers 1711. As such, the first actuators 1734 cause a first flow rate to be implemented in the housing conduits 1718, 1720, and the second actuators 1736 cause a second flow rate that is different than (e.g., less than) the first flow rate to be implemented in the first server conduits 1722. In some examples, the servers 1711 include different sockets for different components thereof (e.g., different processor circuit sockets). In some such examples, the respective second actuators 1736 control a flow rate of the coolant to the respective socket-level component of the server 1711. Accordingly, different ones of the second actuators 1736 can cause a first flow rate to be delivered to a first portion of the server 1711 (e.g., a first socket-level component of the server 1711) and cause a second flow rate (e.g., a flow rate different than the first flow rate) to be delivered to a second portion of the server 1711 (e.g., a second socket-level component of the server 1711).

In the illustrated example of FIG. 17, the CDU 1704 includes CDU circuitry 1738 to control a distribution of the coolant to the server housings 1706, 1708. The CDU circuitry 1738 of FIG. 17 may be instantiated (e.g., creating an instance of, bring into being for any length of time, materialize, implement, etc.) by programmable circuitry such as a Central Processor Unit (CPU) executing first instructions. Additionally or alternatively, the CDU circuitry 1738 of FIG. 17 may be instantiated (e.g., creating an instance of, bring into being for any length of time, materialize, implement, etc.) by (i) an Application Specific Integrated Circuit (ASIC) and/or (ii) a Field Programmable Gate Array (FPGA) structured and/or configured in response to execution of second instructions to perform operations corresponding to the first instructions. It should be understood that some or all of the CDU circuitry 1738 of FIG. 17 may, thus, be instantiated at the same or different times. Some or all of the CDU circuitry 1738 of FIG. 17 may be instantiated, for example, in one or more threads executing concurrently on hardware and/or in series on hardware. Moreover, in some examples, some or all of the CDU circuitry 1738 of FIG. 17 may be implemented by microprocessor circuitry executing instructions and/or FPGA circuitry performing operations to implement one or more virtual machines and/or containers.

In this example, the CDU circuitry 1738 is positioned outside of the server housings 1706, 1708 in the end-of-row CDU 1704. The CDU circuitry 1738 can be communicatively coupled to the servers 1711, the sensors 1732, the first actuators 1734, and/or the second actuators 1736. In some examples, the CDU circuitry 1738 receives telemetry data indicative of performance conditions (e.g., throughput, latency, instructions per second, etc.) associated with the servers 1711. The CDU circuitry 1738 can control the actuators 1734, 1736 based on the parameters detected by the sensors 1732 and/or workloads being performed by the servers 1711. Specifically, the CDU circuitry 1738 controls the actuators 1734, 1736 to achieve a temperature for the servers 1711 that enables a desired (e.g., optimal) operating frequency (e.g., instructions per cycle) for the servers 1711 to be maintained that is associated with acceptable performance while minimizing or otherwise reducing power dissipation of the servers 1711. In some examples, the CDU circuitry 1738 only controls a flow rate of the coolant exiting the CDU 1704. While the CDU circuitry 1738 can achieve a temperature for the servers 1711 that enables the desired operating frequency and reduce power dissipation to be maintained when the workloads and/or cooling demands for the servers 1711 are stable, the CDU circuitry 1738 can encounter more difficulty reacting to variance in the workloads and/or the cooling demands for the servers 1711.

To accommodate for dynamic workloads and/or cooling demands associated with the servers 1711, the respective servers 1711 include local temperature control circuitry 1740 (labelled as "PC," which is representative of "programmable circuitry," in FIG. 17). The local temperature control circuitry 1740 is communicatively coupled to the second actuators 1736 and one or more of the sensors 1732. For example, the local temperature control circuitry 1740 can be communicatively coupled to the sensors 1732 that measure a temperature of the respective server 1711 or portion thereof associated therewith. For example, when the servers 1711 include a mix of different components, such as GPUs, accelerators, CPUs, and/or XPUs, that separately receive coolant flow from a portion of the flowline associated therewith (e.g., coolant flow that is separately controlled by respective ones of the second actuators 1736), respective ones of the local temperature circuitry 1740 can be associated with the respective components of the server 1711. That is, the local temperature control circuitry 1740 can control the coolant flow to the server 1711 on a socket-by-socket basis as different portions of the servers 1711 can be associated with different sockets. Additionally, the local temperature control circuitry 1740 can be communicatively coupled to the sensors 1732 that measure coolant parameters (e.g., temperature, pressure, flow rate, etc.) to be encountered by the respective server 1711 or portion thereof (e.g., socket-level component of the server 1711). The local temperature control circuitry 1740 of FIG. 17 may be instantiated (e.g., creating an instance of, bring into being for any length of time, materialize, implement, etc.) by programmable circuitry such as a Central Processor Unit (CPU) executing first instructions. Additionally or alternatively, the local temperature control circuitry 1740 of FIG. 17 may be instantiated (e.g., creating an instance of, bring into being for any length of time, materialize, implement, etc.) by (i) an Application Specific Integrated Circuit (ASIC) and/or (ii) a Field Programmable Gate Array (FPGA) structured and/or configured in response to execution of second instructions to perform operations corresponding to the first instructions. It should be understood that some or all of the local temperature control circuitry 1740 of FIG. 17 may, thus, be instantiated at the same or different times. Some or all of the local temperature control circuitry 1740 of FIG. 17 may be instantiated, for example, in one or more threads executing concurrently on hardware and/or in series on hardware. Moreover, in some examples, some or all of the local temperature control circuitry 1740 of FIG. 17 may be implemented by microprocessor circuitry executing instructions and/or FPGA circuitry performing operations to implement one or more virtual machines and/or containers.

In the illustrated example of FIG. 17, the local temperature control circuitry 1740 controls local coolant flow delivered to the cold plate that is thermally coupled to the respective server 1711 or portion thereof associated therewith based on a temperature of the server 1711 or portion thereof and a target temperature for a workload for the server 1711 or portion thereof (e.g., a workload being or to be performed by the server 1711 or portion thereof). Specifically, the local temperature control circuitry 1740 sets the target temperatures for the workloads associated with the servers 1711 or portions thereof to maximize or otherwise increase performance-per-watt (e.g., increase instructions per cycle per watt) and minimize or otherwise reduce power dissipation by the server 1711. The target temperatures determined by the CDU circuitry 1738 can differ from the target temperatures determined by the local temperature control circuitry 1740 as a result of the distance between the CDU 1704 and the servers 1711. Specifically, the target temperatures determined by the CDU 1704 are limited to average bulk flow parameter control, whereas the local temperature control circuitry 1740 determines target temperature for socket-level conditions identified in substantially real time. For example, the CDU circuitry 1738 can determine target temperatures based on an average of the target temperatures associated with all of the servers 1711 receiving coolant therefrom, and the target temperatures determined by the local temperature control circuitry 1740 correspond to temperatures for individual servers 1711 or portion thereof.

In the determination of the target temperature, the local temperature control circuitry 1740 accounts for increasing signal leakage with silicon temperature and an inverse temperature dependent voltage. Specifically, for a given workload, leakage continues to drop as a function of decreasing temperature. However, at lower temperatures, voltage has to be increased to maintain desired performance parameters for the server 1711. As such, the target temperature is typically below a maximum temperature at which the server 1711 or portion thereof can operate while meeting performance criteria as the maximum temperature results in increased power dissipation and, thus, inefficient power utilization that incurs greater costs to operate the servers 1711. The local temperature control circuitry 1740 determines the target temperature based on the workload and silicon characteristics associated with the respective server 1711 or portion thereof (e.g., part-to-part leakage variation). As a result, the local temperature control circuitry 1740 enables the servers 1711 to operate at a target (e.g., optimal) performance-per-watt condition.

As different ones of the servers 1711 or portions thereof in the same server housing 1706, 1708, can have different target temperatures for the same workload, can have different workload parameters, and/or can have different silicon characteristics, the CDU circuitry 1738 would have to perform excessive computations to enable the target temperatures to be obtained, and such excessive computations reduce a rate at which the target temperature can be achieved. As such, utilization of the CDU circuitry 1738 for such localized temperature control can increase power dissipation, thereby increasing operational costs, and reduce a performance of the servers 1711. Additionally, with dynamic workloads being performed by the servers 1711, the target temperature may again change by the time the CDU circuitry 1738 is able to determine and implement the changes associated with the target temperature such that the CDU circuitry 1738 is often behind schedule. Thus, utilization of the local temperature control circuitry 1740 at the servers 1711 can be advantageous over the CDU circuitry 1738. In some examples, the local temperature control circuitry 1740 in the respective servers 1711 handles all thermal control in the environment 1700 via the second actuators 1736 and, thus, enables the CDU circuitry 1738 to be dedicated to bulk fluid temperature control and other tasks, such as leak detection, as discussed in further detail below.

During operation, a first one of the local temperature control circuitry 1740 identifies a workload being performed by a first one of the servers 1711 or portion thereof that includes the first local temperature control circuitry 1740. In some examples, the first local temperature control circuitry 1740 determines whether sufficient historical temperature-performance data has been collected for the identified workload to enable the target temperature to be accurately determined. For example, the first local temperature control circuitry 1740 can identify a temperature associated with an identified minimum power dissipation for the workload. In some examples, the local temperature control circuitry 1740 controls the second actuator 1736 associated with the server 1711 or portion thereof to obtain predetermined temperatures at different times while performing a same workload. For example, the local temperature control circuitry 1740 can be programmed to cause the second actuator 1736 to obtain certain temperatures at the server 1711 or portion thereof at different times while performing a same workload. In such examples, the local temperature control circuitry 1740 identifies a temperature of the predetermined temperatures that resulted in a best performance (e.g., a highest instructions per cycle per watt, a lowest power dissipation while satisfying a threshold instructions per cycle) and labels the temperature as a target temperature for the server 1711 or portion thereof when performing the given workload.

In some examples, the local temperature control circuitry 1740 determines a power consumption for the respective second actuator 1736 to obtain a temperature. In some such examples, the local temperature control circuitry 1740 incorporates (e.g., adds) the determined power consumption for the respective second actuator 1736 into the power dissipation of the server 1711 or portion thereof to enable consideration of an overall power consumption at the temperature.

When the temperature-performance data does not include (i) the first historical temperature within the threshold range higher than the identified temperature or (ii) the second historical temperature within the threshold range lower than the identified temperature, the first local temperature control circuitry 1740 can determine that additional temperature-performance data is needed to ensure that the identified temperature corresponds to the target temperature for the identified workload. When additional temperature-performance data is needed, the first local temperature control circuitry 1740 determines a temperature for which performance data (e.g., power dissipation data, performance-per-watt data) is needed. For example, when the temperature-performance data does not include the first historical temperature within the threshold range higher than the identified temperature, the first local temperature control circuitry 1740 can cause the respective second actuator 1736 to implement a flow rate that corresponds with a temperature within the threshold range higher than the identified temperature. Additionally or alternatively, when the temperature-performance data does not include the second historical temperature within the threshold range lower than the identified temperature, the first local temperature control circuitry 1740 can cause the respective second actuator 1736 to implement a flow rate that corresponds with a temperature within the threshold range lower than the identified temperature. Accordingly, the first local temperature control circuitry 1740 can identify and store a performance of the server 1711 or portion (e.g., socket-level component) thereof associated with the implemented temperature. The first local temperature control circuitry 1740 can confirm that the identified temperature corresponds to the target temperature for the identified workload or adjust the identified temperature and potentially perform further temperature testing if the newly implemented temperature resulted in improved performance for the server 1711 or portion (e.g., socket-level component) thereof.

In some examples, the local temperature control circuitry 1740 empirically and dynamically calculates a relationship between workload performance and temperature targets under a fixed power budget to determine the target temperature for an identified workload for the respective server 1711 or portion (e.g., socket-level component) thereof associated therewith. For example, the local temperature control circuitry 1740 can calculate the relationship based on a workload being performed by the server 1711 or portion (e.g., socket-level component) thereof, a temperature of the server 1711 or portion (e.g., socket-level component) thereof, a workload performance (e.g., power dissipation, instructions per cycle per watt), and predetermined operating characteristics associated with the server (e.g., core voltage, core frequency, core capacitance). In some examples, the local temperature control circuitry 1740 updates the relationship in response to implementation of a target temperature resulting in a workload performance that does not satisfy a threshold (e.g., that is greater than a threshold power dissipation). In some examples, the local temperature control circuitry 1740 identifies the relationship based on historical data from another server or portion (e.g., socket-level component) thereof (e.g., another one of the servers 1711 or portion (e.g., socket-level component) thereof installed before the server 1711) having the same or similar operating characteristics and that had the same workload performance when operating at the same temperature for the same workload. In some examples, to reduce resource utilization at inopportune times, the local temperature control circuitry 1740 calculates the relationship for the respective servers 1711 or portion (e.g., socket-level component) thereof associated therewith when dynamic workloads are slow (e.g., when the workload is within a threshold range of an average workload for the server 1711 or portion (e.g., socket-level component) thereof).

In some examples, after identifying a temperature with a lowest power dissipation of the temperatures tested for the server 1711 or portion (e.g., socket-level component) thereof, the local temperature control circuitry 1740 determines whether sufficient data has been obtained on both sides of (e.g., above and below) the temperature. For example, the local temperature control circuitry 1740 can determine whether (i) a server operating at a first historical temperature within a threshold range (e.g., 5 degrees (°) Celsius (C), 10°C, etc.) higher than the identified temperature resulted in a higher power dissipation than when operating at the identified temperature. Additionally, the local temperature control circuitry 1740 can determine whether (ii) the server operating at a second historical temperature within the threshold range lower than the identified temperature resulted in a higher power dissipation than when operating at the identified temperature. When both conditions (i) and (ii) are satisfied, the first local temperature control circuitry 1740 determines that the identified temperature corresponds to the target temperature for the identified workload and additional temperature-performance data is not needed. Further, the first local temperature control circuitry 1740 can cause the respective second actuator 1736 associated with coolant flow in the portion of the server housing 1706, 1708 associated with the respective server 1711 or portion (e.g., socket-level component) thereof to implement a flow rate that corresponds with (e.g., will result in) the identified temperature.

In the illustrated example of FIG. 17, as the local temperature control circuitry 1740 determines the target temperature for the respective server 1711 or portion (e.g., socket-level component) thereof associated therewith based on factors specific to the server 1711 or portion (e.g., socket-level component) thereof (e.g., the workload being performed by the server 1711 or portion thereof, the performance of the server 1711 or portion thereof at different temperatures, operating characteristics associated with the server 1711 or portion thereof, etc.), a first target temperature for a first one of the servers 1711 or portion (e.g., socket-level component) thereof is independent of and distinct from a second target temperature for a second one of the servers 1711 and/or a second portion (e.g., a second socket-level component) of the first one of the servers 1711. In some examples, different ones of the local temperature control circuitry 1740 determine different target temperature for the different servers 1711 or portion (e.g., socket-level component) thereof associated therewith when the servers 1711 or portions thereof are performing the same workload as a result of operating characteristics associated with the server 1711 or portions thereof. Additionally, different ones of the local temperature control circuitry 1740 can determine the same target temperature for the different servers 1711 or portion (e.g., socket-level component) thereof when the servers 1711 or portions thereof are performing different workloads.

In some examples, as the respective second actuators 1736 that deliver the coolant to respective portions of the server housing 1706 are positioned upstream and downstream of one another, different ones of the local temperature control circuitry 1740 cause different movements to be performed by the respective second actuators 1736 associated therewith to obtain the same flow rate for the coolant and, in turn, the same temperature at the different servers 1711 or different portions of the same server 1711. For example, a first coolant inlet of a first one of the first server conduits 1722 is positioned upstream of a second coolant inlet of a second one of the first server conduits 1722. A first one of the local temperature control circuitry 1740 can cause the second actuator 1736 associated therewith to perform a first movement to obtain a local flow rate of the coolant in the first one of the first server conduits 1722. In some such examples, a second one of the local temperature control circuitry 1740 causes the second actuator 1736 associated therewith to perform a second movement to obtain the same local flow rate in the second one of the second server conduits 1730.

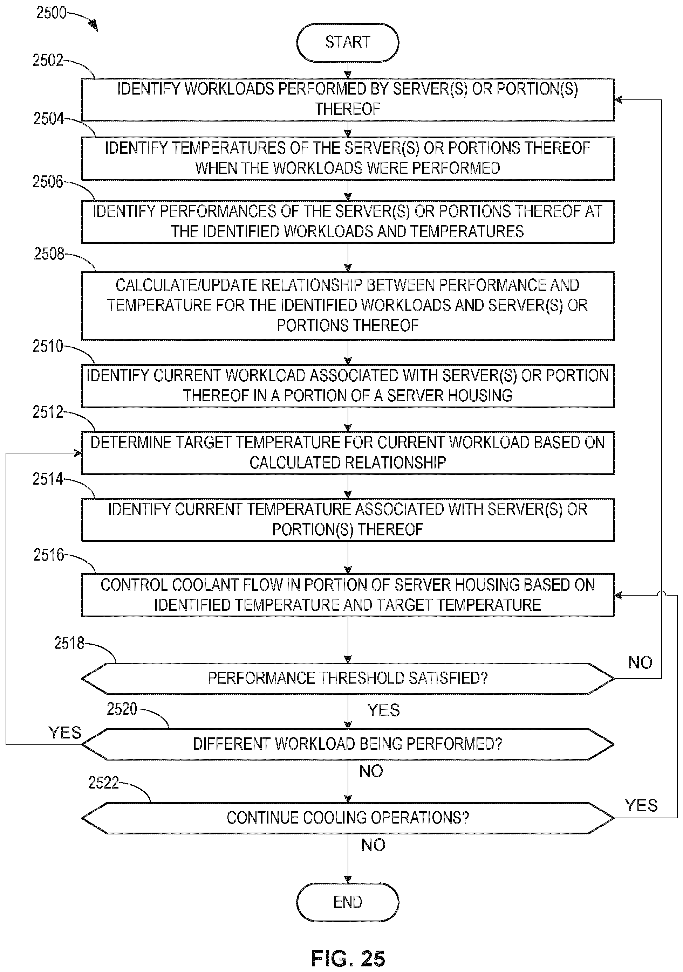

In some examples, the local temperature control circuitry 1740 adapts the control of the respective second actuators 1736 utilized to obtain the target temperature based on coolant parameters (e.g., temperature, pressure, flow rate, etc.) encountered by the respective second actuators 1736. Specifically, as dynamic adjustments to first ones of the second actuators 1736 that are fluidly coupled to the housing conduits 1718, 1720 and/or the first server conduits 1722 upstream of second ones of the second actuators 1736 can alter the coolant flow encountered and relayed by the second ones of the second actuators 1736, the local temperature control circuitry 1740 adjusts a movement or a position associated with the second ones of the second actuators 1736 to cause the coolant flow rate to the server 1711 or portion (e.g., socket-level component) thereof associated therewith to be maintained when the temperature of the server 1711 or portion thereof is to be maintained. In some examples, the respective local temperature control circuitry 1740 is communicatively coupled to one or more of the sensors 1732 that are positioned between (i) a first inlet of the first server conduit 1722 associated with the respective server 1711 or portion (e.g., socket-level component) thereof of which the respective local temperature control circuitry 1740 is a part and (ii) a second inlet of another one of the first server conduit 1722 that is closest to the first inlet in an upstream direction. As a result, the local temperature control circuitry 1740 can dynamically monitor the coolant parameters being encountered by the respective second actuator 1736 associated therewith. Thus, the local temperature control circuitry 1740 can cause an adjustment to a position and/or movement implemented by the respective actuator 1736 when necessary to maintain coolant flow parameters associated with the identified target temperature. Accordingly, the local temperature control circuitry 1740 can adjust the position and/or movement implemented by the respective second actuator 1736 when the coolant flow rate in a portion of the server housing 1706, 1708 associated therewith is to be maintained. In some examples, the local temperature control circuitry 1740 is instantiated by programmable circuitry executing instructions and/or configured to perform operations such as those represented by the flowchart(s) of FIGS. 24 and/or 25.

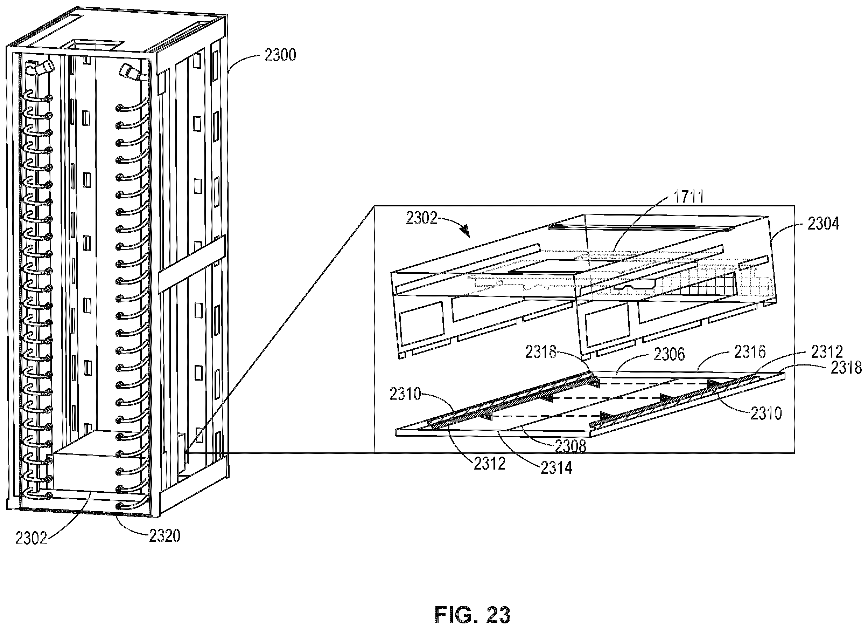

Additionally, in the illustrated example of FIG. 17, the servers 1711 and/or the CDU circuitry 1738 identifies leakage occurrences in the flowline 1702 and protects the servers 1711 in the server housings 1706, 1708 from damage as a result of the leakage. In some examples, the sensors 1732 include rope sensors 1732 (e.g., capacitive rope sensors, conductive rope sensors, optical fiber sensors, ultrasonic rope sensors, etc.) and/or leak sensors 1732. The rope sensors 1732 are operatively coupled to the flowline 1702 in different areas to monitor for leakage. In some examples, the sleds that hold the servers 1711 are inverted relative to known sled configurations, and the servers 1711 are positioned above the respective cold plates that are thermally coupled thereto, as discussed in further detail below in association with FIG. 23. In such examples, a bottom surface of the sled is defined by a bent sheet metal to which the leak sensors 1732 are coupled. Specifically, the bent sheet metal is configured to guide the coolant that leaks from the cold plate towards the leak sensors 1732. Alternatively, the bottom surface of the sled can be positioned at an angle (e.g., slanted) to guide the coolant that leaks from the cold plate towards one end of the surface where the leak sensors 1732 are positioned. In response to detecting a leakage, the respective sensor 1732 can transmit a signal indicative of the leakage occurrence to the CDU circuitry 1738. In some examples, the signal from the sensor 1732 includes a location of the detected leakage occurrence. In some examples, the servers 1711 and/or the CDU circuitry 1738 identify the location of the leakage based on a mapping of the sensors 1732 and an identifier of the respective sensor 1732 embedded in the signal indicative of the detected leakage.

After a leakage is detected, the server 1711 and/or the CDU circuitry 1738 trigger an alarm to notify an operator associated with the environment 1700. Further, the server 1711 and/or the CDU circuitry 1738 adjust a flow of the coolant in the flowline 1702 based on the location of the leakage to minimize or otherwise reduce damage that results from the leakage and/or a quantity of the servers affected by the leakage. For example, the server 1711 and/or the CDU circuitry 1738 can identify the actuator 1734, 1736 closest to the sensor 1732 in an upstream direction relative to the flowline 1702 and cause the identified actuator 1734, 1736 to prevent coolant from flowing past the identified actuator 1734, 1736 (e.g., cause the actuator 1734, 1736 to close an associated valve and/or stop an associated pump at a position that prevents flow therethrough). By cutting off the coolant flow to an area of the flowline 1702 where the coolant is leaking, the server 1711 and/or the CDU circuitry 1738 minimizes or otherwise reduces damage to the servers 1711 in the server housings 1706, 1708.

Additionally, the server 1711 and/or the CDU circuitry 1738 identify which of the servers 1711 may encounter the leakage. For example, the server 1711 and/or the CDU circuitry 1738 can determine that the leakage was detected in a first one of the first server conduits 1722 that carries coolant in a first portion of the first server housing 1706 in which one of the servers 1711 is positioned. The server 1711 and/or the CDU circuitry 1738 can shut down (e.g., stop power from being delivered to, block power from being supplied to) the potentially affected server 1711 to minimize or otherwise reduce damage encountered by the server 1711 as a result of the leakage. Further, the server 1711 and/or the CDU circuitry 1738 can enable the other servers 1711 that are in another portion of the server housing 1706 that is not affected by the leakage to continue operating.

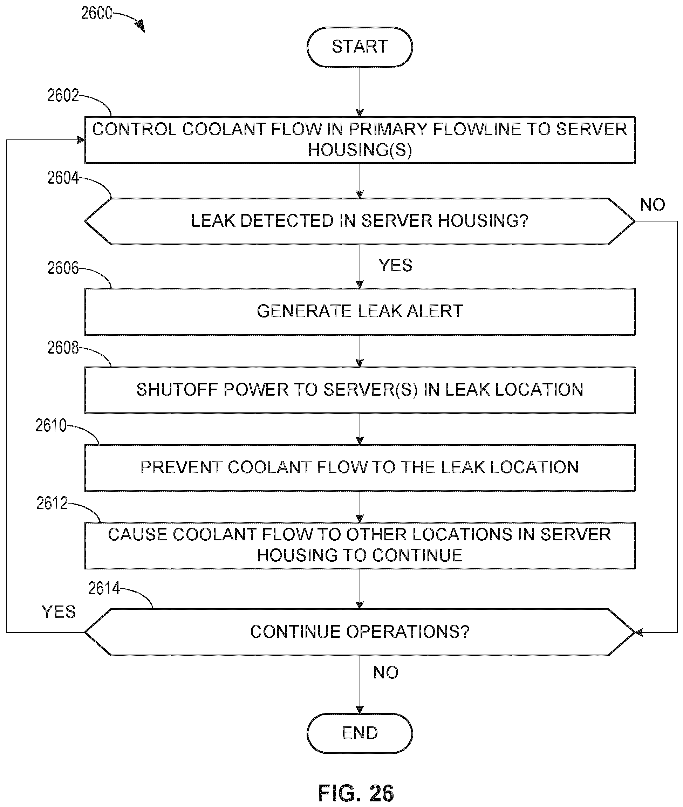

In some examples, the server 1711 and/or the CDU circuitry 1738 identify one or more of the servers 1711 that are not at risk of damage from the leak but are positioned in a portion of the server housing 1706 downstream of the second actuator 1736 utilized to block flow to the leakage location. In some such examples, the server 1711 and/or the CDU circuitry 1738 shut off or limit a workload capacity for the servers 1711 to prevent the servers 1711 from overheating while unable to receive coolant flow. Accordingly, the server 1711 and/or the CDU circuitry 1738 isolate the potentially affected server 1711 while enabling coolant flow and/or operations associated with the other servers 1711 to continue. In some examples, the servers 1711 and/or the CDU circuitry 1738 log a time and location of the detected leakage and/or the identified server 1711 affected by the leakage for analysis, repair, and/or troubleshooting. In some examples, the servers 1711 and/or the CDU circuitry 1738 are instantiated by programmable circuitry executing CDU instructions and/or configured to perform operations such as those represented by the flowchart of FIG. 26.

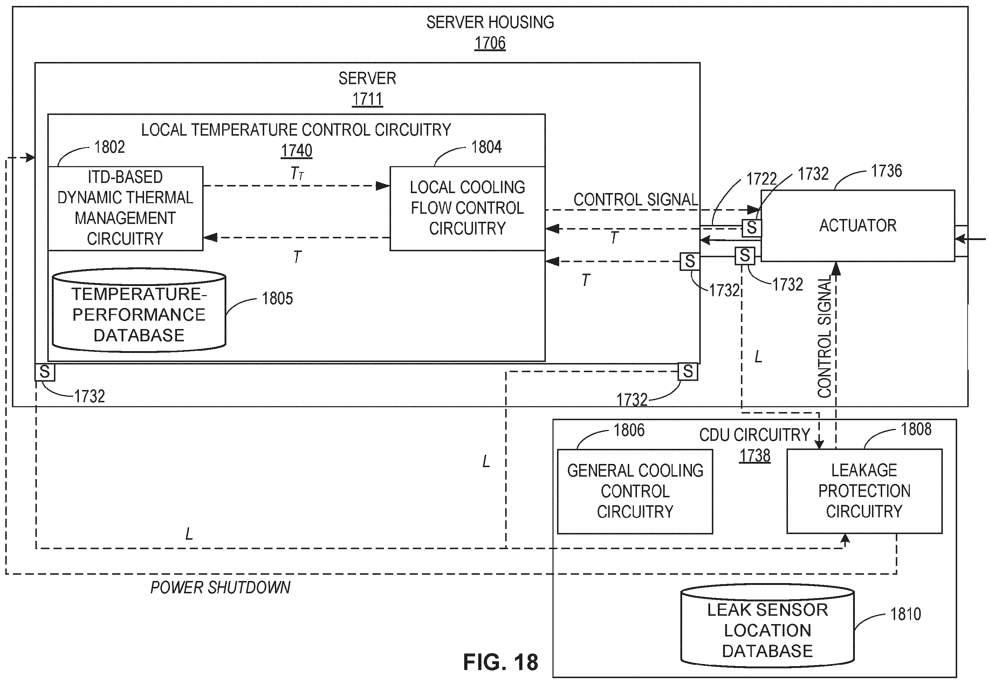

FIG. 18 is a block diagram of an example implementation of the CDU circuitry 1738 and a portion of the first server housing 1706. In the illustrated example of FIG. 18, the portion of the first server housing 1706 includes one of the servers 1711, one of the second actuators 1736 that controls coolant flow to the server 1711, and the local temperature control circuitry 1740 of the server 1711. The second actuator 1736 is operatively coupled to one of the first server conduits 1722 that delivers coolant to the portion of the first server housing 1706 in which the server 1711 or portion (e.g., socket-level component) thereof associated with the local temperature control circuitry 1740 is positioned. In some examples, the second actuator 1736 controls a flow rate of the fluid delivered to a cold plate thermally coupled to the server 1711 or portion (e.g., socket-level component) thereof. Accordingly, different cold plates can be thermally coupled to different portions (e.g., different socket-level components) of the same server 1711.

The inverse temperature dependent (ITD)-based dynamic thermal management circuitry 1802 and/or the local cooling flow control circuitry 1804 can identify the temperature of the server 1711 or portion (e.g., socket-level component) thereof via one or more of the sensors 1732 (e.g., one or more temperature sensors) that are thermally coupled to the server 1711 or portion thereof. In this example, the local cooling flow control circuitry 1804 relays the temperature from the sensor 1732 to the ITD-based dynamic thermal management circuitry 1802.

In the illustrated example of FIG. 18, the local temperature control circuitry 1740 includes example ITD-based dynamic thermal management circuitry 1802, example local cooling flow control circuitry 1804, and an example temperature-performance database 1805. The ITD-based dynamic thermal management circuitry 1802 determines a target temperature for the server 1711 or portion (e.g., socket-level component) thereof when performing a particular workload. In some examples, the ITD-based dynamic thermal management circuitry 1802 stores the target temperature and the workload associated therewith via the temperature performance database 1805 for reference when the workload (and/or a similar workload) is subsequently encountered.

In some examples, the ITD-based dynamic thermal management circuitry 1802 determines the target temperature based on part-specific parameters associated with the server 1711 or portion (e.g., socket-level component) thereof. For example, the part-specific parameters can include electronic power leakage characteristics, core voltage, core frequency, and/or core capacitance stored via the temperature-performance database 1805. In some examples, the ITD-based dynamic thermal management circuitry 1802 determines the target temperature based on performances (e.g., power dissipations, instructions per cycle per second) by the server 1711 or portion (e.g., socket-level component) thereof when encountering different temperatures while performing the same workload. In some examples, the ITD-based dynamic thermal management circuitry 1802 determines a relationship between power dissipation and temperature for the identified workload based on the part-specific parameters. For example, the relationship can be a power dissipation versus temperature plot for a given workload that is stored via the temperature-performance database 1805. In some examples, the relationship is predetermined prior to installation of the server 1711 in the server housing 1706 based on testing of the server 1711 or portion (e.g., socket-level component) thereof and/or temperature-performance data from another server. The relationship can be stored via the temperature-performance database 1805.

In some examples, the ITD-based dynamic thermal management circuitry 1802 generates the relationship between power dissipation and temperature through a dynamic calibration that is based on identified power dissipations at different temperatures. For example, the ITD-based dynamic thermal management circuitry 1802 can determine one or more temperatures for which performance data (e.g., power dissipation data) has not yet been obtained with the workload being performed by the server 1711 or portion (e.g., socket-level component) thereof. In some examples, the ITD-based dynamic thermal management circuitry 1802 identifies predetermined temperatures for which power dissipation data is to be obtained for the workload. For example, the predetermined temperatures can be stored in the temperature-performance database 1805. In some examples, the ITD-based dynamic thermal management circuitry 1802 communicates the different temperatures to the local cooling flow control circuitry 1804 at different times. In turn, the local cooling flow control circuitry 1804 can adjust the second actuator 1736 to obtain the different temperatures at the server 1711 or portion (e.g., socket-level component) thereof. In some examples, the ITD-based dynamic thermal management circuitry 1802 communicates a minimum temperature and a maximum temperature for which performance data is to be obtained to the local cooling flow control circuitry 1804. In turn, the local cooling flow control circuitry 1804 can cause the actuator 1736 to start at a maximum flow rate that results in the minimum temperature and incrementally adjust the flow rate to a minimum flow rate that results in the maximum temperature. The ITD-based dynamic thermal management circuitry 1802 identifies the performance (e.g., the power dissipation, the instructions per cycle per watt) of the server 1711 or portion (e.g., socket-level component) thereof when operating at the different temperatures with the same workload. As a result, the ITD-based dynamic thermal management circuitry 1802 can determine the target temperature for the workload based on the temperature that resulted in the best performance (e.g., the lowest power dissipation, the highest instructions per cycle per watt). The ITD-based dynamic thermal management circuitry 1802 can store the determined target temperature and the associated workload via the temperature-performance database 1805.

In some examples, instead of causing a predetermined set of temperatures to be obtained, the ITD-based dynamic thermal management circuitry 1802 determines the temperatures to be tested based on a dynamic analysis. For example, the ITD-based dynamic thermal management circuitry 1802 can identify a first performance (e.g., a first power dissipation, a first instructions per cycle per watt) of the server 1711 or portion (e.g., socket-level component) thereof for the given workload and a first temperature of the server 1711 or portion (e.g., socket-level component) thereof (e.g., a temperature of the server 1711 or portion thereof at the given instant) and store the same via the temperature-performance database 1805. Further, the ITD-based dynamic thermal management circuitry 1802 can determine a temperature increase or decrease to be implemented (e.g., a 3°C increase or decrease, a 5°C increase or decrease, etc.) to obtain a second temperature. The ITD-based dynamic thermal management circuitry 1802 transmits a signal indicative of the temperature to be obtained to the local cooling flow control circuitry 1804. The local cooling flow control circuitry 1804 transmits a control signal to the actuator 1736, which adjusts the coolant flow to the server 1711 or portion (e.g., socket-level component) thereof to obtain the temperature change. The ITD-based dynamic thermal management circuitry 1802 identifies a second performance (e.g., a second power dissipation, a second instructions per cycle per watt) of the server 1711 or portion (e.g., socket-level component) thereof for the workload at the second temperature and stores the second performance with the second temperature in the temperature-performance database 1805. In some examples, when the first performance is better than the second performance, the ITD-based dynamic thermal management circuitry 1802 determines that a subsequent temperature change is to occur in a direction opposite (e.g., decrease or increase opposite that of) the change from the first temperature to the second temperature. As such, the ITD-based dynamic thermal management circuitry 1802 can determine a third temperature to be obtained that is on a side of the first temperature (e.g., greater than or less than) opposite that of the second temperature. In some examples, the ITD-based dynamic thermal management circuitry 1802 sets a magnitude of the temperature change such that a temperature between the first temperature and second temperature need not be tested. In some examples, the ITD-based dynamic thermal management circuitry 1802 determines that the third temperature obtained is to be between the first temperature and the second temperature when a difference between the first temperature and the second temperature satisfies (e.g., is greater than, is greater than or equal to) a threshold difference (e.g., 5°C, 10°C, etc.).

When the ITD-based dynamic thermal management circuitry 1802 determines that the second temperature provides better performance than the first temperature, the ITD-based dynamic thermal management circuitry 1802 determines that a subsequent temperature change is to occur in a same direction as (e.g., increase or decrease similar to) the change from the first temperature to the second temperature. That is, when the temperature was increased from the first temperature to the second temperature, the ITD-based dynamic thermal management circuitry 1802 determines that another temperature increase is to be implemented to obtain a third temperature that is greater than the first temperature and the second temperature. Alternatively, when the temperature was decreased from the first temperature to the second temperature, the ITD-based dynamic thermal management circuitry 1802 determines that another temperature decrease is to be implemented to obtain a third temperature that is less than the first temperature and the second temperature. Accordingly, the ITD-based dynamic thermal management circuitry 1802 can transmit a signal indicative of the third temperature to the local cooling flow control circuitry 1804, which adjusts the second actuator 1736 to obtain the third temperature. The ITD-based dynamic thermal management circuitry 1802 identifies a third performance of the server 1711 or portion (e.g., socket-level component) thereof for the workload at the third temperature. In some examples, when the third performance is better than the second performance, the ITD-based dynamic thermal management circuitry 1802 continues to cause incremental temperature changes to occur in the same direction until a performance of the server 1711 or portion (e.g., socket-level component) thereof at a certain temperature is worse than a previous performance of the server 1711 or portion (e.g., socket-level component) thereof at a previous temperature (e.g., until the power dissipation is greater than the previous power dissipation, until the instructions per cycle per watt is less than the previous instructions per cycle per watt).

When the ITD-based dynamic thermal management circuitry 1802 determines that the second temperature provides better performance than the third temperature for the current workload, the ITD-based dynamic thermal management circuitry 1802 determines that the second temperature corresponds to a target temperature to pursue when the server 1711 or portion (e.g., socket-level component) thereof is performing the current workload. In some examples, the ITD-based dynamic thermal management circuitry 1802 reduces a magnitude of the adjustment to obtain a fourth temperature between the second temperature and the third temperature and/or between the second temperature and the first temperature. Further, the ITD-based dynamic thermal management circuitry 1802 can determine whether the fourth temperature resulted in a better performance than the third temperature. In this dynamic analysis, the ITD-based dynamic thermal management circuitry 1802 can continue to adjust the temperature of the server 1711 or portion (e.g., socket-level component) thereof until a target temperature is identified for which (i) another temperature that is within a threshold (e.g., 3°C, 5°C) greater than the target temperature resulted in a worse performance than a performance associated with the target temperature and (ii) another temperature that is within the threshold less than the target temperature resulted in a worse performance than the performance associated with the target temperature.

To adjust the temperature of the server 1711 or portion (e.g., socket-level component) thereof, the local cooling flow control circuitry 1804 transmits a control signal to the second actuator 1736. In some examples, the local cooling flow control circuitry 1804 determines a parameter (e.g., a voltage, a current, a frequency, etc.) of the control signal based on a direction (e.g., increase or decrease) and a magnitude of the change from the instant temperature of the server 1711 or portion (e.g., socket-level component) thereof measured by the sensor(s) 1732 to the temperature being targeted. In some examples, the local cooling flow control circuitry 1804 determines the control signal to be transmitted to the second actuator 1736 based on temperature, pressure, and/or flow rate measurements of the coolant entering the portion of the server housing 1706 in which the server 1711 or portion (e.g., socket-level component) thereof is positioned (e.g., the temperature, pressure, and/or flow rate at the actuator 1736 associated with the server 1711 or socket-level component thereof).

In the illustrated example of FIG. 18, the CDU circuitry 1738 includes general cooling control circuitry 1806 and leakage protection circuitry 1808. In some examples, the leakage protection circuitry 1808 is implemented by the server 1711 in addition to or instead of the CDU circuitry 1738. For example, the leakage protection circuitry 1808 can be instantiated by the local temperature control circuitry 1740.

In the illustrated example of FIG. 18, the general cooling control circuitry 1806 controls the first actuators 1734 to control a flow rate of the coolant to the server housings 1706, 1708. For example, the general cooling control circuitry 1806 can control the flow rate of the coolant to the server housings 1706 based on an average temperature and/or workload of the servers 1711 therein.

In the illustrated example of FIG. 18, the leakage protection circuitry 1808 monitors for coolant leaks in the flowline 1702 and minimizes or otherwise reduces damage that result therefrom and operations affected by the leak occurrence. In the illustrated example of FIG. 18, the leakage protection circuitry 1808 is communicatively coupled to the leak sensor 1732 coupled to the server conduit 1722 that delivers coolant to the portion of the server housing 1706 in which the server 1711 is positioned. Additionally, the leakage protection circuitry 1808 is communicatively coupled to the leak sensors 1732 positioned in the sled that holds the server 1711. When a leak occurs, the leak sensors 1732 can transmit a signal indicative of a detected leak to the leakage protection circuitry 1808. The leakage protection circuitry 1808 can determine a location of the leak based on the leak sensor 1732 from which the signal was received. For example, the signal can include an identifier associated with the sensor 1732, and the leakage protection circuitry 1808 can map the identifier to a stored location associated therewith via an example leak sensor location database 1810. For example, the leak sensor location database 1810 can include a mapping of the identifiers of the leak sensors 1732 implemented in the environment 1700 of FIG. 17. In some examples, the leak sensor location database 1810 includes one or more of the servers 1711 and/or one or more of the second actuators 1736 associated with the respective leak sensor 1732. In some examples, when the server 1711 includes the leakage protection circuitry 1808, the server 1711 also includes the leak sensor location database 1810.

In response the leak being detected, the leakage protection circuitry 1808 causes coolant flow to the portion of the server housing 1706 in which the server 1711 is positioned to be blocked. For example, the leakage protection circuitry 1808 can transmit a control signal to the second actuator 1736 to cause the second actuator 1736 to block coolant from flowing past the second actuator 1736 into the portion of the server housing 1706. In some examples, the leakage protection circuitry 1808 transmits a signal to the local cooling flow control circuitry 1804 to cause the second actuator 1736 to prevent coolant from flowing into the portion of the server housing 1706.

In the illustrated example of FIG. 18, after the leak is detected, the leakage protection circuitry 1808 stops power from being delivered to the server 1711 (e.g., shuts down the server 1711) in the portion of the server housing 1706 to minimize or otherwise reduce damage that the server 1711 encounters from coolant contact. Additionally, the leakage protection circuitry 1808 renders a leak alert to prompt an operator to address the leak. The leakage protection circuitry 1808 can indicate the location of the leak in the alert to enable the operator to focus on the identified portion of the server housing 1706.

While blocking the coolant from flowing to the portion of the server housing 1706 associated with the detected leak, the CDU circuitry 1738 enables coolant to flow to other portions of the server housing 1706 unaffected by the leak to minimize or otherwise reduce server operations affected by a local leak. That is, the CDU circuitry 1738 isolates the affected portion of the server housing 1706 while enabling other operations to remain uninterrupted. The isolated leak response by the CDU circuitry 1738 is advantageous to previously utilized leak responses, which shut down the servers 1711 in the entire server housing 1706 when a leak is detected.

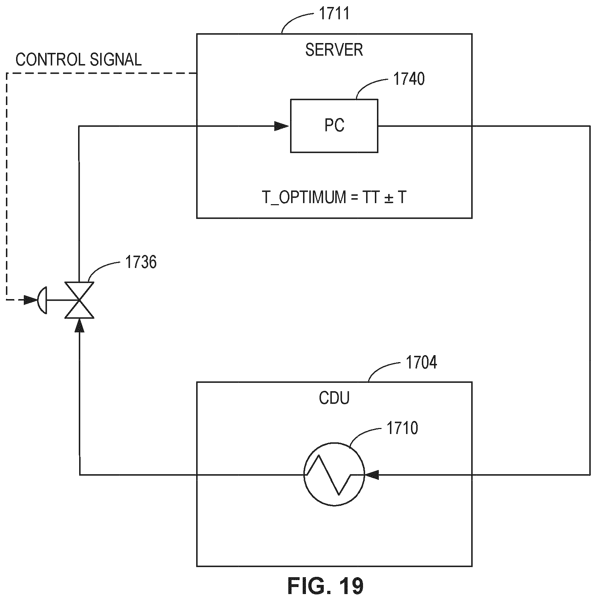

FIG. 19 is schematic representation of coolant flow control for local temperature management in accordance with teachings disclosed herein. In the illustrated example of FIG. 19, coolant circulates in the flowline 1702 between the CDU 1704 and the portion of the server housing 1706 (FIGS. 17 and 18) in which the server 1711 is positioned. The CDU 1704 includes the heat exchanger 1710 to cool the coolant after the coolant has absorbed heat from the server 1711. The server 1711 includes the local temperature control circuitry 1740, which determines a target temperature for the server 1711 or portion (e.g., socket-level component) thereof and transmits a control signal to the second actuator 1736 to adjust the coolant flow to obtain the target temperature. The target temperature as discussed herein can include a specific temperature plus or minus a threshold range (e.g., plus or minus 1°C, plus or minus 2°C).

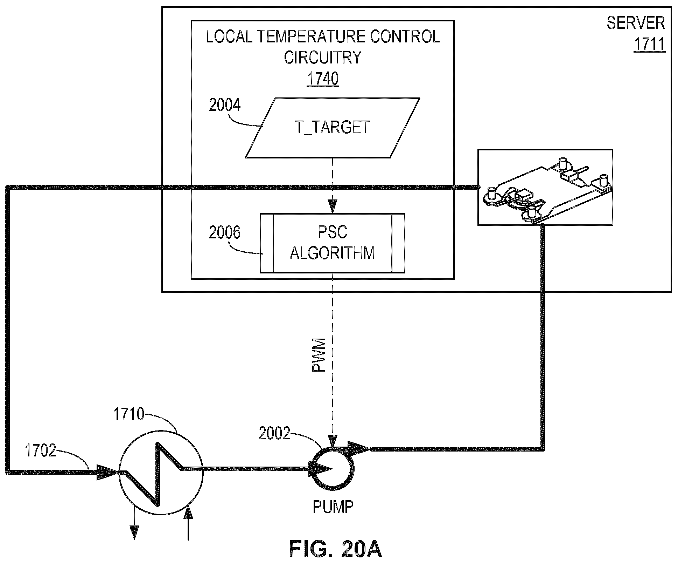

FIG. 20A is a simplified schematic representation of example coolant flow control for local temperature management in which the second actuator 1736 is implemented by a pump 2002. In this simplified example, the flowline 1702 transports coolant between the heat exchanger 1710 of the CDU 1704 (FIGS. 17 and 18), the pump 2002, and the server 1711. The local temperature control circuitry 1740 (e.g., the ITD-based dynamic thermal management circuitry 1802 of FIG. 18) determines a target temperature 2004 at which the server 1711 or portion (e.g., socket-level component) thereof is to operate while performing an identified workload. The local temperature control circuitry 1740 (e.g., the local cooling flow control circuitry 1804 of FIG. 18) inputs the target temperature into a pump speed control (PSC) algorithm 2006, which identifies a pulse width modulation (PWM) signal (e.g., a control signal) that will cause the pump 2002 to deliver coolant to the server 1711 or portion (e.g., socket-level component) thereof at a rate that will obtain the target temperature 2004 at the server 1711. Accordingly, the local temperature control circuitry 1740 transmits the PWM signal to the pump 2002 to obtain the target temperature at the server 1711 or portion (e.g., socket-level component) thereof. The local temperature control circuitry 1740 redetermines the target temperature 2004 and the PWM signal in response to a workload being performed by the server 1711 or portion (e.g., socket-level component) thereof changing.

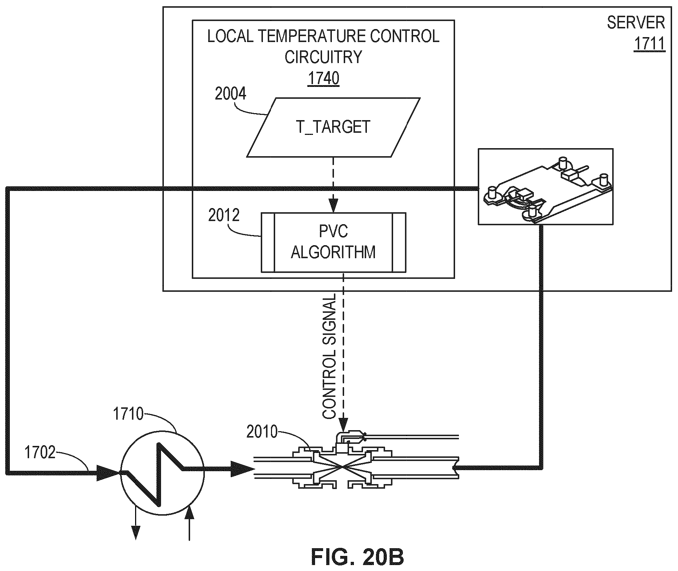

FIG. 20B is another simplified schematic representation of example coolant flow control for local temperature management in which the second actuator 1736 of FIGS. 17-19 is implemented by a valve 2010 (e.g., a proportional valve, a pneumatic pinch valve). In this example, the flowline 1702 transports coolant between the heat exchanger 1710 of the CDU 1704, the valve 2010, and the server 1711. The local temperature control circuitry 1740 (e.g., the ITD-based dynamic thermal management circuitry 1802) determines the target temperature 2004 at which the server 1711 or portion (e.g., socket-level component) thereof is to operate while performing an identified workload. The local temperature control circuitry 1740 (e.g., the local cooling flow control circuitry 1804) inputs the target temperature into a proportional valve control (PVC) algorithm 2012, which identifies a control signal that will cause actuation of the valve 2010 to a position that delivers coolant to the server 1711 or portion (e.g., socket-level component) thereof at a rate that will obtain the target temperature 2004 at the server 1711 or portion (e.g., socket-level component) thereof. Accordingly, the local temperature control circuitry 1740 transmits the control signal to the valve 2010 (e.g., the valve actuator) to obtain the target temperature at the server 1711 or portion (e.g., socket-level component) thereof. The local temperature control circuitry 1740 redetermines the target temperature 2004 and the corresponding control signal in response to a workload being performed by the server 1711 or portion (e.g., socket-level component) thereof changing.

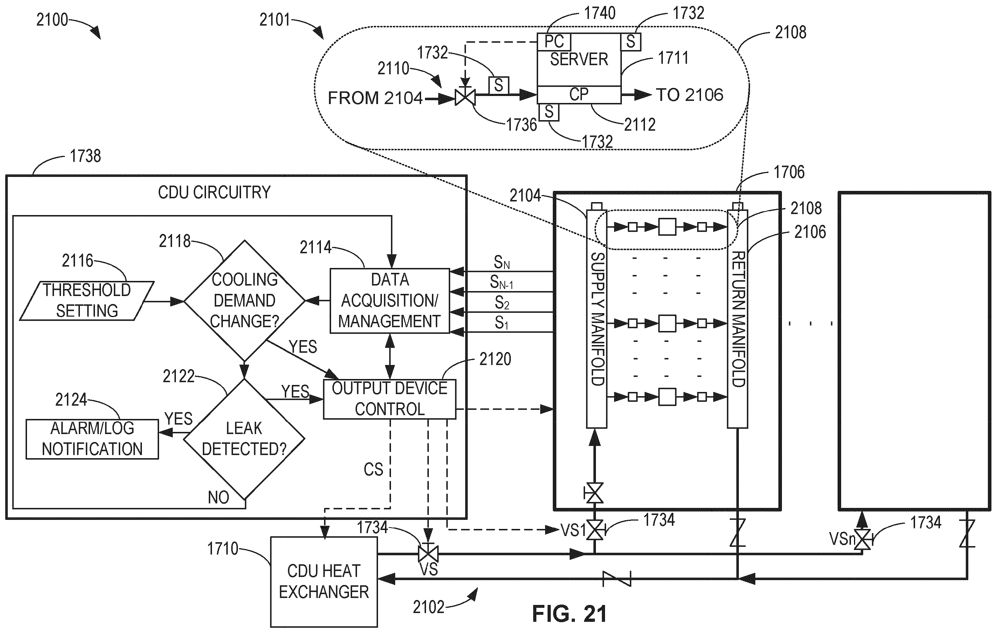

FIG. 21 is a block diagram of another example environment 2100 (e.g., one or more of the central data centers 102, one or more of the edge data centers 106, one or more of the buildings 110, one or more of the CDN data centers 116 of FIG. 1) including a liquid cooling system 2101 in which examples disclosed herein can be implemented. The example environment 2100 of FIG. 21 is similar to the environment 1700 of FIG. 17. However, the environment 2100 includes a flowline 2102 that differs from the flowline 1702 of FIG. 17 within the server housings 1706, 1708. Specifically, the flowline 2102 of FIG. 21 includes a supply manifold 2104 on one side of the sleds inside the server housings 1706, 1708 and a return manifold 2106 on an opposite side of the sleds. As such, the coolant flows from the heat exchanger 1710, to the supply manifold 2104, through the respective portions of the server housings 1706, 1708 in which the servers 1711 are positioned (e.g., through the respective sleds), to the return manifold 2106, and back to the heat exchanger 1710.

The illustrated example of FIG. 21 includes a magnified view of a portion 2108 of the server housing 1706. For example, the portion 2108 of the server housing 1706 can correspond to a sled in which one of the servers 1711 is positioned. The portion 2108 of the server housing 1706 includes a portion 2110 of the flowline 2102 (e.g., one of the server conduits 1722 of FIG. 17) in which the coolant flows from the supply manifold 2104, to the second actuator 1736, and across (e.g., through, against, etc.) a cold plate 2112 thermally coupled to the server 1711 or portion (e.g., socket-level component) thereof, and then to the return manifold 2106. Additionally, the portion 2108 of the server housing 1706 includes the sensors 1732 operatively coupled to the flowline 1702 and/or the server 1711. As discussed above, the local temperature control circuitry 1740 of the server 1711 or portion (e.g., socket-level component) thereof determines a target temperature for the server 1711 or portion (e.g., socket-level component) thereof based on a workload associated therewith. Further, the local temperature control circuitry 1740 controls the actuator 1736 based on a temperature of the server 1711 or portion (e.g., socket-level component) thereof and the target temperature. As such, the local temperature control circuitry 1740 enables localized temperature adjustments for the server 1711 or portion (e.g., socket-level component) thereof that dynamically correspond with the workload for the server 1711 or portion (e.g., socket-level component) thereof and that can be optimized to fit material characteristics of the server 1711 or portion (e.g., socket-level component) thereof both of which can vary between servers 1711 in the server housing 1706 and/or within the server 1711.

In the illustrated example of FIG. 21, the CDU circuitry 1738 performs data acquisition/management 2114 in which the CDU circuitry 1738 obtains server workload data and/or coolant parameter data from the sensors 1732 positioned in the server housings 1706, 1708 and/or coupled to the flowline 2102. The CDU circuitry 1738 determines an operating temperature threshold 2116 for the server housing 1706 based on a workload for the servers 1711 in the server housing 1706 and/or a service-level agreement (SLA) or a service level objective (SLO) associated with the servers 1711. For example, the SLA/SLO can indicate a temperature at which the compute resources are to be maintained to facilitate performance of the workloads. Further, the CDU circuitry 1738 determines whether a cooling demand change is to be implemented 2118 in the server housing 1706 based on the determined operating temperature threshold and the workload and/or coolant parameter data. When there is a cooling demand change to be implemented, the CDU circuitry 1738 causes an output device control 2120 to implement the determined cooling change. For example, the output device control 2120 can cause the first actuators 1734 to adjust the coolant flow to the server housings 1706, 1708 and/or adjust the temperature of the coolant via the CDU heat exchanger 1710.

In the illustrated example of FIG. 21, regardless of whether there is a cooling demand change, the CDU circuitry 1738 determines whether a leak has been detected 2122 based on leak sensor data obtained in the data acquisition/management operation 2114. When the CDU circuitry 1738 determines that a leak has been detected, the CDU circuitry 1738 triggers an alarm/log notification 2124 that indicates to an operator associated with the environment 2100 that the leak has been detected and logged. In some examples, the alarm/log notification 2124 indicates a location of the sensor 1732 that detected the leak to guide the operator to the occurrence. Additionally, when the CDU circuitry 1738 determines that a leak has been detected, the CDU circuitry 1738 causes the output device control 2120 to implement a remediating action. For example, the output device control 2120 can cause one of the second actuators 1736 that control a flow rate of the coolant to a sled where the leak was detected to prevent coolant from entering the sled. In some examples, the CDU circuitry 1738 communicates with the local temperature control circuitry 1740 to enable adjustments to the second actuator 1736 after the leak is detected. Regardless of whether a leak has been detected, the CDU circuitry 1738 returns to the data acquisition/management 2114.

FIG. 22 is a block diagram of another example environment 2200 (e.g., one or more of the central data centers 102, one or more of the edge data centers 106, one or more of the buildings 110, one or more of the CDN data centers 116 of FIG. 1) including a liquid cooling system 2201 in which examples disclosed herein can be implemented. The example environment 2200 of FIG. 22 includes the servers 1711 positioned in another server housing 2202 to facilitate cooling of the servers 1711. In this example, the server housing 2202 of FIG. 22 is an immersion cooling tank 2202. Accordingly, coolant in the environment 2200 is a dielectric fluid in which the servers 1711 are immersed as opposed to the conductive fluid of the environments 1700, 2100 of FIGS. 17 and 21 that cool the servers 1711 indirectly through cold plates.

In the illustrated example of FIG. 22, a flowline 2204 that carries the coolant to the servers 1711 in the immersion tank 2202 and the CDU heat exchanger 1710 enables targeted flow to the respective servers 1711 or portions (e.g., socket-level components) thereof in the immersion tank 2202 for socket-level temperature control. For example, the immersion tank 2202 can include and/or correspond to example immersion tank structures disclosed in U.S. Patent Application No. 18/428,991. Although the illustrated example of FIG. 22 only depicts one immersion tank 2202, it should be understood that the environment 220 can include more than one of the immersion tank 2202 coupled to the flowline 2204 in parallel similar to the server housings 1706, 1708 of FIG. 17.

In the illustrated example of FIG. 22, the environment 2200 includes the sensors 1732 positioned in the immersion tank 2202 and coupled to the flowline 2204, the first actuators 1734 that control the flow rate of the coolant from CDU heat exchanger 1710 to the immersion tank 2202, and the second actuators 1736 that control the flow rate of the coolant to one of the respective servers 1711 or respective portions (e.g., respective socket-level components) thereof in the immersion tank 2202. For example, the first actuators 1734 can control the flow rate of the coolant in a first portion 2206 of the flowline 2204 that delivers the coolant to a first portion of the immersion tank 2202 that enables the coolant to exchange thermal energy with various servers. Further, the second actuators 1736 can control the flow rate of the coolant in a second portion 2208 of the flowline 2204, which is distinct from the first portion 2206, that delivers the coolant to a second portion of the immersion tank 2202 in which the coolant exchanges thermal energy with a particular one of the servers 1711 or a particular portion (e.g., a particular socket-level component) of the server 1711. For example, the second portion 2208 of the flowline 2204 can include a duct in the immersion tank 2202 in which one or more of the servers 1711 or portion (e.g., socket-level component) thereof are positioned to receive coolant flow controlled by the second actuator 1736. In some examples, the flowline 2204 only includes respective ones of the second portion 2208 of the flowline 2204 for the servers 1711 in the immersion tank 2202 (e.g., the flowline 2204 does not include the first portion 2206).

In the illustrated example of FIG. 22, the servers 1711 include the local temperature control circuitry 1740, which are communicatively coupled to the sensors 1732 and the second actuators 1736. As discussed above, the local temperature control circuitry 1740 of the server 1711 determines a target temperature for the server 1711 or portion (e.g., socket-level component) thereof based on a workload associated therewith. Further, the local temperature control circuitry 1740 controls the actuator 1736 based on a temperature of the server 1711 or portion (e.g., socket-level component) thereof and the determined target temperature. As such, the local temperature control circuitry 1740 enables localized temperature adjustments for the server 1711 or portion (e.g., socket-level component) thereof that dynamically correspond with the workload for the server 1711 or portion (e.g., socket-level component) thereof and that can be optimized to fit material characteristics of the server 1711 or portion (e.g., socket-level component) thereof both of which can vary between servers 1711 in the immersion tank 2202 and/or between socket-level components of the servers 1711.

In the illustrated example of FIG. 22, the CDU circuitry 1738 performs the data acquisition/management 2114 in which the CDU circuitry 1738 obtains server workload data and/or coolant parameter data from the sensors 1732 positioned in the immersion tank 2202. The CDU circuitry 1738 determines the operating temperature threshold 2116 for the server housing 1706 based on a workload for the servers 1711 in the server housing 1706 and/or an SLA/SLO associated with the servers 1711. Further, the CDU circuitry 1738 determines whether the cooling demand change 2118 is desired based on the determined operating temperature threshold and the workload and/or coolant parameter data. When there is a cooling demand change, the CDU circuitry 1738 causes an output device control 2120 to implement the determined cooling change. For example, the output device control 2120 can cause the first actuators 1734 to adjust the coolant flow to the first portion of the immersion tank 2202 and/or adjust the temperature of the coolant via the CDU heat exchanger 1710. In some examples, the CDU circuitry 1738 triggers an alarm/log notification 2210 when the cooling demand changes.

FIG. 23 illustrates an example rack 2300 (e.g., the first server housing 1706, the second server housing 1708) that protects the servers 1711 from damage as a result of leakage. In the illustrated example of FIG. 23, the rack 2300 includes a sled 2302 in accordance with teachings disclosed herein. Although only one of the sled 2302 is pictured in the rack 2300 in FIG. 23, it should be understood that the rack 2300 is intended to include multiple of the sled 2302 stacked on top of each other.

In the illustrated example of FIG. 23, the sled 2302 includes an inverted chassis 2304 that positions the server 1711 above a cold plate (not shown) through or against which coolant flows to cool the server 1711. The cold plate and the server 1711 are positioned above a sheet 2306 (e.g., sheet metal). In some examples, the sheet 2306 includes a bend 2308 and leak sensors 2310 (e.g., a portion of the sensors 1732). The leak sensors 2310 are communicatively coupled to the server 1711 and/or the CDU circuitry 1738. The bend 2308 results in the surface of the sheet 2306 to be slanted to direct coolant that spills on the sheet 2306 to the leak sensors 2310. For example, when coolant leaks from the cold plate that cools the server 1711, the coolant falls onto the sheet 2306, and the bend 2308 guides the spilled coolant to a perimeter of the sheet 2306 where a leak flow path 2312 (e.g., a gutter) is defined. The leak sensors 2310 are positioned on the leak flow paths 2312 on opposite sides of the bend 2308. For example, the leak sensors 2310 can span along the leak flow paths 2312. Further, the leak flow path 2312 can include a certain depth and/or walls around a perimeter thereof to prevent the coolant from exiting the sled 2302 before the CDU circuitry 1738 and/or the local temperature control circuitry 1740 is able to detect the leak and cause the respective second actuator 1736 to block coolant from flowing to the sled 2302. As such, the sled 2302 enables a leak in the sled 2302 to be detected and isolated such that damage to the server 1711 on the sled 2302 is minimized or otherwise reduced and operations of the other servers 1711 on the rack can continue unhindered by the leak. In this example, the bend 2308 defines a peak in the sheet 2306 so that the leak flow path 2312 is in a direction away from the bend 2308. In other examples, the bend 2308 can be in the opposite direction to define a trough or gutter that collects spilled coolant. In such examples, the leak sensor(s) 2310 are located adjacent the bend 2308. In other examples, the sheet 2306 does not include a bend but is positioned at a slanted angle to direct spilled coolant to one side (e.g., gutter) of the sheet 2306 corresponding to the lowest point of the sheet 2306.

In the illustrated example of FIG. 23, the bend 2308 extends from a first edge 2314 to a second edge 2316 of the sheet 2306 opposite the first edge 2314. In some examples, the first edge 2314 is positioned higher than the second edge 2316 such that the sheet 2306 guides the spilled coolant to opposite ends of the second edge 2316 (e.g., corners 2318 of the sheet 2306 at the second edge 2316). In such examples, the leak sensors 2310 are positioned proximate the corners of the sheet 2306 to minimize or otherwise reduce a size and/or quantity of the leak sensors 2310 associated with the sled and, thus, costs associated therewith.

In the illustrated example of FIG. 23, the rack 2300 also includes one or more leak sensor(s) 2320 (e.g., another portion of the sensors 1732) positioned outside of the sled 2302. The leak sensors 2320 are communicatively coupled to the server 1711 and/or the CDU circuitry 1738. In some examples, the leak sensor(s) 2320 are positioned (i) between the supply manifold 2104 and an inner surface of the rack 2300, (ii) between the return manifold 2106 and an inner surface of the rack 2300, and/or (iii) below the manifolds 2104, 2106 and conduits 2322 extending therefrom (e.g., the first server conduits 1722 and second server conduits 1730 of FIG. 17). As such, coolant that leaks from the manifolds 2104, 2106 and/or the conduits 1722 contacts the leak sensors 2320 in advance of the leaked coolant pooling up at the bottom of the rack 2300 and damaging a low positioned sled (e.g., the sled 2302). Additionally, leak sensors (e.g., another portion of the sensors 1732, rope sensors) can be coupled to the manifolds 2104, 2106 and the conduits 2322 to detect a leak and/or rupture in the manifolds 2104, 2106 and/or the conduits 2322. Further, the CDU circuitry 1738 can determine a location of the leak based on a predetermined location associated with the respective sensor (e.g., the leak sensors 2310, the leak sensor(s) 2320, the leak sensors coupled to the manifolds 2104, 2106 and the conduits 2322) that detected the leak. Accordingly, the CDU circuitry 1738 can isolate remediating actions to an affected location to enable the servers 1711 unaffected by the leak to continue operating.

While an example manner of implementing the CDU circuitry 1738 of FIG. 17 is illustrated in FIGS. 17, 18, 21, and 22, one or more of the elements, processes, and/or devices illustrated in FIG. 18 may be combined, divided, re-arranged, omitted, eliminated, and/or implemented in any other way. Further, the general cooling control circuitry 1806, the leakage protection circuitry 1808, the leak sensor location database 1810, and/or, more generally, the example CDU circuitry 1738 of FIGS. 17, 18, 21, and/or 22, may be implemented by hardware alone or by hardware in combination with software and/or firmware. Thus, for example, any of the general cooling control circuitry 1806, the leakage protection circuitry 1808, the leak sensor location database 1810, and/or, more generally, the example CDU circuitry 1738, could be implemented by programmable circuitry in combination with machine readable instructions (e.g., firmware or software), processor circuitry, analog circuit(s), digital circuit(s), logic circuit(s), programmable processor(s), programmable microcontroller(s), graphics processing unit(s) (GPU(s)), digital signal processor(s) (DSP(s)), ASIC(s), programmable logic device(s) (PLD(s)), and/or field programmable logic device(s) (FPLD(s)) such as FPGAs. Further still, the example CDU circuitry 1738 of FIG. 18 may include one or more elements, processes, and/or devices in addition to, or instead of, those illustrated in FIG. 18, and/or may include more than one of any or all of the illustrated elements, processes and devices.

Additionally, while an example manner of implementing the local temperature control circuitry 1740 of FIGS. 17-22 is illustrated in FIG. 18, one or more of the elements, processes, and/or devices illustrated in FIG. 18 may be combined, divided, re-arranged, omitted, eliminated, and/or implemented in any other way. Further, the ITD-based dynamic thermal management circuitry 1802, the example local cooling flow control circuitry 1804, the example temperature-performance database 1805, and/or, more generally, the example local temperature control circuitry 1740 of FIG. 18, may be implemented by hardware alone or by hardware in combination with software and/or firmware. Thus, for example, any of the ITD-based dynamic thermal management circuitry 1802, the example local cooling flow control circuitry 1804, the example temperature-performance database 1805, and/or, more generally, the example local temperature control circuitry 1740, could be implemented by programmable circuitry in combination with machine readable instructions (e.g., firmware or software), processor circuitry, analog circuit(s), digital circuit(s), logic circuit(s), programmable processor(s), programmable microcontroller(s), graphics processing unit(s) (GPU(s)), digital signal processor(s) (DSP(s)), ASIC(s), programmable logic device(s) (PLD(s)), and/or field programmable logic device(s) (FPLD(s)) such as FPGAs. Further still, the example local temperature control circuitry 1740 of FIG. 18 may include one or more elements, processes, and/or devices in addition to, or instead of, those illustrated in FIG. 18, and/or may include more than one of any or all of the illustrated elements, processes and devices.

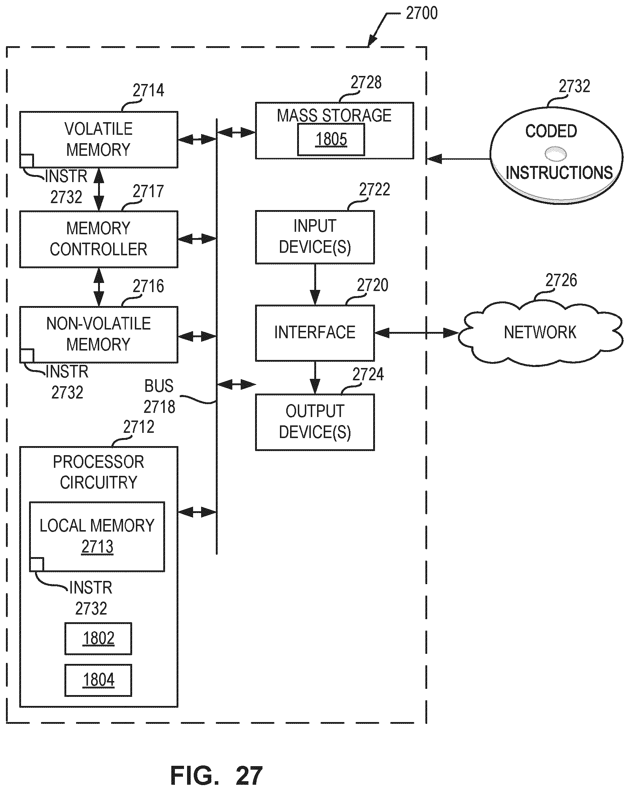

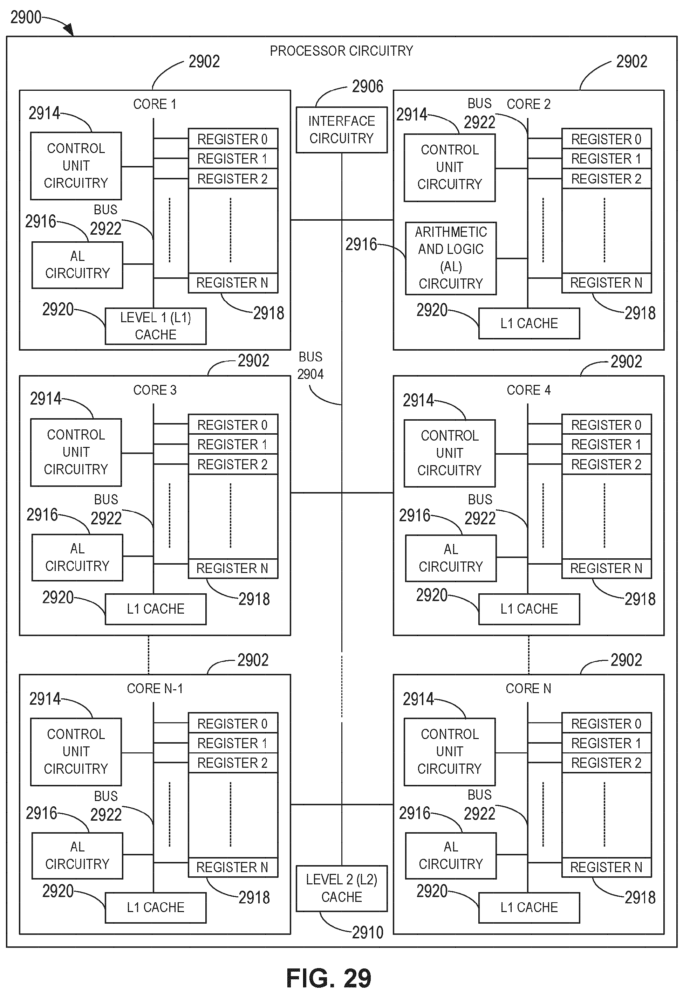

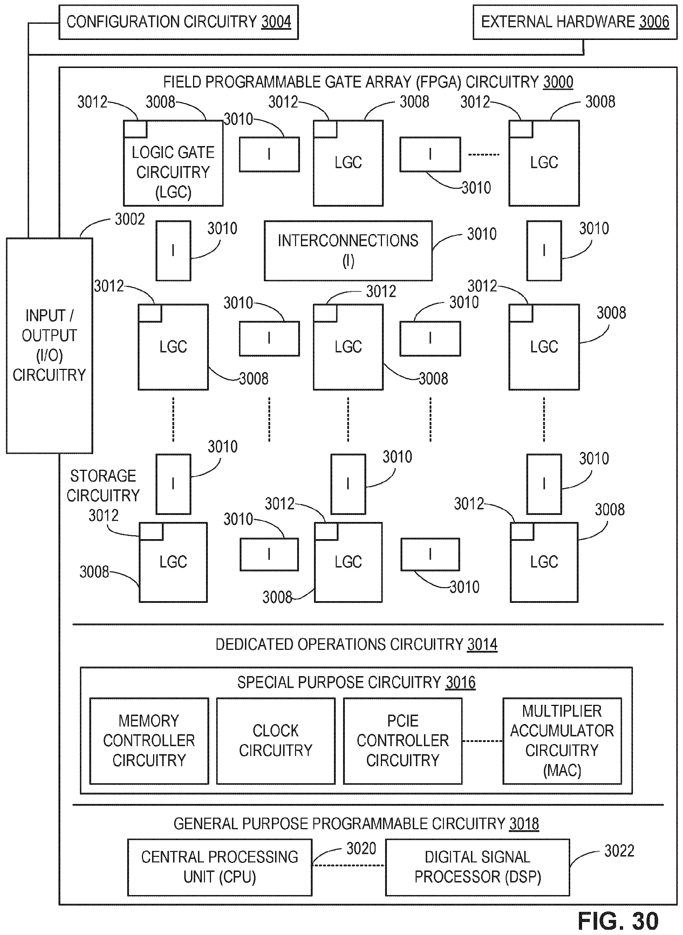

Flowcharts representative of example machine readable instructions, which may be executed by programmable circuitry to implement and/or instantiate the local temperature control circuitry 1740 of FIGS. 17-22 and/or representative of example operations which may be performed by programmable circuitry to implement and/or instantiate the local temperature control circuitry of FIGS. 17-22, are shown in FIGS. 24 and 25. The machine readable instructions may be one or more executable programs or portion(s) of one or more executable programs for execution by programmable circuitry such as the programmable circuitry 2712 shown in the example processor platform 2700 discussed below in connection with FIG. 27 and/or may be one or more function(s) or portion(s) of functions to be performed by the example programmable circuitry (e.g., an FPGA) discussed below in connection with FIGS. 29 and/or 30.

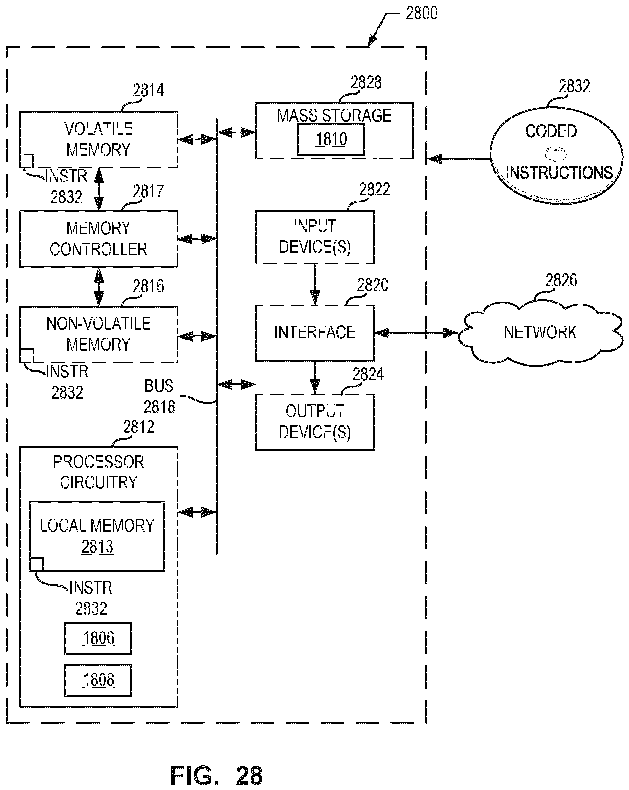

A flowchart representative of example machine readable instructions, which may be executed by programmable circuitry to implement and/or instantiate the CDU circuitry 1738 of FIGS. 17, 18, 21, and 22 and/or representative of example operations which may be performed by programmable circuitry to implement and/or instantiate the CDU circuitry 1738 of FIGS. 17, 18, 21, and 22, is shown in FIG. 26. The machine readable instructions may be one or more executable programs or portion(s) of one or more executable programs for execution by programmable circuitry such as the programmable circuitry 2812 shown in the example processor platform 2800 discussed below in connection with FIG. 28 and/or may be one or more function(s) or portion(s) of functions to be performed by the example programmable circuitry (e.g., an FPGA) discussed below in connection with FIGS. 29 and/or 30. In some examples, the machine readable instructions cause an operation, a task, etc., to be carried out and/or performed in an automated manner in the real world. As used herein, "automated" means without human involvement.

The program may be embodied in instructions (e.g., software and/or firmware) stored on one or more non-transitory computer readable and/or machine readable storage medium such as cache memory, a magnetic-storage device or disk (e.g., a floppy disk, a Hard Disk Drive (HDD), etc.), an optical-storage device or disk (e.g., a Blu-ray disk, a Compact Disk (CD), a Digital Versatile Disk (DVD), etc.), a Redundant Array of Independent Disks (RAID), a register, ROM, a solid-state drive (SSD), SSD memory, non-volatile memory (e.g., electrically erasable programmable read-only memory (EEPROM), flash memory, etc.), volatile memory (e.g., Random Access Memory (RAM) of any type, etc.), and/or any other storage device or storage disk. The instructions of the non-transitory computer readable and/or machine readable medium may program and/or be executed by programmable circuitry located in one or more hardware devices, but the entire program and/or parts thereof could alternatively be executed and/or instantiated by one or more hardware devices other than the programmable circuitry and/or embodied in dedicated hardware. The machine readable instructions may be distributed across multiple hardware devices and/or executed by two or more hardware devices (e.g., a server and a client hardware device). For example, the client hardware device may be implemented by an endpoint client hardware device (e.g., a hardware device associated with a human and/or machine user) or an intermediate client hardware device gateway (e.g., a radio access network (RAN)) that may facilitate communication between a server and an endpoint client hardware device. Similarly, the non-transitory computer readable storage medium may include one or more mediums. Further, although the example program is described with reference to the flowchart(s) illustrated in FIGS. 24-26, many other methods of implementing the example CDU circuitry 1738 and/or the local temperature control circuitry 1740 may alternatively be used. For example, the order of execution of the blocks of the flowchart(s) may be changed, and/or some of the blocks described may be changed, eliminated, or combined. Additionally or alternatively, any or all of the blocks of the flow chart may be implemented by one or more hardware circuits (e.g., processor circuitry, discrete and/or integrated analog and/or digital circuitry, an FPGA, an ASIC, a comparator, an operational-amplifier (op-amp), a logic circuit, etc.) structured to perform the corresponding operation without executing software or firmware. The programmable circuitry may be distributed in different network locations and/or local to one or more hardware devices (e.g., a single-core processor (e.g., a single core CPU), a multi-core processor (e.g., a multi-core CPU, an XPU, etc.)). For example, the programmable circuitry may be a CPU and/or an FPGA located in the same package (e.g., the same integrated circuit (IC) package or in two or more separate housings), one or more processors in a single machine, multiple processors distributed across multiple servers of a server rack, multiple processors distributed across one or more server racks, etc., and/or any combination(s) thereof.

The machine readable instructions described herein may be stored in one or more of a compressed format, an encrypted format, a fragmented format, a compiled format, an executable format, a packaged format, etc. Machine readable instructions as described herein may be stored as data (e.g., computer-readable data, machine-readable data, one or more bits (e.g., one or more computer-readable bits, one or more machine-readable bits, etc.), a bitstream (e.g., a computer-readable bitstream, a machine-readable bitstream, etc.), etc.) or a data structure (e.g., as portion(s) of instructions, code, representations of code, etc.) that may be utilized to create, manufacture, and/or produce machine executable instructions. For example, the machine readable instructions may be fragmented and stored on one or more storage devices, disks and/or computing devices (e.g., servers) located at the same or different locations of a network or collection of networks (e.g., in the cloud, in edge devices, etc.). The machine readable instructions may require one or more of installation, modification, adaptation, updating, combining, supplementing, configuring, decryption, decompression, unpacking, distribution, reassignment, compilation, etc., in order to make them directly readable, interpretable, and/or executable by a computing device and/or other machine. For example, the machine readable instructions may be stored in multiple parts, which are individually compressed, encrypted, and/or stored on separate computing devices, wherein the parts when decrypted, decompressed, and/or combined form a set of computer-executable and/or machine executable instructions that implement one or more functions and/or operations that may together form a program such as that described herein.

In another example, the machine readable instructions may be stored in a state in which they may be read by programmable circuitry, but require addition of a library (e.g., a dynamic link library (DLL)), a software development kit (SDK), an application programming interface (API), etc., in order to execute the machine-readable instructions on a particular computing device or other device. In another example, the machine readable instructions may need to be configured (e.g., settings stored, data input, network addresses recorded, etc.) before the machine readable instructions and/or the corresponding program(s) can be executed in whole or in part. Thus, machine readable, computer readable and/or machine readable media, as used herein, may include instructions and/or program(s) regardless of the particular format or state of the machine readable instructions and/or program(s).

The machine readable instructions described herein can be represented by any past, present, or future instruction language, scripting language, programming language, etc. For example, the machine readable instructions may be represented using any of the following languages: C, C++, Java, C#, Perl, Python, JavaScript, HyperText Markup Language (HTML), Structured Query Language (SQL), Swift, etc.

As mentioned above, the example operations of FIGS. 24-26 may be implemented using executable instructions (e.g., computer readable and/or machine readable instructions) stored on one or more non-transitory computer readable and/or machine readable media. As used herein, the terms non-transitory computer readable medium, non-transitory computer readable storage medium, non-transitory machine readable medium, and/or non-transitory machine readable storage medium are expressly defined to include any type of computer readable storage device and/or storage disk and to exclude propagating signals and to exclude transmission media. Examples of such non-transitory computer readable medium, non-transitory computer readable storage medium, non-transitory machine readable medium, and/or non-transitory machine readable storage medium include optical storage devices, magnetic storage devices, an HDD, a flash memory, a read-only memory (ROM), a CD, a DVD, a cache, a RAM of any type, a register, and/or any other storage device or storage disk in which information is stored for any duration (e.g., for extended time periods, permanently, for brief instances, for temporarily buffering, and/or for caching of the information). As used herein, the terms "non-transitory computer readable storage device" and "non-transitory machine readable storage device" are defined to include any physical (mechanical, magnetic and/or electrical) hardware to retain information for a time period, but to exclude propagating signals and to exclude transmission media. Examples of non-transitory computer readable storage devices and/ or non-transitory machine readable storage devices include random access memory of any type, read only memory of any type, solid state memory, flash memory, optical discs, magnetic disks, disk drives, and/or redundant array of independent disks (RAID) systems. As used herein, the term "device" refers to physical structure such as mechanical and/or electrical equipment, hardware, and/or circuitry that may or may not be configured by computer readable instructions, machine readable instructions, etc., and/or manufactured to execute computer-readable instructions, machine-readable instructions, etc.

FIG. 24 is a flowchart representative of example machine readable instructions and/or example operations 2400 that may be executed, instantiated, and/or performed by programmable circuitry to determine a target temperature for a server or portion (e.g., socket-level component) thereof in a portion of a server housing and locally control coolant flow in the portion of the server housing based on the determined target temperature. The example machine-readable instructions and/or the example operations 2400 of FIG. 24 begin at block 2402, at which the local temperature control circuitry 1740 identifies a workload being performed by the server 1711 or portion (e.g., socket-level component) thereof in a portion of the server housing. For example, the local temperature control circuitry 1740 can identify the workload being performed by the server 1711 or portion (e.g., socket-level component) thereof of which the local temperature control circuitry 1740 is a part.

At block 2404, the local temperature control circuitry 1740 determines whether sufficient historical temperature-performance data has been collected for the identified workload being performed by the server 1711 or portion (e.g., socket-level component) thereof. For example, the ITD-based dynamic thermal management circuitry 1802 can determine whether a target temperature has been associated with the workload in the temperature-performance database 1805. When sufficient historical temperature-performance data has been collected for the identified workload being performed by the server 1711 or portion (e.g., socket-level component) thereof, the operations 2400 proceed to block 2424. Otherwise, when sufficient historical temperature-performance data has not been collected for the identified workload being performed by the server 1711 or portion (e.g., socket-level component) thereof, the operations 2400 continue to block 2406.

At block 2406, the local temperature control circuitry 1740 identifies a first temperature of the server 1711 or portion (e.g., socket-level component) thereof. For example, the local cooling flow control circuitry 1804 can identify a temperature measurement by one or more of the sensors 1732 thermally coupled to the server 1711 or portion (e.g., socket-level component) thereof.

At block 2408, the local temperature control circuitry 1740 determines a performance of the server 1711 or portion (e.g., socket-level component) thereof at the first temperature. For example, the ITD-based dynamic thermal management circuitry 1802 can determine the power dissipation and/or the instructions per cycle per watt of the server 1711 or portion (e.g., socket-level component) thereof as the server 1711 or portion thereof performs the identified workload.

At block 2410, the local temperature control circuitry 1740 determines whether the identified workload is still being performed or is being performed again after switching from another workload. For example, the ITD-based dynamic thermal management circuitry 1802 can identify the workload being performed by the server 1711 or portion (e.g., socket-level component) thereof and determine whether the workload corresponds to the same workload for which the temperature-performance data has been partially gathered. When the identified workload is still being performed or is being performed again after switching from another workload, the operations proceed to block 2412. Otherwise, when the identified workload is no longer being performed, the operations 2400 return to block 2402. As such, the local temperature control circuitry 1740 can obtain a first portion of temperature-performance data utilized to determine the target temperature before the server 1711 or portion (e.g., socket-level component) thereof switches to a different workload (e.g., a second workload) and obtain a second portion of the temperature-performance data after the server 1711 or portion (e.g., socket-level component) thereof returns to the workload (e.g., switches back from the second workload or a third workload to the first workload).

At block 2412, the local temperature control circuitry 1740 adjusts coolant flow in the portion of the server housing 1706 associated with the server 1711 or portion (e.g., socket-level component) thereof. For example, the ITD-based dynamic thermal management circuitry 1802 can communicate a temperature adjustment to the local cooling flow control circuitry 1804. Further, the local cooling flow control circuitry 1804 can control the second actuator 1736 associated with the portion of the server housing 1706 to implement the temperature adjustment.

At block 2414, the local temperature control circuitry 1740 determines a performance of the server at a resulting temperature associated with the adjusted coolant flow. For example, the ITD-based dynamic thermal management circuitry 1802 can determine the power dissipation and/or the instructions per cycle per watt for the server 1711 or portion (e.g., socket-level component) thereof at the associated temperature.

At block 2416, the local temperature control circuitry 1740 determines whether other temperatures are to be tested. For example, the ITD-based dynamic thermal management circuitry 1802 can determine whether performance data for other temperatures is needed before a target temperature for the given workload can be determined. When other temperatures are to be tested, the operations 2400 returns to block 2410. Otherwise, when sufficient performance-temperature data has been collected for the workload, the operations proceed to block 2418.

At block 2418, the local temperature control circuitry 1740 identifies a target temperature for the workload. For example, the ITD-based dynamic thermal management circuitry 1802 can identify the target temperature for the workload based on a temperature at which the server 1711 or portion (e.g., socket-level component) thereof had the best performance while performing the workload. In some examples, the ITD-based dynamic thermal management circuitry 1802 determines the target temperature based on a temperature-performance relationship associated with the gathered temperature-performance data.

At block 2420, the local temperature control circuitry 1740 stores the target temperature for a future look up. For example, the ITD-based dynamic thermal management circuitry 1802 can store the target temperature for the workload via the temperature-performance database 1805.

At block 2422, the local temperature control circuitry 1740 determines whether the identified workload is still being performed or is being performed again after switching from another workload. For example, the ITD-based dynamic thermal management circuitry 1802 can identify the workload being performed by the server 1711 or portion (e.g., socket-level component) thereof and determine whether the workload corresponds to the same workload for which the temperature-performance data has been gathered. When the identified workload is being performed, the operations 2400 proceed to block 2424. Otherwise, when a different workload is being performed, the operations 2400 return to block 2402.

At block 2424, the local temperature control circuitry 1740 identifies a temperature of the server 1711 or portion (e.g., socket-level component) thereof. For example, the local cooling flow control circuitry 1804 can identify the temperature of the server 1711 or portion (e.g., socket-level component) thereof via one or more of the sensors 1732 thermally coupled to the server 1711 or portion (e.g., socket-level component) thereof.

At block 2426, the local temperature control circuitry 1740 determines a target temperature for the workload. For example, the ITD-based dynamic thermal management circuitry 1802 can determine the target temperature for the workload via the temperature-performance database 1805.

At block 2428, the local temperature control circuitry 1740 controls coolant flow in the portion of the server housing 1706 associated with the server 1711 or portion (e.g., socket-level component) thereof based on the identified temperature of the server 1711 and the determined target temperature for the server 1711 or portion (e.g., socket-level component) thereof at the given workload. For example, the ITD-based dynamic thermal management circuitry 1802 can communicate the target temperature and/or a temperature change to be obtained to the local cooling flow control circuitry 1804. The local cooling flow control circuitry 1804 can transmit a control signal to the actuator 1736 associated with the portion of the server housing 1706 to adjust the coolant flow to the portion of the server housing 1706 and, in turn, adjust the temperature of the server 1711 or portion (e.g., socket-level component) thereof.

At block 2430, the local temperature control circuitry 1740 determines whether a different workload is being performed. When a different workload is being performed, the operations 2400 return to block 2402. Otherwise, the operations 2400 proceed to block 2432.

At block 2432, the local temperature control circuitry 1740 determines whether local cooling operations are to continue. When cooling operations are to continue, the operations 2400 return to block 2438.

FIG. 25 is a flowchart representative of example machine readable instructions and/or example operations 2500 that may be executed, instantiated, and/or performed by programmable circuitry to determine a target temperature for a server or portion (e.g., socket-level component) thereof in a portion of a server housing and locally control coolant flow in the portion of the server housing based on the determined target temperature. The example machine-readable instructions and/or the example operations 2500 of FIG. 25 begin at block 2502, at which the local temperature control circuitry 1740 identifies workloads performed by the server 1711 or portion (e.g., socket-level component) thereof and/or one or more other servers or portions (e.g., socket-level components) thereof with similar part-specific parameters. In some examples, the ITD-based dynamic thermal management circuitry 1802 identifies the workloads via the temperature-performance database 1805.

At block 2504, the local temperature control circuitry 1740 identifies temperatures of the server 1711 or portion (e.g., socket-level component) thereof and/or the one or more other servers or portions (e.g., socket-level components) thereof with similar part-specific parameters when performing the workloads. In some examples, the ITD-based dynamic thermal management circuitry 1802 identifies the temperatures of the server 1711 or portion (e.g., socket-level component) thereof and/or the one or more other servers or portions (e.g., socket-level components) thereof with similar part-specific parameters when performing the workloads via the temperature-performance database 1805.

At block 2506, the local temperature control circuitry 1740 identifies performances (e.g., power dissipation, instructions per cycle per watt) of the server 1711 or portion (e.g., socket-level component) thereof and/or the one or more other servers or portions (e.g., socket-level components) thereof with similar part-specific parameters when performing the workloads while operating at the identified temperatures. In some examples, the ITD-based dynamic thermal management circuitry 1802 the performances of the server 1711 or portion (e.g., socket-level component) thereof and/or the one or more other servers or portions (e.g., socket-level components) thereof with similar part-specific parameters when performing the workloads while operating at the identified temperatures via the temperature-performance database 1805.

At block 2508, the local temperature control circuitry 1740 calculates and/or updates a relationship between performance and temperature for the identified workload and the server 1711 or portion (e.g., socket-level component) thereof and/or the one or more other servers or portions (e.g., socket-level components) thereof with similar part-specific parameters. For example, the ITD-based dynamic thermal management circuitry 1802 can generate a plot based on the performances of the server 1711 or portion (e.g., socket-level component) thereof and/or the one or more other servers or portions (e.g., socket-level components) thereof with similar part-specific parameters when performing the workloads while operating at the identified temperatures. In some examples, the ITD-based dynamic thermal management circuitry 1802 generates the relationship for a first workload based on temperature and performance data gathered for a second workload and a difference between the first workload and the second workload.

At block 2510, the local temperature control circuitry 1740 identifies a current workload associated with the server 1711 or portion (e.g., socket-level component) thereof in a portion of the server housing 1706. For example, the ITD-based dynamic thermal management circuitry 1802 can determine the current workload being performed by the server 1711 or portion (e.g., socket-level component) thereof of which the local temperature control circuitry 1740 is a part.

At block 2512, the local temperature control circuitry 1740 determines a target temperature for the current workload based on the calculated relationship between performance and temperature. For example, the ITD-based dynamic thermal management circuitry 1802 can determine the target temperature based on the calculated relationship between performance and temperature associated with the workload being performed.

At block 2514, the local temperature control circuitry 1740 identifies a temperature of the server 1711 or portion (e.g., socket-level component) thereof. For example, the local cooling flow control circuitry 1804 can identify the temperature of the server 1711 via one or more of the sensors 1732 thermally coupled to the server 1711 or portion (e.g., socket-level component) thereof.

At block 2516, the local temperature control circuitry 1740 controls coolant flow in the portion of the server housing 1706 associated with the server 1711 or portion (e.g., socket-level component) thereof based on the identified temperature of the server 1711 and the determined target temperature for the server 1711 or portion (e.g., socket-level component) thereof at the given workload. For example, the ITD-based dynamic thermal management circuitry 1802 can communicate the target temperature and/or a temperature change to be obtained to the local cooling flow control circuitry 1804. The local cooling flow control circuitry 1804 can transmit a control signal to the actuator 1736 associated with the portion of the server housing 1706 to adjust the coolant flow to the portion of the server housing 1706 and, in turn, adjust the temperature of the server 1711 or portion (e.g., socket-level component) thereof.

At block 2518, the local temperature control circuitry 1740 determines whether a performance threshold is satisfied. For example, the ITD-based dynamic thermal management circuitry 1802 can identify a performance (e.g., the power dissipation, the instructions per cycle per watt) of the server 1711 or portion (e.g., socket-level component) thereof when performing the workload while operating at the target temperature. Further, the ITD-based dynamic thermal management circuitry 1802 can determine whether the identified performance satisfies the performance threshold (e.g., the identified power dissipation is less than a power dissipation threshold, the identified instructions per cycle per watt is greater than an instructions per cycle per watt threshold). When the performance threshold is satisfied, the operations 2500 proceed to block 2520. Otherwise, when the performance threshold is not satisfied, the operations 2500 return to block 2502.

At block 2520, the local temperature control circuitry 1740 determines whether a different workload is being performed. When a different workload is being performed, the operations 2500 return to block 2512. Otherwise, the operations 2500 proceed to block 2522.

At block 2522, the local temperature control circuitry 1740 determines whether local cooling operations are to continue. When cooling operations are to continue, the operations 2500 return to block 2516.

FIG. 26 is a flowchart representative of example machine readable instructions and/or example operations 2600 that may be executed, instantiated, and/or performed by programmable circuitry to control coolant flow to the server housings 1706, 1708, protect electronics in the server housings 1706, 1708 from damage in the event of a leak in a coolant flowline (e.g., the coolant flowline 1702 of FIG. 17, the coolant flowline 2102 of FIG. 21), and minimize or otherwise reduce an effect of the leak on server and/or cooling operations. The example machine-readable instructions and/or the example operations 2600 of FIG. 26 begin at block 2602, at which the local temperature control circuitry 1740 controls coolant flow to one or more server housings (e.g., the server housings 1706, 1708 of FIGS. 17 and/or 18, the server housing 2202 of FIG. 22). For example, the ITD-based dynamic thermal management circuitry 1802 can determine target temperatures for the servers 1711 or portions (e.g., socket-level components) thereof associated therewith. Further, the local cooling flow control circuitry can control the actuators 1736 to control coolant flow to and/or in the server housings 1706, 1708. In some examples, the CDU circuitry 1738 controls coolant flow to the server housing(s). For example, the general cooling control circuitry 1806 can control the first actuators 1734 to control the coolant flow to the server housing(s).

At block 2604, the servers 1711 and/or the CDU circuitry 1738 determine whether a leak has been detected in one of the server housings 1706, 1708. For example, the leakage protection circuitry 1808 can determine whether a leak has been detected based on an indication from one or more of the leak sensors 1732 in the server housings 1706, 1708. When a leak has been detected, the operations 2600 proceed to block 2606. Otherwise, when a leak has not been detected, the operations 2600 skip to block 2614.

At block 2606, the servers 1711 and/or the CDU circuitry 1738 generate a leak alert to prompt an operator to address the leak. The leakage protection circuitry 1808 can indicate the location of the leak in the alert to enable the operator to focus on the identified portion of the server housing 1706.

At block 2608, the servers 1711 and/or the CDU circuitry 1738 shut off power to one or more of the servers 1711 (e.g., shuts down the server 1711) that are positioned in the portion of the server housing 1706 affected by the leak to minimize or otherwise reduce damage that the server 1711 encounters from coolant contact. For example, the leakage protection circuitry 1808 can cause the server(s) 1711 to power down.

At block 2610, the servers 1711 and/or the CDU circuitry 1738 prevent coolant flow to an identified leak location. For example, after one or more of the leak sensors 1732 identify a leak, the leakage protection circuitry 1808 determines a location of the leak based on an identifier associated with the sensor 1732 and a stored location of the sensor 1732 in the leak sensor location database 1810. For example, the leak sensor location database 1810 can include a mapping of the identifiers of the leak sensors 1732 implemented in the environment 1700 of FIG. 17. In some examples, the leak sensor location database 1810 includes one or more of the servers 1711 and/or one or more of the second actuators 1736 associated with the respective leak sensor 1732. Further, the leakage protection circuitry 1808 causes coolant flow to the portion of the server housing 1706 (e.g., in a section of the flowline 1702) in which the leak is occurring to be blocked. For example, the leakage protection circuitry 1808 can transmit a control signal to the second actuator 1736 to cause the second actuator 1736 to block coolant from flowing past the second actuator 1736 into the section of the flowline 1702 in which the leak is occurring. In some examples, the leakage protection circuitry 1808 transmits a signal to the local cooling flow control circuitry 1804 to cause the second actuator 1736 to prevent coolant from flowing into the portion of the server housing 1706.

At block 2612, the servers 1711 and/or the CDU circuitry 1738 cause coolant to flow to other portions of the server housing 1706 unaffected by the leak to minimize or otherwise reduce server operations affected by a local leak. That is, the servers 1711 and/or the CDU circuitry 1738 isolate the affected portion of the server housing 1706 while enabling other operations to remain uninterrupted.

At block 2614, the servers 1711 and/or the CDU circuitry 1738 determine whether to continue operating. When the CDU circuitry 1738 is to continue operating, the operations 2600 return to block 2602. Otherwise, the operations 2600 terminate.

FIG. 27 is a block diagram of an example programmable circuitry platform 2700 structured to execute and/or instantiate the example machine-readable instructions and/or the example operations of FIGS. 24-25 to implement the local temperature control circuitry 1740 of FIGS. 17-23. The programmable circuitry platform 2700 can be, for example, a server or any other type of computing and/or electronic device.

The programmable circuitry platform 2700 of the illustrated example includes programmable circuitry 2712. The programmable circuitry 2712 of the illustrated example is hardware. For example, the programmable circuitry 2712 can be implemented by one or more integrated circuits, logic circuits, FPGAs, microprocessors, CPUs, GPUs, DSPs, and/or microcontrollers from any desired family or manufacturer. The programmable circuitry 2712 may be implemented by one or more semiconductor based (e.g., silicon based) devices. In this example, the programmable circuitry 2712 implements the ITD-based dynamic thermal management circuitry 1802 and the local cooling flow control circuitry 1804.

The programmable circuitry 2712 of the illustrated example includes a local memory 2713 (e.g., a cache, registers, etc.). The programmable circuitry 2712 of the illustrated example is in communication with main memory 2714, 2716, which includes a volatile memory 2714 and a non-volatile memory 2716, by a bus 2718. The volatile memory 2714 may be implemented by Synchronous Dynamic Random Access Memory (SDRAM), Dynamic Random Access Memory (DRAM), RAMBUS^{®} Dynamic Random Access Memory (RDRAM^{®}), and/or any other type of RAM device. The non-volatile memory 2716 may be implemented by flash memory and/or any other desired type of memory device. Access to the main memory 2714, 2716 of the illustrated example is controlled by a memory controller 2717. In some examples, the memory controller 2717 may be implemented by one or more integrated circuits, logic circuits, microcontrollers from any desired family or manufacturer, or any other type of circuitry to manage the flow of data going to and from the main memory 2714, 2716.

The programmable circuitry platform 2700 of the illustrated example also includes interface circuitry 2720. The interface circuitry 2720 may be implemented by hardware in accordance with any type of interface standard, such as an Ethernet interface, a universal serial bus (USB) interface, a Bluetooth^{®} interface, a near field communication (NFC) interface, a Peripheral Component Interconnect (PCI) interface, and/or a Peripheral Component Interconnect Express (PCIe) interface.

In the illustrated example, one or more input devices 2722 are connected to the interface circuitry 2720. The input device(s) 2722 permit(s) a user (e.g., a human user, a machine user, etc.) to enter data and/or commands into the programmable circuitry 2712. The input device(s) 2722 can be implemented by, for example, an audio sensor, a microphone, a camera (still or video), a keyboard, a button, a mouse, a touchscreen, a trackpad, a trackball, an isopoint device, and/or a voice recognition system.

One or more output devices 2724 are also connected to the interface circuitry 2720 of the illustrated example. The output device(s) 2724 can be implemented, for example, by display devices (e.g., a light emitting diode (LED), an organic light emitting diode (OLED), a liquid crystal display (LCD), a cathode ray tube (CRT) display, an in-place switching (IPS) display, a touchscreen, etc.), a tactile output device, a printer, and/or speaker. The interface circuitry 2720 of the illustrated example, thus, typically includes a graphics driver card, a graphics driver chip, and/or graphics processor circuitry such as a GPU.

The interface circuitry 2720 of the illustrated example also includes a communication device such as a transmitter, a receiver, a transceiver, a modem, a residential gateway, a wireless access point, and/or a network interface to facilitate exchange of data with external machines (e.g., computing devices of any kind) by a network 2726. The communication can be by, for example, an Ethernet connection, a digital subscriber line (DSL) connection, a telephone line connection, a coaxial cable system, a satellite system, a beyond-line-of-sight wireless system, a line-of-sight wireless system, a cellular telephone system, an optical connection, etc.

The programmable circuitry platform 2700 of the illustrated example also includes one or more mass storage discs or devices 2728 to store firmware, software, and/or data. Examples of such mass storage discs or devices 2728 include magnetic storage devices (e.g., floppy disk, drives, HDDs, etc.), optical storage devices (e.g., Blu-ray disks, CDs, DVDs, etc.), RAID systems, and/or solid-state storage discs or devices such as flash memory devices and/or SSDs. In this example, the mass storage 2728 implements the temperature-performance database 1805.

The machine readable instructions 2732, which may be implemented by the machine readable instructions of FIGS. 24-25, may be stored in the mass storage device 2728, in the volatile memory 2714, in the non-volatile memory 2716, and/or on at least one non-transitory computer readable storage medium such as a CD or DVD which may be removable.

FIG. 28 is a block diagram of an example programmable circuitry platform 2800 structured to execute and/or instantiate the example machine-readable instructions and/or the example operations of FIG. 26 to implement the CDU circuitry 1738 of FIGS. 17-23. The programmable circuitry platform 2800 can be, for example, a server or any other type of computing and/or electronic device.

The programmable circuitry platform 2800 of the illustrated example includes programmable circuitry 2812. The programmable circuitry 2812 of the illustrated example is hardware. For example, the programmable circuitry 2812 can be implemented by one or more integrated circuits, logic circuits, FPGAs, microprocessors, CPUs, GPUs, DSPs, and/or microcontrollers from any desired family or manufacturer. The programmable circuitry 2812 may be implemented by one or more semiconductor based (e.g., silicon based) devices. In this example, the programmable circuitry 2812 implements the general cooling control circuitry 1806 and the leakage protection circuitry 1808.

The programmable circuitry 2812 of the illustrated example includes a local memory 2813 (e.g., a cache, registers, etc.). The programmable circuitry 2812 of the illustrated example is in communication with main memory 2814, 2816, which includes a volatile memory 2814 and a non-volatile memory 2816, by a bus 2818. The volatile memory 2814 may be implemented by Synchronous Dynamic Random Access Memory (SDRAM), Dynamic Random Access Memory (DRAM), RAMBUS^{®} Dynamic Random Access Memory (RDRAM^{®}), and/or any other type of RAM device. The non-volatile memory 2816 may be implemented by flash memory and/or any other desired type of memory device. Access to the main memory 2814, 2816 of the illustrated example is controlled by a memory controller 2817. In some examples, the memory controller 2817 may be implemented by one or more integrated circuits, logic circuits, microcontrollers from any desired family or manufacturer, or any other type of circuitry to manage the flow of data going to and from the main memory 2814, 2816.

The programmable circuitry platform 2800 of the illustrated example also includes interface circuitry 2820. The interface circuitry 2820 may be implemented by hardware in accordance with any type of interface standard, such as an Ethernet interface, a universal serial bus (USB) interface, a Bluetooth^{®} interface, a near field communication (NFC) interface, a Peripheral Component Interconnect (PCI) interface, and/or a Peripheral Component Interconnect Express (PCIe) interface.

In the illustrated example, one or more input devices 2822 are connected to the interface circuitry 2820. The input device(s) 2822 permit(s) a user (e.g., a human user, a machine user, etc.) to enter data and/or commands into the programmable circuitry 2812. The input device(s) 2822 can be implemented by, for example, an audio sensor, a microphone, a camera (still or video), a keyboard, a button, a mouse, a touchscreen, a trackpad, a trackball, an isopoint device, and/or a voice recognition system.

One or more output devices 2824 are also connected to the interface circuitry 2820 of the illustrated example. The output device(s) 2824 can be implemented, for example, by display devices (e.g., a light emitting diode (LED), an organic light emitting diode (OLED), a liquid crystal display (LCD), a cathode ray tube (CRT) display, an in-place switching (IPS) display, a touchscreen, etc.), a tactile output device, a printer, and/or speaker. The interface circuitry 2820 of the illustrated example, thus, typically includes a graphics driver card, a graphics driver chip, and/or graphics processor circuitry such as a GPU.

The interface circuitry 2820 of the illustrated example also includes a communication device such as a transmitter, a receiver, a transceiver, a modem, a residential gateway, a wireless access point, and/or a network interface to facilitate exchange of data with external machines (e.g., computing devices of any kind) by a network 2826. The communication can be by, for example, an Ethernet connection, a digital subscriber line (DSL) connection, a telephone line connection, a coaxial cable system, a satellite system, a beyond-line-of-sight wireless system, a line-of-sight wireless system, a cellular telephone system, an optical connection, etc.

The programmable circuitry platform 2800 of the illustrated example also includes one or more mass storage discs or devices 2828 to store firmware, software, and/or data. Examples of such mass storage discs or devices 2828 include magnetic storage devices (e.g., floppy disk, drives, HDDs, etc.), optical storage devices (e.g., Blu-ray disks, CDs, DVDs, etc.), RAID systems, and/or solid-state storage discs or devices such as flash memory devices and/or SSDs. In this example, the mass storage discs or devices 2828 implements the leak sensor location database 1810.

The machine readable instructions 2832, which may be implemented by the machine readable instructions of FIG. 26, may be stored in the mass storage device 2828, in the volatile memory 2814, in the non-volatile memory 2816, and/or on at least one non-transitory computer readable storage medium such as a CD or DVD which may be removable.

FIG. 29 is a block diagram of an example implementation of the programmable circuitry 2712 of FIG. 27 and/or 2812 of FIG. 28. In this example, the programmable circuitry 2712 of FIG. 27 and/or 2812 of FIG. 28 is implemented by a microprocessor 2900. For example, the microprocessor 2900 may be a general-purpose microprocessor (e.g., general-purpose microprocessor circuitry). The microprocessor 2900 executes some or all of the machine-readable instructions of the flowcharts of FIGS. 24, 25, and/or 26 to effectively instantiate the circuitry of FIG. 2 as logic circuits to perform operations corresponding to those machine readable instructions. In some such examples, the circuitry of FIG. 18 is instantiated by the hardware circuits of the microprocessor 2900 in combination with the machine-readable instructions. For example, the microprocessor 2900 may be implemented by multi-core hardware circuitry such as a CPU, a DSP, a GPU, an XPU, etc. Although it may include any number of example cores 2902 (e.g., 1 core), the microprocessor 2900 of this example is a multi-core semiconductor device including N cores. The cores 2902 of the microprocessor 2900 may operate independently or may cooperate to execute machine readable instructions. For example, machine code corresponding to a firmware program, an embedded software program, or a software program may be executed by one of the cores 2902 or may be executed by multiple ones of the cores 2902 at the same or different times. In some examples, the machine code corresponding to the firmware program, the embedded software program, or the software program is split into threads and executed in parallel by two or more of the cores 2902. The software program may correspond to a portion or all of the machine readable instructions and/or operations represented by the flowcharts of FIGS. 24, 25, and/or 26.

The cores 2902 may communicate by a first example bus 2904. In some examples, the first bus 2904 may be implemented by a communication bus to effectuate communication associated with one(s) of the cores 2902. For example, the first bus 2904 may be implemented by at least one of an Inter-Integrated Circuit (I2C) bus, a Serial Peripheral Interface (SPI) bus, a PCI bus, or a PCIe bus. Additionally or alternatively, the first bus 2904 may be implemented by any other type of computing or electrical bus. The cores 2902 may obtain data, instructions, and/or signals from one or more external devices by example interface circuitry 2906. The cores 2902 may output data, instructions, and/or signals to the one or more external devices by the interface circuitry 2906. Although the cores 2902 of this example include example local memory 2920 (e.g., Level 1 (L1) cache that may be split into an L1 data cache and an L1 instruction cache), the microprocessor 2900 also includes example shared memory 2910 that may be shared by the cores (e.g., Level 2 (L2 cache)) for high-speed access to data and/or instructions. Data and/or instructions may be transferred (e.g., shared) by writing to and/or reading from the shared memory 2910. The local memory 2920 of each of the cores 2902 and the shared memory 2910 may be part of a hierarchy of storage devices including multiple levels of cache memory and the main memory (e.g., the main memory 2714, 2814, 2716, 2816 of FIGS. 27 and/or 28). Typically, higher levels of memory in the hierarchy exhibit lower access time and have smaller storage capacity than lower levels of memory. Changes in the various levels of the cache hierarchy are managed (e.g., coordinated) by a cache coherency policy.

Each core 2902 may be referred to as a CPU, DSP, GPU, etc., or any other type of hardware circuitry. Each core 2902 includes control unit circuitry 2914, arithmetic and logic (AL) circuitry (sometimes referred to as an ALU) 2916, a plurality of registers 2918, the local memory 2920, and a second example bus 2922. Other structures may be present. For example, each core 2902 may include vector unit circuitry, single instruction multiple data (SIMD) unit circuitry, load/store unit (LSU) circuitry, branch/jump unit circuitry, floating-point unit (FPU) circuitry, etc. The control unit circuitry 2914 includes semiconductor-based circuits structured to control (e.g., coordinate) data movement within the corresponding core 2902. The AL circuitry 2916 includes semiconductor-based circuits structured to perform one or more mathematic and/or logic operations on the data within the corresponding core 2902. The AL circuitry 2916 of some examples performs integer based operations. In other examples, the AL circuitry 2916 also performs floating-point operations. In yet other examples, the AL circuitry 2916 may include first AL circuitry that performs integer-based operations and second AL circuitry that performs floating-point operations. In some examples, the AL circuitry 2916 may be referred to as an Arithmetic Logic Unit (ALU).

The registers 2918 are semiconductor-based structures to store data and/or instructions such as results of one or more of the operations performed by the AL circuitry 2916 of the corresponding core 2902. For example, the registers 2918 may include vector register(s), SIMD register(s), general-purpose register(s), flag register(s), segment register(s), machine-specific register(s), instruction pointer register(s), control register(s), debug register(s), memory management register(s), machine check register(s), etc. The registers 2918 may be arranged in a bank as shown in FIG. 29. Alternatively, the registers 2918 may be organized in any other arrangement, format, or structure, such as by being distributed throughout the core 2902 to shorten access time. The second bus 2922 may be implemented by at least one of an I2C bus, a SPI bus, a PCI bus, or a PCIe bus.

Each core 2902 and/or, more generally, the microprocessor 2900 may include additional and/or alternate structures to those shown and described above. For example, one or more clock circuits, one or more power supplies, one or more power gates, one or more cache home agents (CHAs), one or more converged/common mesh stops (CMSs), one or more shifters (e.g., barrel shifter(s)) and/or other circuitry may be present. The microprocessor 2900 is a semiconductor device fabricated to include many transistors interconnected to implement the structures described above in one or more integrated circuits (ICs) contained in one or more packages.

The microprocessor 2900 may include and/or cooperate with one or more accelerators (e.g., acceleration circuitry, hardware accelerators, etc.). In some examples, accelerators are implemented by logic circuitry to perform certain tasks more quickly and/or efficiently than can be done by a general-purpose processor. Examples of accelerators include ASICs and FPGAs such as those discussed herein. A GPU, DSP and/or other programmable device can also be an accelerator. Accelerators may be on-board the microprocessor 2900, in the same chip package as the microprocessor 2900 and/or in one or more separate packages from the microprocessor 2900.

FIG. 30 is a block diagram of another example implementation of the programmable circuitry 2712, 2812 of FIGS. 27 and/or 28. In this example, the programmable circuitry 2712, 2812 is implemented by FPGA circuitry 3000. For example, the FPGA circuitry 3000 may be implemented by an FPGA. The FPGA circuitry 3000 can be used, for example, to perform operations that could otherwise be performed by the example microprocessor 2900 of FIG. 29 executing corresponding machine readable instructions. However, once configured, the FPGA circuitry 3000 instantiates the operations and/or functions corresponding to the machine readable instructions in hardware and, thus, can often execute the operations/functions faster than they could be performed by a general-purpose microprocessor executing the corresponding software.

More specifically, in contrast to the microprocessor 2900 of FIG. 29 described above (which is a general purpose device that may be programmed to execute some or all of the machine readable instructions represented by the flowchart(s) of FIGS. 24, 25, and/or 26 but whose interconnections and logic circuitry are fixed once fabricated), the FPGA circuitry 3000 of the example of FIG. 30 includes interconnections and logic circuitry that may be configured, structured, programmed, and/or interconnected in different ways after fabrication to instantiate, for example, some or all of the operations/functions corresponding to the machine readable instructions represented by the flowchart(s) of FIGS. 24, 25, and/or 26. In particular, the FPGA circuitry 3000 may be thought of as an array of logic gates, interconnections, and switches. The switches can be programmed to change how the logic gates are interconnected by the interconnections, effectively forming one or more dedicated logic circuits (unless and until the FPGA circuitry 3000 is reprogrammed). The configured logic circuits enable the logic gates to cooperate in different ways to perform different operations on data received by input circuitry. Those operations may correspond to some or all of the instructions (e.g., the software and/or firmware) represented by the flowchart(s) of FIGS. 24, 25, and/or 26. As such, the FPGA circuitry 3000 may be configured and/or structured to effectively instantiate some or all of the operations/functions corresponding to the machine readable instructions of the flowchart(s) of FIGS. 24, 25, and/or 26 as dedicated logic circuits to perform the operations/functions corresponding to those software instructions in a dedicated manner analogous to an ASIC. Therefore, the FPGA circuitry 3000 may perform the operations/functions corresponding to the some or all of the machine readable instructions of FIGS. 24, 25, and/or 26 faster than the general-purpose microprocessor can execute the same.

In the example of FIG. 30, the FPGA circuitry 3000 is configured and/or structured in response to being programmed (and/or reprogrammed one or more times) based on a binary file. In some examples, the binary file may be compiled and/or generated based on instructions in a hardware description language (HDL) such as Lucid, Very High Speed Integrated Circuits (VHSIC) Hardware Description Language (VHDL), or Verilog. For example, a user (e.g., a human user, a machine user, etc.) may write code or a program corresponding to one or more operations/functions in an HDL; the code/program may be translated into a low-level language as needed; and the code/program (e.g., the code/program in the low-level language) may be converted (e.g., by a compiler, a software application, etc.) into the binary file. In some examples, the FPGA circuitry 3000 of FIG. 30 may access and/or load the binary file to cause the FPGA circuitry 3000 of FIG. 30 to be configured and/or structured to perform the one or more operations/functions. For example, the binary file may be implemented by a bit stream (e.g., one or more computer-readable bits, one or more machine-readable bits, etc.), data (e.g., computer-readable data, machine-readable data, etc.), and/or machine-readable instructions accessible to the FPGA circuitry 3000 of FIG. 30 to cause configuration and/or structuring of the FPGA circuitry 3000 of FIG. 30, or portion(s) thereof.

In some examples, the binary file is compiled, generated, transformed, and/or otherwise output from a uniform software platform utilized to program FPGAs. For example, the uniform software platform may translate first instructions (e.g., code or a program) that correspond to one or more operations/functions in a high-level language (e.g., C, C++, Python, etc.) into second instructions that correspond to the one or more operations/functions in an HDL. In some such examples, the binary file is compiled, generated, and/or otherwise output from the uniform software platform based on the second instructions. In some examples, the FPGA circuitry 3000 of FIG. 30 may access and/or load the binary file to cause the FPGA circuitry 3000 of FIG. 30 to be configured and/or structured to perform the one or more operations/functions. For example, the binary file may be implemented by a bit stream (e.g., one or more computer-readable bits, one or more machine-readable bits, etc.), data (e.g., computer-readable data, machine-readable data, etc.), and/or machine-readable instructions accessible to the FPGA circuitry 3000 of FIG. 30 to cause configuration and/or structuring of the FPGA circuitry 3000 of FIG. 30, or portion(s) thereof.

The FPGA circuitry 3000 of FIG. 30, includes example input/output (I/O) circuitry 3002 to obtain and/or output data to/from example configuration circuitry 3004 and/or external hardware 3006. For example, the configuration circuitry 3004 may be implemented by interface circuitry that may obtain a binary file, which may be implemented by a bit stream, data, and/or machine-readable instructions, to configure the FPGA circuitry 3000, or portion(s) thereof. In some such examples, the configuration circuitry 3004 may obtain the binary file from a user, a machine (e.g., hardware circuitry (e.g., programmable or dedicated circuitry) that may implement an Artificial Intelligence/Machine Learning (AI/ML) model to generate the binary file), etc., and/or any combination(s) thereof). In some examples, the external hardware 3006 may be implemented by external hardware circuitry. For example, the external hardware 3006 may be implemented by the microprocessor 2900 of FIG. 29.

The FPGA circuitry 3000 also includes an array of example logic gate circuitry 3008, a plurality of example configurable interconnections 3010, and example storage circuitry 3012. The logic gate circuitry 3008 and the configurable interconnections 3010 are configurable to instantiate one or more operations/functions that may correspond to at least some of the machine readable instructions of FIGS. 24, 25, and/or 26 and/or other desired operations. The logic gate circuitry 3008 shown in FIG. 30 is fabricated in blocks or groups. Each block includes semiconductor-based electrical structures that may be configured into logic circuits. In some examples, the electrical structures include logic gates (e.g., And gates, Or gates, Nor gates, etc.) that provide basic building blocks for logic circuits. Electrically controllable switches (e.g., transistors) are present within each of the logic gate circuitry 3008 to enable configuration of the electrical structures and/or the logic gates to form circuits to perform desired operations/functions. The logic gate circuitry 3008 may include other electrical structures such as look-up tables (LUTs), registers (e.g., flip-flops or latches), multiplexers, etc.

The configurable interconnections 3010 of the illustrated example are conductive pathways, traces, vias, or the like that may include electrically controllable switches (e.g., transistors) whose state can be changed by programming (e.g., using an HDL instruction language) to activate or deactivate one or more connections between one or more of the logic gate circuitry 3008 to program desired logic circuits.

The storage circuitry 3012 of the illustrated example is structured to store result(s) of the one or more of the operations performed by corresponding logic gates. The storage circuitry 3012 may be implemented by registers or the like. In the illustrated example, the storage circuitry 3012 is distributed amongst the logic gate circuitry 3008 to facilitate access and increase execution speed.

The example FPGA circuitry 3000 of FIG. 30 also includes example dedicated operations circuitry 3014. In this example, the dedicated operations circuitry 3014 includes special purpose circuitry 3016 that may be invoked to implement commonly used functions to avoid the need to program those functions in the field. Examples of such special purpose circuitry 3016 include memory (e.g., DRAM) controller circuitry, PCIe controller circuitry, clock circuitry, transceiver circuitry, memory, and multiplier-accumulator circuitry. Other types of special purpose circuitry may be present. In some examples, the FPGA circuitry 3000 may also include example general purpose programmable circuitry 3018 such as an example CPU 3020 and/or an example DSP 3022. Other general purpose programmable circuitry 3018 may additionally or alternatively be present such as a GPU, an XPU, etc., that can be programmed to perform other operations.

Although FIGS. 29 and 30 illustrate two example implementations of the programmable circuitry 2712 of FIG. 27 and/or 2812 of FIG. 28, many other approaches are contemplated. For example, FPGA circuitry may include an on-board CPU, such as one or more of the example CPU 3020 of FIG. 29. Therefore, the programmable circuitry 2712 of FIG. 27 and/or 2812 of FIG. 28 may additionally be implemented by combining at least the example microprocessor 2900 of FIG. 29 and the example FPGA circuitry 3000 of FIG. 30. In some such hybrid examples, one or more cores 2902 of FIG. 29 may execute a first portion of the machine readable instructions represented by the flowchart(s) of FIGS. 24, 25, and/or 26 to perform first operation(s)/function(s), the FPGA circuitry 3000 of FIG. 30 may be configured and/or structured to perform second operation(s)/function(s) corresponding to a second portion of the machine readable instructions represented by the flowcharts of FIG. 24, 25, and/or 26, and/or an ASIC may be configured and/or structured to perform third operation(s)/function(s) corresponding to a third portion of the machine readable instructions represented by the flowcharts of FIGS. 24, 25, and/or 26.

It should be understood that some or all of the circuitry of FIG. 18 may, thus, be instantiated at the same or different times. For example, same and/or different portion(s) of the microprocessor 2900 of FIG. 29 may be programmed to execute portion(s) of machine-readable instructions at the same and/or different times. In some examples, same and/or different portion(s) of the FPGA circuitry 3000 of FIG. 30 may be configured and/or structured to perform operations/functions corresponding to portion(s) of machine-readable instructions at the same and/or different times.

In some examples, some or all of the circuitry of FIG. 18 may be instantiated, for example, in one or more threads executing concurrently and/or in series. For example, the microprocessor 2900 of FIG. 29 may execute machine readable instructions in one or more threads executing concurrently and/or in series. In some examples, the FPGA circuitry 3000 of FIG. 30 may be configured and/or structured to carry out operations/functions concurrently and/or in series. Moreover, in some examples, some or all of the circuitry of FIG. 18 may be implemented within one or more virtual machines and/or containers executing on the microprocessor 2900 of FIG. 29.

In some examples, the programmable circuitry 2712 of FIG. 27 and/or 2812 of FIG. 28 may be in one or more packages. For example, the microprocessor 2900 of FIG. 29 and/or the FPGA circuitry 3000 of FIG. 30 may be in one or more packages. In some examples, an XPU may be implemented by the programmable circuitry 2712 of FIG. 27 and/or 2812 of FIG. 28, which may be in one or more packages. For example, the XPU may include a CPU (e.g., the microprocessor 2900 of FIG. 29, the CPU 3020 of FIG. 30, etc.) in one package, a DSP (e.g., the DSP 3022 of FIG. 30) in another package, a GPU in yet another package, and an FPGA (e.g., the FPGA circuitry 3000 of FIG. 30) in still yet another package.

A block diagram illustrating an example software distribution platform 3105 to distribute software such as the example machine readable instructions 2732 of FIG. 27 and/or 2832 of FIG. 28 to other hardware devices (e.g., hardware devices owned and/or operated by third parties from the owner and/or operator of the software distribution platform) is illustrated in FIG. 31. The example software distribution platform 3105 may be implemented by any computer server, data facility, cloud service, etc., capable of storing and transmitting software to other computing devices. The third parties may be customers of the entity owning and/or operating the software distribution platform 3105. For example, the entity that owns and/or operates the software distribution platform 3105 may be a developer, a seller, and/or a licensor of software such as the example machine readable instructions 2732 of FIG. 27 and/or 2832 of FIG. 28. The third parties may be consumers, users, retailers, OEMs, etc., who purchase and/or license the software for use and/or re-sale and/or sub-licensing. In the illustrated example, the software distribution platform 3105 includes one or more servers and one or more storage devices. The storage devices store the machine readable instructions 2732, 2832, which may correspond to the example machine readable instructions of FIGS. 24, 25, and/or 26, as described above. The one or more servers of the example software distribution platform 3105 are in communication with an example network 3110, which may correspond to any one or more of the Internet and/or any of the example networks described above. In some examples, the one or more servers are responsive to requests to transmit the software to a requesting party as part of a commercial transaction. Payment for the delivery, sale, and/or license of the software may be handled by the one or more servers of the software distribution platform and/or by a third party payment entity. The servers enable purchasers and/or licensors to download the machine readable instructions 2732, 2832 from the software distribution platform 3105. For example, the software, which may correspond to the example machine readable instructions of FIG. 24, 25, and/or 26, may be downloaded to the example programmable circuitry platform 2700, 2800, which is to execute the machine readable instructions 2732, 2832 to implement the CDU circuitry 1738 and the local temperature control circuitry 1740. In some examples, one or more servers of the software distribution platform 3105 periodically offer, transmit, and/or force updates to the software (e.g., the example machine readable instructions 2732 of FIG. 27 and/or 2832 of FIG. 28) to ensure improvements, patches, updates, etc., are distributed and applied to the software at the end user devices. Although referred to as software above, the distributed "software" could alternatively be firmware.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

As used in this patent, stating that any part (e.g., a layer, film, area, portion, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein "substantially real time" refers to occurrence in a near instantaneous manner recognizing there may be real world delays for computing time, transmission, etc. Thus, unless otherwise specified, "substantially real time" refers to real time + 1 second. As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example, an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that dynamically determine a target temperature for a server when performing a given workload and locally control coolant flow in a portion of a server housing in which the server is positioned based on the determined temperature. The target temperature can maximize or otherwise increase performance-per-watt and minimize or otherwise reduce power dissipation by the server. Moreover, examples disclosed herein enable different portions of the server housing that hold different servers to be set to different temperatures to account for workload and/or part-to-part leakage variance between the servers. Additionally, controlling coolant flow locally to obtain the determined target temperatures in the different portions of the server housing enables the target temperature to be achieved at a faster rate, which prevents temperature adjustments from falling behind schedule with the servers dynamically changing workloads. Further, increasing the rate at which the target temperature can be achieved reduces operational costs and improves operations of the servers. Additionally, examples disclosed herein minimize or otherwise reduce damage to electronics in the event of a leak occurring in a coolant flowline in a server housing while also minimizing or otherwise reducing server and/or cooling operations affected by the leak.

Example methods, apparatus, systems, and articles of manufacture to provide localized temperature control and leakage protection in a server housing are disclosed herein. Further examples and combinations thereof include the following:

Example 1 includes a system comprising interface circuitry, machine readable instructions, and at least one programmable circuit of a server disposable inside a portion of a server housing, the at least one programmable circuit to at least one of instantiate or execute the machine readable instructions to identify a temperature of the server, determine a target temperature for a workload for the server, and control an actuator based on the temperature and the target temperature, the actuator to control a local flow rate of a coolant in the portion of the server housing.

Example 2 includes the system of any preceding example, wherein the portion of the server housing is a first portion distinct from a second portion of the server housing, the target temperature is a first target temperature, and wherein a second target temperature is associated with the second portion of the server housing, the second target temperature distinct from the first target temperature.

Example 3 includes the system of any preceding example, wherein the at least one programmable circuit is at least one first programmable circuit, the server is a first server, the portion is a first portion of the server housing, the machine readable instructions are first machine readable instructions, the temperature is a first temperature, the target temperature is a first target temperature, the actuator is a first actuator, the workload is a first workload, and the local flow rate is a first local flow rate, further including at least one second programmable circuit of a second server disposable inside a second portion of the server housing distinct from the first portion, and the at least one second programmable circuit to at least one of instantiate or execute second machine readable instructions to identify a second temperature of the second server, determine a second target temperature for a second workload for the second server, and control a second actuator based on the second temperature and the second target temperature, the second actuator to control a second local flow rate of the coolant in the second portion of the server housing.

Example 4 includes the system of any preceding example, wherein the first target temperature is different than the second target temperature when the first workload is the same as the second workload.

Example 5 includes the system of any preceding example, wherein a first coolant inlet associated with the first portion is upstream of a second coolant inlet associated with the second portion, the at least one first programmable circuit is to cause the first actuator to perform a first movement to obtain the local flow rate of the coolant in the first portion, and the at least one second programmable circuit is to cause the second actuator to perform a second movement to obtain the local flow rate of the coolant in the second portion, the first movement different than the second movement.

Example 6 includes the system of any preceding example, wherein the at least one programmable circuit is at least one first programmable circuit, the machine readable instructions are first machine readable instructions, and the actuator is a first actuator, further including at least one second programmable circuit to be positioned outside of the server housing, the at least one second programmable circuit to at least one of instantiate or execute second machine readable instructions to control a second actuator that controls an input flow rate of the coolant delivered to the server housing.

Example 7 includes the system of any preceding example, wherein the at least one programmable circuit is at least one first programmable circuit and the machine readable instructions are first machine readable instructions, at least one of (i) the at least one first programmable circuit is to execute the first machine readable instructions or (ii) at least one second programmable circuit positioned outside the server housing is to execute second machine readable instructions to detect a coolant leak in a section of a flowline positioned in the portion of the server housing, and cause the actuator to prevent the coolant from flowing into the portion of the flowline after detection of the coolant leak.

Example 8 includes the system of any preceding example, wherein the actuator is a first actuator, the section of the flowline is a first section of the flowline, and the portion of the server housing is a first portion of the server housing, and wherein at least one of (i) the at least one second programmable circuit is to at least one of instantiate or execute the second machine readable instructions or (ii) at least one third programmable circuit positioned in a second portion of the server housing distinct from the first portion is to execute third machine readable instructions to cause a second actuator to continue to provide the coolant to a second portion of the server housing after the first actuator prevents the coolant from flowing into the first section of the flowline.

Example 9 includes the system of any preceding example, wherein the local flow rate is a first local flow rate, and wherein at least one of (i) the at least one second programmable circuit is to at least one of instantiate or execute the second machine readable instructions or (ii) at least one third programmable circuit is to at least one of instantiate or execute third machine readable instructions to adjust the second actuator to maintain a second local flow rate of the coolant in a second portion of the flowline after the first actuator prevents the coolant from flowing into the first portion of the flowline, a first inlet of the first portion of the flowline upstream of a second inlet of the second portion of the flowline.

Example 10 includes the system of any preceding example, wherein one or more of the at least one programmable circuit is to cause the actuator to adjust the local flow rate of the coolant in the portion of the server housing to obtain different temperatures for the server, the server performing a first workload when the different temperatures are obtained, and determine the target temperature associated with the first workload based on a performance of the server when encountering the different temperatures.

Example 11 includes the system of any preceding example, wherein the performance is based on a power dissipation of the server when the server is performing the first workload and encountering the different temperatures.

Example 12 includes the system of any preceding example, wherein the at least one programmable circuit is at least one first programmable circuit, the portion of the server housing is a first portion of the server housing, the machine readable instructions are first machine readable instructions, the temperature of the server is a first temperature of a first socket-level component of the server, the target temperature is a first target temperature for the first socket-level component, the workload is a first workload of the first-socket level component, and the actuator is a first actuator further including at least one second programmable circuit of the server disposable inside a second portion of the server housing distinct from the first portion, and the at least one second programmable circuit to at least one of instantiate or execute second machine readable instructions to identify a second temperature of a second socket-level component of the server, determine a second target temperature for a second workload for the second socket-level component of the server, and control a second actuator based on the second temperature and the second target temperature, the second actuator to control a second local flow rate of the coolant in the second portion of the server housing.

Example 13 includes a non-transitory machine readable storage medium comprising instructions to cause programmable circuitry to at least identify a workload being performed by a server, cause an actuator to obtain different temperatures at the server when the server is performing the workload, and determine a target temperature for the server when performing the workload based on performances by the server at the different temperatures.

Example 14 includes the non-transitory machine readable storage medium of any preceding example, wherein the performances include power dissipations of the server when performing the workload at the different temperatures.

Example 15 includes the non-transitory machine readable storage medium of any preceding example, wherein the workload is a first workload, wherein the server switches from the first workload to a second workload different than the first workload before returning to the first workload, and wherein the instructions cause the programmable circuitry to cause the actuator to obtain a first portion of the different temperatures before the server switches to the second workload and causes the actuator to obtain a second portion of the different temperatures after the server returns to the first workload.

Example 16 includes the non-transitory machine readable storage medium of any preceding example, wherein the target temperature is a first target temperature and the workload is a first workload, and wherein the instructions cause the programmable circuitry to determine a second target temperature associated with a second workload based on the first target temperature and the first workload.

Example 17 includes the non-transitory machine readable storage medium of any preceding example, wherein the workload is a first workload, the target temperature is a first target temperature, and the performances are first performances, and wherein the instructions cause the programmable circuitry to identify a second workload being performed by the server, cause the actuator to obtain the different temperatures at the server when the server is performing the second workload, and determine a second target temperature for the server when performing the second workload based on second performances by the server at the different temperatures.

Example 18 includes a method comprising identifying a workload being performed by a server, causing an actuator to obtain different temperatures at the server when the server is performing the workload, and determining a target temperature for the server when performing the workload based on performances by the server at the different temperatures.

Example 19 includes the method of any preceding example, wherein the workload is a first workload, wherein the server switches from the first workload to a second workload different than the first workload before returning to the first workload, wherein a first portion of the different temperatures are obtained before the server switches to the second workload, and wherein a second portion of the different temperatures are obtained after the server returns to the first workload.

Example 20 includes the method of any preceding example, wherein the workload is a first workload, the target temperature is a first target temperature, and the performances are first performances, further including identifying a second workload being performed by the server, causing the actuator to obtain the different temperatures at the server when the server is performing the second workload, and determining a second target temperature for the server when performing the second workload based on second performances by the server at the different temperatures.

Example 21 includes a system comprising interface circuitry, machine readable instructions, a liquid cooling system including a heat exchanger, a server housing, a flowline to carry a coolant (i) from the heat exchanger through the server housing and (ii) from the server housing to the heat exchanger, a first actuator to control a flow rate of the coolant flowing from the heat exchanger to the server housing, a second actuator to control a flow rate of the coolant in a portion of the flowline within a portion of the server housing, a sensor to measure a temperature in the portion of the server housing, at least one first programmable circuit positioned outside the server housing, one or more of the at least one first programmable circuit to control the first actuator, and at least one second programmable circuit positioned in the portion of the server housing, one or more of the at least one second programmable circuit to at least one of instantiate or execute the machine readable instructions to determine a target temperature of the server based on a workload being or to be performed by the server, and adjust the second actuator based on the temperature and the target temperature.

Example 22 includes the system of any preceding example, wherein the first actuator is associated with a first valve, and wherein the second actuator is associated with a second valve, the second valve smaller than the first valve.

Example 23 includes an apparatus comprising interface circuitry, machine readable instructions, and at least one programmable circuit to at least one of instantiate or execute the machine readable instructions to detect a leak in a first portion of a flowline, the flowline to carry a coolant from a heat exchanger through a server housing, the first portion of the flowline associated with a first portion of the server housing, cause a first actuator coupled to the first portion of the flowline to prevent the coolant from flowing into the first portion of the flowline after detection of the leak, and cause a second actuator coupled to a second portion of the flowline associated with a second portion of the server housing to continue to enable the coolant to flow in the second portion of the flowline after the first actuator prevents the coolant from flowing into the first portion of the flowline.

Example 24 includes the apparatus of any preceding example, wherein one or more of the at least one programmable circuit is to shut off power supplied to first programmable circuitry positioned in the first portion of the server housing in response to detection of the leak in the first portion of the flowline.

Example 25 includes the apparatus of any preceding example, wherein one or more of the at least one programmable circuit is to cause second programmable circuitry in the second portion of the server housing to continue to receive power after shutting off power to the first programmable circuitry.

Example 26 includes the apparatus of any preceding example, wherein one or more of the at least one programmable circuit is to cause the second actuator to maintain a flow rate of the coolant in the second portion of the flowline after causing the first actuator to prevent the coolant from flowing into the first portion of the flowline.

Example 27 includes the apparatus of any preceding example, wherein a first inlet of the first portion of the flowline is positioned upstream of a second inlet of the second portion of the flowline.

Example 28 includes the apparatus of any preceding example, further including a sled that holds the at least one programmable circuit, wherein the sled includes a sheet below the at least one programmable circuit, the sheet including a bend to guide the coolant to a leak sensor when the leak occurs.

Example 29 includes the apparatus of any preceding example, wherein the sled includes a cold plate positioned between the at least one programmable circuit and the sheet.

Example 30 includes a system comprising a flowline to carry a coolant from a heat exchanger through a server housing, a first actuator to control a first flow rate of the coolant that enters a first portion of the flowline positioned in a portion of the server housing, the coolant in the first portion of the flowline to cool first programmable circuitry, a second actuator to control a second flow rate of the coolant in a second portion of the flowline outside of the portion of the server housing, interface circuitry, machine readable instructions, and second programmable circuitry to at least one of instantiate or execute the machine readable instructions to detect a leak in the first portion of the flowline, and cause the first actuator to prevent the coolant from flowing into the first portion of the flowline after detection of the leak, the second actuator to continue to enable the coolant to flow in the second portion of the flowline after the second programmable circuitry causes the first actuator to prevent the coolant from flowing into the first portion of the flowline.

Example 31 includes the system of any preceding example, wherein the second programmable circuitry is to at least one of instantiate or execute the machine readable instructions to block power from being supplied to the first programmable circuitry in response to detection of the leak in the first portion of the flowline.

Example 32 includes the system of any preceding example, wherein the portion is a first portion of the server housing, further including third programmable circuitry in a second portion of the server housing, wherein the third programmable circuitry continues to receive power after the second programmable circuitry blocks power from being supplied to the first programmable circuitry.

Example 33 includes the system of any preceding example, wherein the second programmable circuitry is to at least one of instantiate or execute the machine readable instructions to adjust a position or a movement of the second actuator to maintain the second flow rate in the second portion of the flowline after the second programmable circuitry causes the first actuator to prevent the coolant from flowing into the first portion of the flowline.

Example 34 includes the system of any preceding example, wherein a first inlet of the first portion of the flowline is positioned upstream of a second inlet of the second portion of the flowline.

Example 35 includes the system of any preceding example, wherein the target temperature is a first target temperature, and the one or more of the at least one programmable circuit is to determine a second target temperature associated with a second workload based on the first target temperature and the first workload.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. A system comprising:
interface circuitry;
machine readable instructions; and
at least one programmable circuit of a server disposable inside a portion of a server housing, the at least one programmable circuit to at least one of instantiate or execute the machine readable instructions to:
identify a temperature of the server;
determine a target temperature for a workload for the server; and
control an actuator based on the temperature and the target temperature, the actuator to control a local flow rate of a coolant in the portion of the server housing.

2. The system of claim 1, wherein the portion of the server housing is a first portion distinct from a second portion of the server housing, the target temperature is a first target temperature, and wherein a second target temperature is associated with the second portion of the server housing, the second target temperature distinct from the first target temperature.

3. The system of claim 1 or claim 2, wherein the at least one programmable circuit is at least one first programmable circuit, the server is a first server, the portion is a first portion of the server housing, the machine readable instructions are first machine readable instructions, the temperature is a first temperature, the target temperature is a first target temperature, the actuator is a first actuator, the workload is a first workload, and the local flow rate is a first local flow rate, further including at least one second programmable circuit of a second server disposable inside a second portion of the server housing distinct from the first portion, and the at least one second programmable circuit to at least one of instantiate or execute second machine readable instructions to:
identify a second temperature of the second server;
determine a second target temperature for a second workload for the second server; and
control a second actuator based on the second temperature and the second target temperature, the second actuator to control a second local flow rate of the coolant in the second portion of the server housing.

4. The system of claim 3, wherein the first target temperature is different than the second target temperature when the first workload is the same as the second workload.

5. The system of claim 3 or claim 4, wherein a first coolant inlet associated with the first portion is upstream of a second coolant inlet associated with the second portion, the at least one first programmable circuit is to cause the first actuator to perform a first movement to obtain the first local flow rate of the coolant in the first portion, and the at least one second programmable circuit is to cause the second actuator to perform a second movement to obtain the second local flow rate of the coolant in the second portion, the first movement different than the second movement.

6. The system of any one of claims 1-5, wherein the at least one programmable circuit is at least one first programmable circuit, the machine readable instructions are first machine readable instructions, and the actuator is a first actuator, further including at least one third programmable circuit to be positioned outside of the server housing, the at least one third programmable circuit to at least one of instantiate or execute third machine readable instructions to control a third actuator that controls an input flow rate of the coolant delivered to the server housing.

7. The system of any one of claims 1-6, wherein the actuator is a first actuator, and the portion of the server housing is a first portion of the server housing, the at least one programmable circuit is at least one first programmable circuit and the machine readable instructions are first machine readable instructions, at least one of (i) the at least one first programmable circuit is to execute the first machine readable instructions or (ii) at least one fourth programmable circuit positioned outside the server housing is to execute fourth machine readable instructions to:
detect a coolant leak in a section of a flowline positioned in the first portion of the server housing; and
cause the first actuator to prevent the coolant from flowing into the first portion of the flowline after detection of the coolant leak.

8. The system of claim 7, wherein the section of the flowline is a first section of the flowline, and wherein at least one of (i) the at least one fourth programmable circuit is to at least one of instantiate or execute the fourth machine readable instructions or (ii) at least one fifth programmable circuit positioned in a third portion of the server housing distinct from the first portion is to execute fifth machine readable instructions to: cause a fourth actuator to continue to provide the coolant to the third portion of the server housing after the first actuator prevents the coolant from flowing into the first section of the flowline.

9. The system of claim 8, wherein the local flow rate is a first local flow rate, and wherein at least one of (i) the at least one fourth programmable circuit is to at least one of instantiate or execute the fourth machine readable instructions or (ii) the at least one fifth programmable circuit is to at least one of instantiate or execute the fifth machine readable instructions to: adjust the fourth actuator to maintain a third local flow rate of the coolant in a third portion of the flowline after the first actuator prevents the coolant from flowing into the first portion of the flowline, a first inlet of the first portion of the flowline upstream of a second inlet of the third portion of the flowline.

10. The system of any one of claims 1-8, wherein one or more of the at least one first programmable circuit is to:
cause the first actuator to adjust the first local flow rate of the coolant in the first portion of the server housing to obtain different temperatures for the first server, the first server performing a first workload when the different temperatures are obtained; and
determine the target temperature associated with the first workload based on a performance of the first server when encountering the different temperatures.

11. The system of claim 10, wherein the performance is based on a power dissipation of the server when the server is performing the first workload and encountering the different temperatures.

12. The system of any one of claims 1-11, wherein the at least one programmable circuit is at least one first programmable circuit, the portion of the server housing is a first portion of the server housing, the machine readable instructions are first machine readable instructions, the temperature of the server is a first temperature of a first socket-level component of the server, the target temperature is a first target temperature for the first socket-level component, the workload is a first workload of the first socket-level component, and the actuator is a first actuator, the system further including at least one sixth programmable circuit of the server disposable inside a fourth portion of the server housing distinct from the first portion, the at least one sixth programmable circuit to at least one of instantiate or execute sixth machine readable instructions to:
identify a third temperature of a second socket-level component of the server;
determine a third target temperature for a third workload for the second socket-level component of the server; and
control a fifth actuator based on the second temperature and the second target temperature, the fifth actuator to control a fourth local flow rate of the coolant in the fourth portion of the server housing.

13. A machine readable storage medium comprising instructions to cause programmable circuitry to at least:
identify a workload being performed by a server;
cause an actuator to obtain different temperatures at the server when the server is performing the workload; and
determine a target temperature for the server when performing the workload based on performances by the server at the different temperatures.

14. The machine readable storage medium of claim 13, wherein the workload is a first workload, wherein the server switches from the first workload to a second workload different than the first workload before returning to the first workload, and wherein the instructions cause the programmable circuitry to cause the actuator to obtain a first portion of the different temperatures before the server switches to the second workload and causes the actuator to obtain a second portion of the different temperatures after the server returns to the first workload.

15. A method comprising operations as claimed in any preceding claim.
